# EUROPEAN PATENT APPLICATION

(11) **EP 4 615 202 A1**
(43) Date of publication of application: **10.09.2025**
(21) Application number: 25161982.1
(22) Date of filing: 06.03.2025
(51) Int. Cl.: H10K 50/12

(54) **LIGHT-EMITTING ELEMENT, DISPLAY DEVICE INCLUDING THE SAME AND ELECTRONIC DEVICE**

(30) Priority: 06.03.2024 KR 20240032100
(71) Applicant: Samsung Display Co., Ltd., Gyeonggi-Do (KR)
(72) Inventor: NAIJO, Tsuyoshi, Yongin-si, Gyeonggi-Do (KR); BAE, Sung-Soo, Yongin-si, Gyeonggi-Do (KR); SHIN, Hyosup, Yongin-si, Gyeonggi-Do (KR); LEE, Jiyoung, Yongin-si, Gyeonggi-Do (KR); CHU, Changwoong, Yongin-si, Gyeonggi-Do (KR); HA, Moran, Yongin-si, Gyeonggi-Do (KR)
(74) Representative: Gulde & Partner

(57) **Abstract**

Embodiments provide a light-emitting element and a display device that includes the light-emitting element. The light-emitting element includes a first electrode, a second electrode disposed on the first electrode, and a light-emitting layer disposed between the first electrode and the second electrode. The light-emitting layer includes a hole-transporting host compound, an electron-transporting host compound, a phosphorescent compound, and a fluorescent compound, wherein at least one of the hole-transporting host compound and the electron-transporting host compound has a lower giant surface potential than the phosphorescent compound.

## Description

### CROSS-REFERENCE TO RELATED APPLICATION(S)

This application claims priority to and benefits of Korean Patent Application No. 10-2024-0032100, filed on March 6, 2024, in the Korean Intellectual Property Office, the entire contents of which are incorporated herein by reference.

### BACKGROUND

### 1. Technical Field

The disclosure relates to a light-emitting element, a display device including the same, and electronic device.

### 2. Description of the Related Art

Ongoing development continues for an organic electroluminescence display device as an image display device. In contrast to a liquid crystal display device, an organic electroluminescence display device is a so-called self-luminous display device in which holes and electrons respectively injected from a first electrode and a second electrode recombine in a light-emitting layer. In the light-emitting layer, a light-emitting material that includes an organic compound emits light upon this recombination of holes and electrons, thereby implementing display.

In the application of an organic electroluminescence element to a display device, there is a persistent demand for an organic electroluminescence element having a low driving voltage. Thus, continuous development is required on materials for an organic electroluminescence element that are capable of stably achieving such characteristics.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The disclosure provides a light-emitting element showing low capacitance characteristics.

The disclosure also provides a display device with improved image quality.

According to an embodiment, a light-emitting element may include a first electrode, a second electrode disposed on the first electrode, and a light-emitting layer disposed between the first electrode and the second electrode, wherein the light-emitting layer may include a hole-transporting host compound, an electron-transporting host compound, a phosphorescent compound, and a fluorescent compound, and at least one of the hole-transporting host compound and the electron-transporting host compound may have a lower giant surface potential than that of the phosphorescent compound.

In an embodiment, the phosphorescent compound may have a positive giant surface potential.

In an embodiment, at least one of the hole-transporting host compound and the electron-transporting host compound may have a negative giant surface potential.

In an embodiment, the electron-transporting host compound and the phosphorescent compound may each have a positive giant surface potential, and the hole-transporting host compound may have a negative giant surface potential.

In an embodiment, the phosphorescent compound may have a positive giant surface potential, and the hole-transporting host compound and the electron-transporting host compound may each have a negative giant surface potential.

In an embodiment, the hole-transporting host compound may be represented by Formula 1:

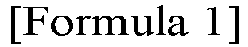

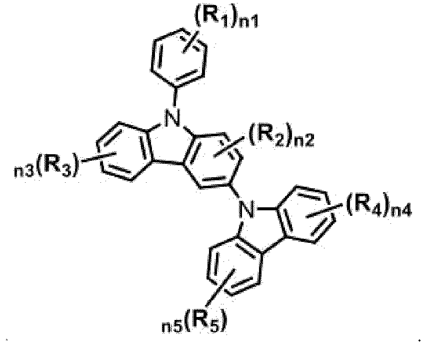

In Formula 1, R₁ to R₃ may each independently be a hydrogen atom, a deuterium atom, a substituted or unsubstituted aryl group having 6 to 30 ring-forming carbon atoms, or a substituted or unsubstituted heteroaryl group having 5 to 30 ring-forming carbon atoms; R₄ and R₅ may each independently be a hydrogen atom, a deuterium atom, or a substituted or unsubstituted silyl group; n1 may be an integer from 0 to 5; n2 may be an integer from 0 to 3; and n3 to n5 may each independently be an integer from 0 to 4.

In an embodiment, the hole-transporting host compound may be selected from Compound Group 1:

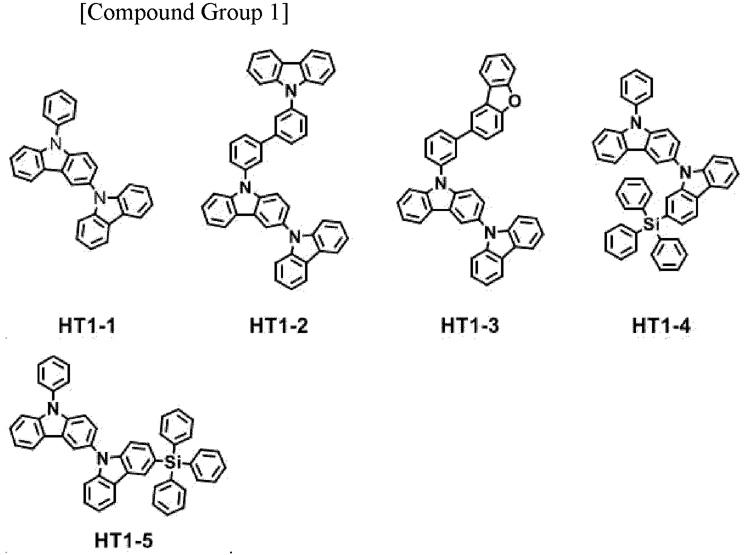

In an embodiment, the electron-transporting host compound may be represented by Formula 2:

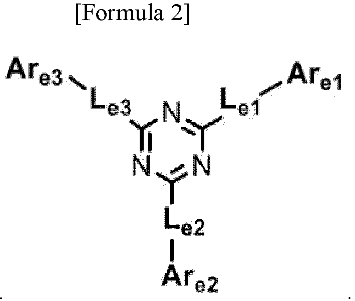

In Formula 2, Lₑ₁ to Lₑ₃ may each independently be a direct linkage, or a substituted or unsubstituted arylene group having 6 to 30 ring-forming carbon atoms; Arₑ₁ to Arₑ₃ may each independently be a substituted or unsubstituted aryl group having 6 to 30 ring-forming carbon atoms, or a substituted or unsubstituted heteroaryl group having 6 to 30 ring-forming carbon atoms; and when Lₑ₁ to Lₑ₃ are each a direct linkage, a case in which Arₑ₁ to Arₑ₃ are each substituted with a triphenylsilyl group is excluded.

In an embodiment, the electron-transporting host compound may be selected from Compound Group 2:

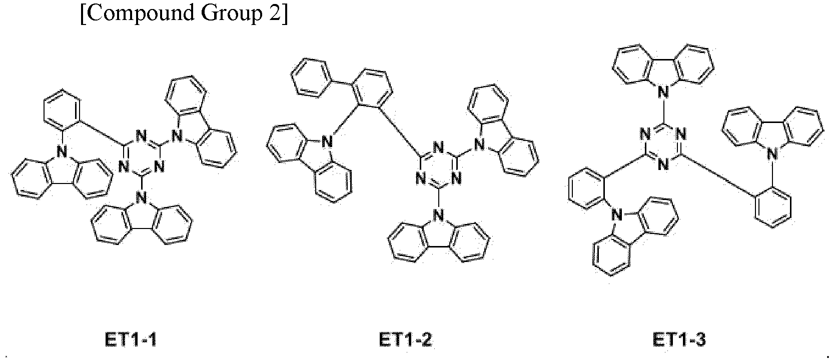

In an embodiment, the phosphorescent compound may be represented by Formula 3:

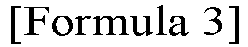

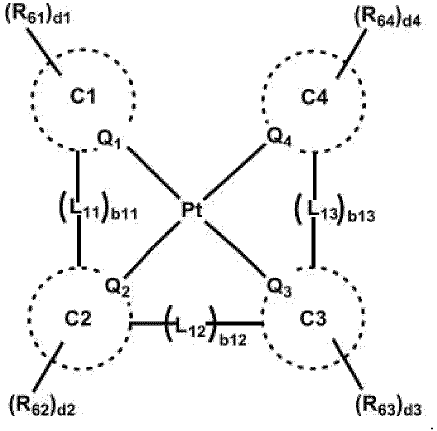

In Formula 3, Q1 to Q4 may each independently be C or N; C1 to C4 may each independently be a substituted or unsubstituted hydrocarbon ring having 5 to 30 ring-forming carbon atoms, or a substituted or unsubstituted heterocycle having 2 to 30 ring-forming carbon atoms; L₁₁ to L₁₃ may each independently be a direct linkage, ***-O-***, ***-S-***, 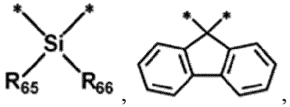 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms; b11 to b13 may each independently be 0 or 1; R₆₁ to R₆₆ may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms; and d1 to d4 may each independently be an integer from 0 to 4.

In an embodiment, the fluorescent compound may emit delayed fluorescence.

In an embodiment, the light-emitting element may further include a hole transport region disposed between the first electrode and the light-emitting layer, wherein the hole transport region may include at least one of a hole injection layer, a hole transport layer, and an auxiliary light-emitting layer.

In an embodiment, the hole transport region may include a compound having a positive giant surface potential.

In an embodiment, the hole transport region may include a hole injection layer disposed on the first electrode, a hole transport layer disposed on the hole injection layer, and an electron-blocking layer disposed on the hole transport layer; and the electron-blocking layer may include the compound having the positive giant surface potential.

In an embodiment, the light-emitting element may further include an electron transport region disposed between the light-emitting layer and the second electrode, wherein the electron transport region may include at least one of a hole-blocking layer, an electron transport layer, and an electron injection layer.

In an embodiment, the electron transport region may include a compound having a positive giant surface potential.

In an embodiment, the electron transport region may include a hole-blocking layer disposed on the light-emitting layer, an electron transport layer disposed on the hole-blocking layer, and an electron injection layer disposed on the electron transport layer; and the hole-blocking layer may include the compound having the positive giant surface potential.

According to an embodiment, a display device may include a circuit layer disposed on a base layer, a pixel-defining film disposed on the circuit layer, and a plurality of light-emitting elements disposed on the circuit layer, wherein a plurality of pixel openings may be defined in the pixel-defining film; each of the light-emitting elements may include a light-emitting layer; the light-emitting layer may include a hole-transporting host compound, an electron-transporting host compound, a phosphorescent compound, and a fluorescent compound; and at least one of the hole-transporting host compound and the electron-transporting host compound may have a lower giant surface potential than that of the phosphorescent compound.

In an embodiment, the display device may further include a light control layer including quantum dots, and a color filter layer disposed on the light control layer, wherein the color filter layer may include a first filter transmitting red color light, a second filter transmitting green color light, and a third filter transmitting blue color light.

In an embodiment, at least one of the hole-transporting host compound and the electron-transporting host compound may have a negative giant surface potential.

It is to be understood that the embodiments above are described in a generic and explanatory sense only and not for the purposes of limitation, and the disclosure is not limited to the embodiments described above.

### BRIEF DESCRIPTION OF THE DRAWINGS

The accompanying drawings are included to provide a further understanding of the embodiments, and are incorporated in and constitute a part of this specification. The drawings illustrate embodiments of the disclosure and principles thereof. The above and other aspects and features of the disclosure will become more apparent by describing in detail embodiments thereof with reference to the accompanying drawings, in which:
FIG. 1 is a block diagram of an electronic device according to an embodiment.
FIG. 2 illustrates schematic views of electronic devices according to various embodiments.
FIG. 3 is a schematic plan view of a display device according to an embodiment;
FIG. 4 is a schematic cross-sectional view of a display device according to an embodiment;
FIGS. 5 to 10 are each a schematic cross-sectional view of a light-emitting element according to an embodiment;
FIGS. 11 to 14 are each a schematic cross-sectional view of a display device according to an embodiment;
FIG. 15 is a schematic diagram of an interior of a vehicle in which a display device according to an embodiment is disposed; and
FIG. 16. is a graph showing an evaluation result of characteristics of light-emitting elements according to the Examples and the Comparative Examples.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, the sizes, thicknesses, ratios, and dimensions of the elements may be exaggerated for ease of description and for clarity. Like reference numbers and reference characters refer to like elements throughout.

In the specification, it will be understood that when an element (or region, layer, part, etc.) is referred to as being "on", "connected to", or "coupled to" another element, it can be directly on, connected to, or coupled to the other element, or one or more intervening elements may be present therebetween. In a similar sense, when an element (or region, layer, part, etc.) is described as "covering" another element, it can directly cover the other element, or one or more intervening elements may be present therebetween.

In the specification, when an element is "directly on," "directly connected to," or "directly coupled to" another element, there are no intervening elements present. For example, "directly on" may mean that two layers or two elements are disposed without an additional element such as an adhesion element therebetween.

As used herein, the expressions used in the singular such as "a," "an," and "the," are intended to include the plural forms as well, unless the context clearly indicates otherwise.

As used herein, the term "and/or" includes any and all combinations of one or more of the associated listed items. For example, "A and/or B" may be understood to mean "A, B, or A and B." The terms "and" and "or" may be used in the conjunctive or disjunctive sense and may be understood to be equivalent to "and/or".

In the specification and the claims, the term "at least one of" is intended to include the meaning of "at least one selected from the group consisting of" for the purpose of its meaning and interpretation. For example, "at least one of A, B, and C" may be understood to mean A only, B only, C only, or any combination of two or more of A, B, and C, such as ABC, ACC, BC, or CC. When preceding a list of elements, the term, "at least one of," modifies the entire list of elements and does not modify the individual elements of the list.

It will be understood that, although the terms first, second, etc. may be used herein to describe various elements, these elements should not be limited by these terms. These terms are only used to distinguish one element from another element. Thus, a first element could be termed a second element without departing from the teachings of the disclosure. Similarly, a second element could be termed a first element, without departing from the scope of the disclosure.

The spatially relative terms "below", "beneath", "lower", "above", "upper", or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

The terms "about" or "approximately" as used herein is inclusive of the stated value and means within an acceptable range of deviation for the recited value as determined by one of ordinary skill in the art, considering the measurement in question and the error associated with measurement of the recited quantity (i.e., the limitations of the measurement system). For example, "about" may mean within one or more standard deviations, or within ±20%, ±10%, or ±5% of the stated value.

It should be understood that the terms "comprises," "comprising," "includes," "including," "have," "having," "contains," "containing," and the like are intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined or implied herein, all terms (including technical and scientific terms) used have the same meaning as commonly understood by those skilled in the art to which this disclosure pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification.

In the specification, the term "substituted or unsubstituted" may describe a group that is substituted or unsubstituted with at least one substituent selected from the group consisting of a deuterium atom, a halogen atom, a cyano group, a nitro group, an amino group, an amine group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. Each of the substituents listed above may itself be substituted or unsubstituted. For example, a biphenyl group may be interpreted as an aryl group, or it may be interpreted as a phenyl group substituted with a phenyl group.

In the specification, the term "bonded to an adjacent group to form a ring" may refer to a group that is bonded to an adjacent group to form a substituted or unsubstituted hydrocarbon ring or a substituted or unsubstituted heterocycle. A hydrocarbon ring may be aliphatic or aromatic. A heterocycle may be aliphatic heterocycle or aromatic. A hydrocarbon ring and a heterocycle may each independently be monocyclic or polycyclic. A ring that is formed by adjacent groups being bonded to each other may itself be connected to another ring to form a spiro structure.

In the specification, the term "adjacent group" may be interpreted as a substituent that is substituted for an atom which is directly linked to an atom substituted with a corresponding substituent, as another substituent that is substituted for an atom which is substituted with a corresponding substituent, or as a substituent that is sterically positioned at the nearest position to a corresponding substituent. For example, two methyl groups in 1,2-dimethylbenzene may be interpreted as "adjacent groups" to each other, and two ethyl groups in 1,1-diethylcyclopentane may be interpreted as "adjacent groups" to each other. For example, two methyl groups in 4,5-dimethylphenanthrene may be interpreted as "adjacent groups" to each other.

In the specification, examples of a halogen atom may include a fluorine atom, a chlorine atom, a bromine atom, and an iodine atom.

In the specification, an alkyl group may be linear or branched. The number of carbon atoms in an alkyl group may be 1 to 50, 1 to 30, 1 to 20, 1 to 10, or 1 to 6. Examples of an alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-henicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, etc., but embodiments are not limited thereto.

In the specification, a cycloalkyl group may be a cyclic alkyl group. The number of carbon atoms in a cycloalkyl group may be 3 to 50, 3 to 30, 3 to 20, or 3 to 10. Examples of a cycloalkyl group may include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, etc., but embodiments are not limited thereto.

In the specification, an alkenyl group may be a hydrocarbon group that includes at least one carbon-carbon double bond in the middle or at a terminus of an alkyl group having 2 or more carbon atoms. An alkenyl group may be linear or branched. The number of carbon atoms in an alkenyl group is not particularly limited, and may be 2 to 30, 2 to 20, or 2 to 10. Examples of an alkenyl group may include a vinyl group, a 1-butenyl group, a 1-pentenyl group, a 1,3-butadienyl group, a styrenyl group, a styryl vinyl group, etc., but embodiments are not limited thereto.

In the specification, an alkynyl group may be a hydrocarbon group that includes at least one carbon-carbon triple bond in the middle or at a terminus of an alkyl group having 2 or more carbon atoms. An alkynyl group may be linear or branched. The number of carbon atoms in an alkynyl group is not particularly limited, and may be 2 to 30, 2 to 20, or 2 to 10. Examples of an alkynyl group may include an ethynyl group, a propynyl group, etc., but embodiments are not limited thereto.

In the specification, a hydrocarbon ring group may be any functional group or substituent derived from an aliphatic hydrocarbon ring. For example, a hydrocarbon ring group may be a saturated hydrocarbon ring group having 5 to 20 ring-forming carbon atoms.

In the specification, an aryl group may be any functional group or substituent derived from an aromatic hydrocarbon ring. An aryl group may be monocyclic or polycyclic. The number of ring-forming carbon atoms in an aryl group may be 6 to 60, 6 to 30, 6 to 20, or 6 to 15. Examples of an aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, etc., but embodiments are not limited thereto.

In the specification, a fluorenyl group may be substituted, and two substituents may be bonded to each other to form a spiro structure. Examples of a substituted fluorenyl group may include the groups shown below. However, embodiments are not limited thereto.

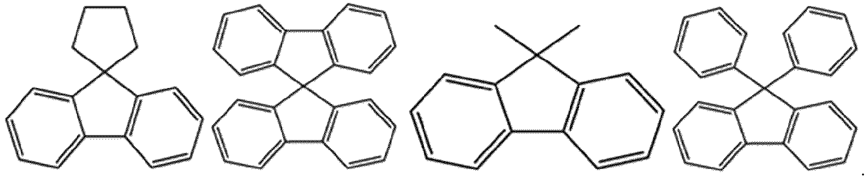

In the specification, a heterocyclic group may be any functional group or substituent derived from a ring that includes at least one of B, O, N, P, Si, and Se as a heteroatom. A heterocyclic group may be aliphatic or aromatic. An aromatic heterocyclic group may be a heteroaryl group. An aliphatic heterocycle and an aromatic heterocycle may each independently be monocyclic or polycyclic.

If a heterocyclic group includes two or more heteroatoms, the two or more heteroatoms may be the same as or different from each other. The number of ring-forming carbon atoms in a heterocyclic group may be 2 to 60, 2 to 30, 2 to 20, or 2 to 10.

Examples of an aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, etc., but embodiments are not limited thereto.

Examples of a heteroaryl group may include a thiophene group, a furan group, a pyrrole group, an imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzoimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, etc., but embodiments are not limited thereto.

In the specification, the above description of an aryl group may be applied to an arylene group, except that an arylene group is a divalent group. In the specification, the above description of a heteroaryl group may be applied to a heteroarylene group, except that a heteroarylene group is a divalent group.

In the specification, a silyl group may be an alkylsilyl group or an arylsilyl group. Examples of a silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, etc., but embodiments are not limited thereto.

In the specification, the number of carbon atoms in a carbonyl group is not particularly limited, and may be 1 to 40, 1 to 30, or 1 to 20. For example, a carbonyl group may have one of the following structures, but embodiments are not limited thereto.

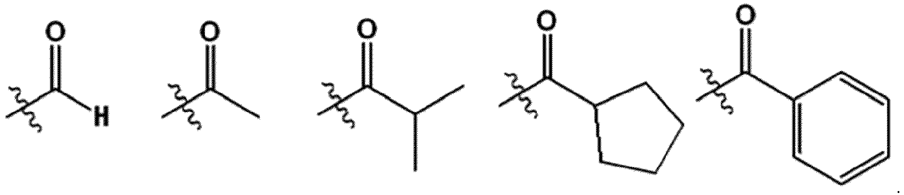

In the specification, the number of carbon atoms in a sulfinyl group or a sulfonyl group is not particularly limited, and may be 1 to 30. A sulfinyl group may be an alkyl sulfinyl group or an aryl sulfinyl group. A sulfonyl group may be an alkyl sulfonyl group or an aryl sulfonyl group.

In the specification, a thio group may be an alkylthio group or an arylthio group. A thio group may be a sulfur atom that is bonded to an alkyl group or to an aryl group as defined above. Examples of a thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, but embodiments are not limited thereto.

In the specification, an oxy group may be an oxygen atom that is bonded to an alkyl group or to an aryl group as defined above. An oxy group may be an alkoxy group or an aryl oxy group. An alkoxy group may be linear, branched, or cyclic. The number of carbon atoms in an alkoxy group is not particularly limited, and may be, for example, 1 to 20 or 1 to 10. Examples of an oxy group may include a methoxy group, an ethoxy group, an n-propoxy group, an isopropoxy group, a butoxy group, a pentyloxy group, a hexyloxy group, an octyloxy group, a nonyloxy group, a decyloxy group, a benzyloxy group, etc., but embodiments are not limited thereto.

In the specification, a boron group may be a boron atom that is bonded to an alkyl group or to an aryl group as defined above. A boron group may be an alkyl boron group or an aryl boron group. Examples of a boron group may include a dimethylboron group, a t-butylmethylboron group, a diphenylboron group, a phenylboron group, etc., but embodiments are not limited thereto.

In the specification, the number of carbon atoms in an amine group is not particularly limited, and may be 1 to 30. An amine group may be an alkyl amine group or an aryl amine group. Examples of an amine group may include a methylamine group, a dimethylamine group, a phenylamine group, a diphenylamine group, a naphthylamine group, a 9-methyl-anthracenylamine group, etc., but embodiments are not limited thereto.

In the specification, an alkyl group within an alkylthio group, an alkylsulfoxy group, an alkylaryl group, an alkylamino group, an alkyl boron group, an alkyl silyl group, or an alkyl amine group may be the same as an example of an alkyl group as described above.

In the specification, an aryl group within an aryloxy group, an arylthio group, an arylsulfoxy group, an arylamino group, an arylboron group, an arylsilyl group, or an arylamine group may be the same as an example of an aryl group as described above.

In the specification, a direct linkage may be a single bond.

In the specification, the symbols 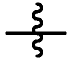 and -* each represent a bond to a neighboring atom in a corresponding formula or moiety.

Hereinafter, embodiments will be described with reference to the accompanying drawings.

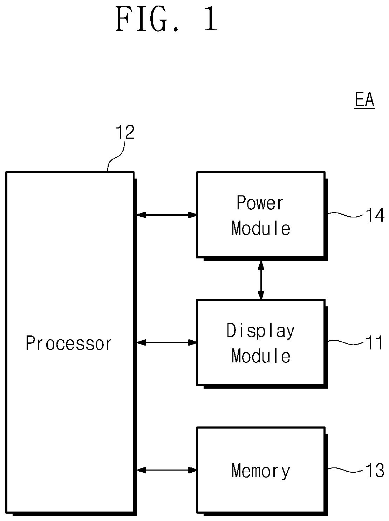

FIG. 1 is a block diagram of an electronic device according to an embodiment. Referring to FIG. 1, an electronic device EA according to an embodiment may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), or a controller.

The memory 13 may store data information required for an operation of the processor 12 or the display module 11. When the processor 12 executes an application stored in the memory 13, an image data signal and/or an input control signal may be transmitted to the display module 11, and the display module 11 may process the provided signal and output image information through a display screen.

The power module 14 may include a power supply module such as a power adapter or a battery device, and a power conversion module which converts power supplied by the power supply module and generates power required for an operation of the electronic device EA.

At least one of the components of the electronic device EA described above may be included in the display device according to an embodiment described above. In addition, some of individual modules included as functional in one module may be included in the display device, and others may be provided separately from the display device. For example, the display device may include the display module 11, and the processor 12, the memory 13, and the power module 14 may be provided not in the display device but in another type of device in the electronic device EA.

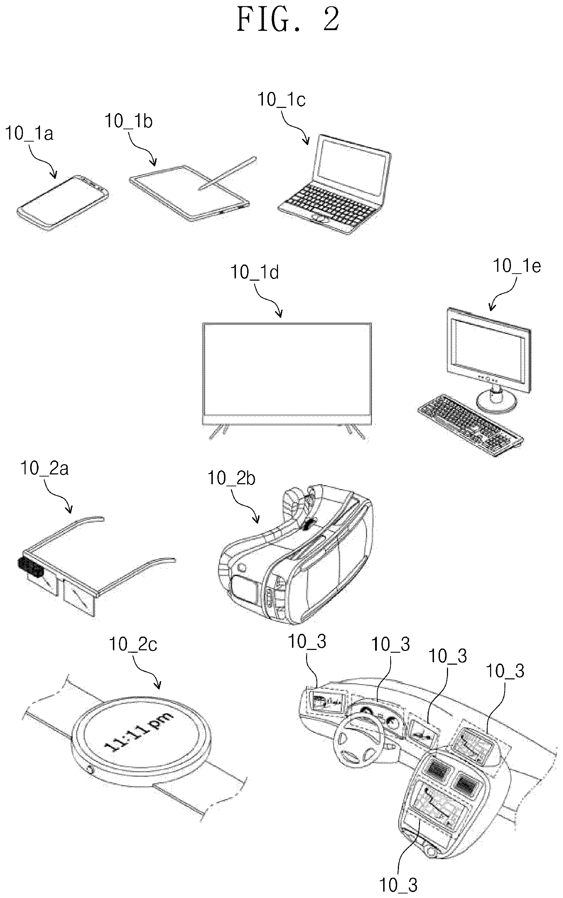

FIG. 2 illustrates schematic views of electronic devices according to various embodiments.

Referring to FIG. 2, various electronic devices to which the display device according to an embodiment is applied may include not only electronic devices for displaying images, e.g., a smartphone 10_la, a tablet computer (PC) 10_1b, a laptop computer 10_1c, television (TV) 10_1d, and a monitor for a desk computer 10_1e, but also wearable electronic devices including display modules, e.g., smart glasses 10_2a, a head mounted display 10_2b, and a smart watch 10_2c, and vehicle electronic devices 10_3 including display modules, e.g., a vehicle instrument panel, a center fascia, a center information display (CID) disposed on a dashboard, and a room mirror display.

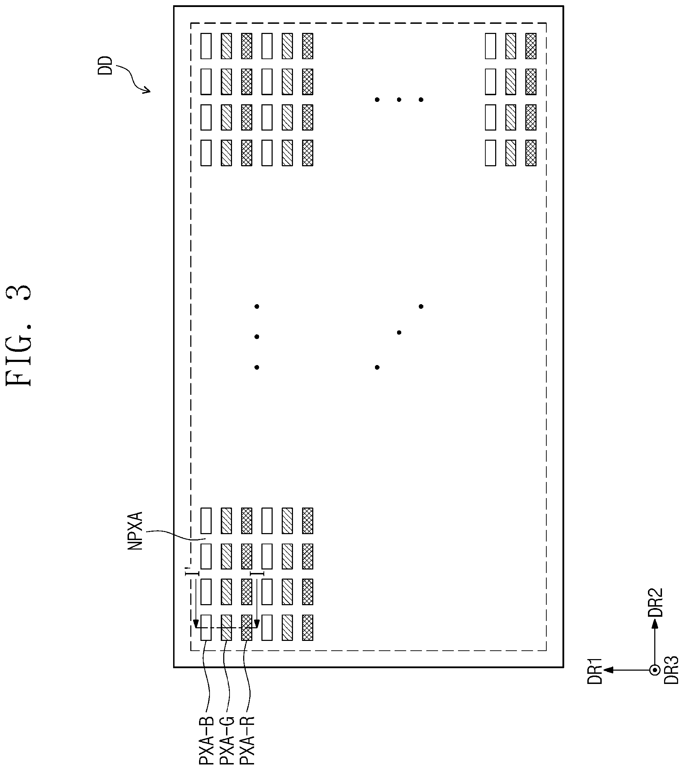

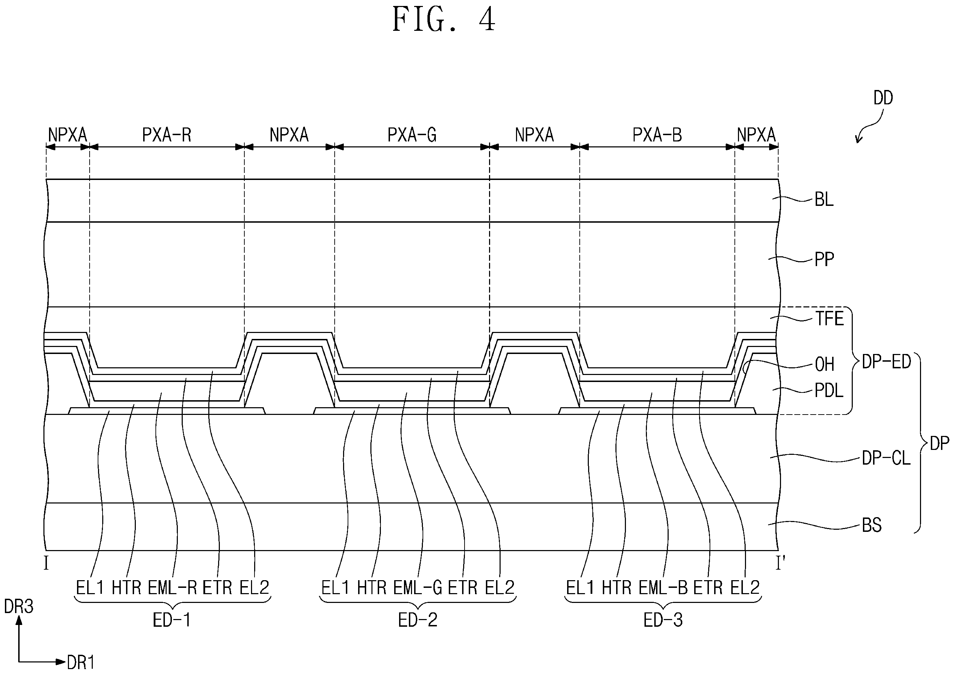

FIG. 3 is a schematic plan view of a display device DD according to an embodiment. FIG. 4 is a schematic cross-sectional view of a display device DD according to an embodiment. FIG. 4 is a schematic cross-sectional view of a portion of the display device DD taken along virtual line I-I' in FIG. 3. The display device DD of one embodiment may be included in the electronic device EA described above. The display device DD may be a part that provides an image in the electronic device EA.

The display device DD may include a display panel DP and an optical layer PP disposed on the display panel DP. The display panel DP includes light-emitting elements ED-1, ED-2, and ED-3. The display device DD may include multiples of each of the light-emitting elements ED-1, ED-2, and ED-3. The optical layer PP may be disposed on the display panel DP to control light that is reflected at the display panel DP from an external light. The optical layer PP may include, for example, a polarization layer or a color filter layer. Although not shown in the drawings, in an embodiment, the optical layer PP may be omitted from the display device DD.

A base substrate BL may be disposed on the optical layer PP. The base substrate BL may provide a base surface on which the optical layer PP is disposed. The base substrate BL may be a glass substrate, a metal substrate, a plastic substrate, etc. However, embodiments are not limited thereto, and the base substrate BL may include an inorganic layer, an organic layer, or a composite material layer. Although not shown in the drawings, in an embodiment, the base substrate BL may be omitted.

The display device DD according to an embodiment may further include a filling layer (not shown). The filling layer (not shown) may be disposed between a display device layer DP-ED and the base substrate BL. The filling layer (not shown) may be an organic material layer. The filling layer (not shown) may include at least one of an acrylic-based resin, a silicone-based resin, and an epoxy-based resin.

The display panel DP may include a base layer BS, a circuit layer DP-CL provided on the base layer BS, and the display device layer DP-ED. The display device layer DP-ED may include a pixel defining film PDL, light-emitting elements ED-1, ED-2, and ED-3 disposed between portions of the pixel defining film PDL, and an encapsulation layer TFE disposed on the light-emitting elements ED-1, ED-2, and ED-3.

The base layer BS may provide a base surface on which the display device layer DP-ED is disposed. The base layer BS may be a glass substrate, a metal substrate, a plastic substrate, etc. However, embodiments are not limited thereto, and the base layer BS may include an inorganic layer, an organic layer, or a composite material layer.

In an embodiment, the circuit layer DP-CL is disposed on the base layer BS, and the circuit layer DP-CL may include transistors (not shown). The transistors (not shown) may each include a control electrode, an input electrode, and an output electrode. For example, the circuit layer DP-CL may include a switching transistor and a driving transistor for driving the light-emitting elements ED-1, ED-2, and ED-3 of the display device layer DP-ED.

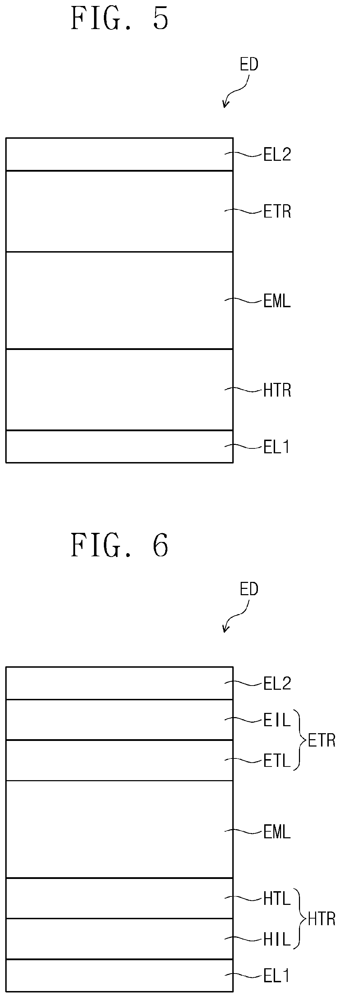

The light-emitting elements ED-1, ED-2, and ED-3 may each have a structure of a light-emitting element ED of an embodiment according to any of FIGS. 5 to 10, which will be described later. The light-emitting elements ED-1, ED-2, and ED-3 may each include a first electrode EL1, a hole transport region HTR, corresponding one of light-emitting layers EML-R, EML-G, and EML-B, an electron transport region ETR, and a second electrode EL2.

FIG. 4 illustrates an embodiment in which the light-emitting layers EML-R, EML-G, and EML-B of the light-emitting elements ED-1, ED-2, and ED-3 are disposed in openings OH defined in the pixel defining film PDL, and the hole transport region HTR, the electron transport region ETR, and the second electrode EL2 are each provided as a common layer for the light-emitting elements ED-1, ED-2, and ED-3. However, embodiments are not limited thereto. Although not shown in FIG. 4, in an embodiment, the hole transport region HTR and the electron transport region ETR may each be provided by being patterned in the openings OH defined in the pixel defining film PDL. For example, in an embodiment, the hole transport region HTR, the light-emitting layers EML-R, EML-G, and EML-B, and the electron transport region ETR of the light-emitting elements ED-1, ED-2, and ED-3 may be provided by being patterned through an inkjet printing method.

The encapsulation layer TFE may cover the light-emitting elements ED-1, ED-2, and ED-3. The encapsulation layer TFE may seal the display device layer DP-ED. The encapsulation layer TFE may be a thin film encapsulation layer. The encapsulation layer TFE may be formed of a single layer or of multiple layers. The encapsulation layer TFE may include at least one insulation layer. The encapsulation layer TFE according to an embodiment may include at least one inorganic film (hereinafter, an encapsulation-inorganic film). The encapsulation layer TFE according to an embodiment may also include at least one organic film (hereinafter, an encapsulation-organic film) and at least one encapsulation-inorganic film.

The encapsulation-inorganic film protects the display device layer DP-ED from moisture and/or oxygen, and the encapsulation-organic film protects the display device layer DP-ED from foreign substances such as dust particles. The encapsulation-inorganic film may include silicon nitride, silicon oxynitride, silicon oxide, titanium oxide, aluminum oxide, or the like, but embodiments are not limited thereto. The encapsulation-organic film may include an acrylic-based compound, an epoxy-based compound, or the like. The encapsulation-organic film may include a photopolymerizable organic material, but embodiments are not limited thereto.

The encapsulation layer TFE may be disposed on the second electrode EL2 and may be disposed to fill the openings OH.

Referring to FIGS. 3 and 4, the display device DD may include non-light emitting regions NPXA and light emitting regions PXA-R, PXA-G, and PXA-B. The light emitting regions PXA-R, PXA-G, and PXA-B may each be a region that emits light respectively generated by the light-emitting elements ED-1, ED-2, and ED-3. The light emitting regions PXA-R, PXA-G, and PXA-B may be spaced apart from each other in a plan view.

The light emitting regions PXA-R, PXA-G, and PXA-B may be regions that are separated from each other by the pixel defining film PDL. The non-light emitting regions NPXA may be areas between the adjacent light emitting regions PXA-R, PXA-G, and PXA-B, and which may correspond to the pixel defining film PDL. In an embodiment, the light emitting regions PXA-R, PXA-G, and PXA-B may each correspond to a pixel. The pixel defining film PDL may separate the light-emitting elements ED-1, ED-2, and ED-3. The light-emitting layers EML-R, EML-G, and EML-B of the light-emitting elements ED-1, ED-2, and ED-3 may be disposed in openings OH defined in the pixel defining film PDL and separated from each other.

The light emitting regions PXA-R, PXA-G, and PXA-B may be arranged into groups according to the color of light generated from the light-emitting elements ED-1, ED-2, and ED-3. In the display device DD according to an embodiment illustrated in FIGS. 3 and 4, three light emitting regions PXA-R, PXA-G, and PXA-B, which respectively emit red light, green light, and blue light, are illustrated as an example. For example, the display device DD may include a red light emitting region PXA-R, a green light emitting region PXA-G, and a blue light emitting region PXA-B, which are distinct from each other.

In the display device DD according to an embodiment, the light-emitting elements ED-1, ED-2, and ED-3 may emit light having wavelengths that are different from each other. For example, in an embodiment, the display device DD may include a first light-emitting element ED-1 that emits red light, a second light-emitting element ED-2 that emits green light, and a third light-emitting element ED-3 that emits blue light. For example, the red light emitting region PXA-R, the green light emitting region PXA-G, and the blue light emitting region PXA-B of the display device DD may respectively correspond to the first light-emitting element ED-1, the second light-emitting element ED-2, and the third light-emitting element ED-3.

However, embodiments are not limited thereto, and the first to third light-emitting elements ED-1, ED-2, and ED-3 may emit light in a same wavelength range or at least one light-emitting element may emit light in a wavelength range that is different from the remainder. For example, the first to third light-emitting elements ED-1, ED-2, and ED-3 may each emit blue light.

The light emitting regions PXA-R, PXA-G, and PXA-B in the display device DD according to an embodiment may be arranged in a stripe configuration. Referring to FIG. 3, the red light emitting regions PXA-R, the green light emitting regions PXA-G, and the blue light emitting regions PXA-B may be respectively arranged along a second directional axis DR2. In another embodiment, the red light emitting region PXA-R, the green light emitting region PXA-G, and the blue light emitting region PXA-B may be arranged in this repeating order along a first directional axis DR1.

FIGS. 3 and 4 illustrate that the light emitting regions PXA-R, PXA-G, and PXA-B all have a similar area, but embodiments are not limited thereto. In an embodiment, the light emitting regions PXA-R, PXA-G, and PXA-B may be different in size or shape from each other, according to a wavelength range of emitted light. The areas of the light emitting regions PXA-R, PXA-G, and PXA-B may be areas in a plan view that are defined by the first directional axis DR1 and the second directional axis DR2. The third directional axis DR3 may be perpendicular to the plane defined by the first directional axis DR1 and the second directional axis DR2.

An arrangement of the light emitting regions PXA-R, PXA-G, and PXA-B is not limited to the configuration illustrated in FIG. 3, and the order in which the red light emitting region PXA-R, the green light emitting region PXA-G, and the blue light emitting region PXA-B are arranged may be provided in various combinations, according to the display quality characteristics that are required for the display device DD. For example, the light emitting regions PXA-R, PXA-G, and PXA-B may be arranged in a pentile configuration (such as PenTile^{®}) or in a diamond configuration (such as Diamond Pixel^{®}).

The areas of the light emitting regions PXA-R, PXA-G, and PXA-B may be different in size from each other. For example, in an embodiment, an area of a green light emitting region PXA-G may be smaller than an area of a blue light emitting region PXA-B, but embodiments are not limited thereto.

Hereinafter, FIG. 5 to FIG. 10 are each a schematic cross-sectional view of a light-emitting element ED according to an embodiment. A light-emitting element ED may include a first electrode EL1, a second electrode EL2 disposed on the first electrode EL1, and a light-emitting layer EML disposed between the first electrode EL1 and the second electrode EL2. The light-emitting element ED may further include a hole transport region HTR between the first electrode EL1 and the light-emitting layer EML, and an electron transport region ETR between the light-emitting layer EML and the second electrode EL2.

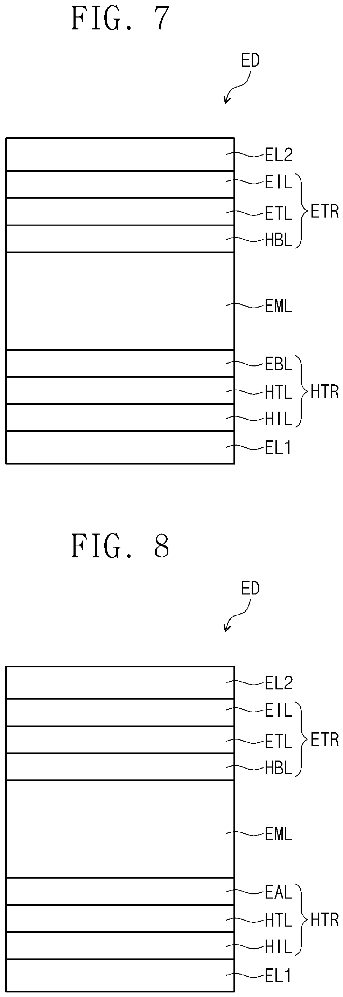

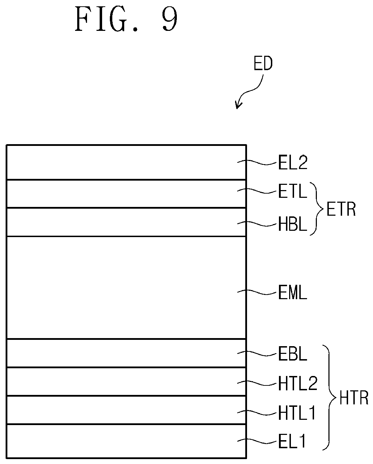

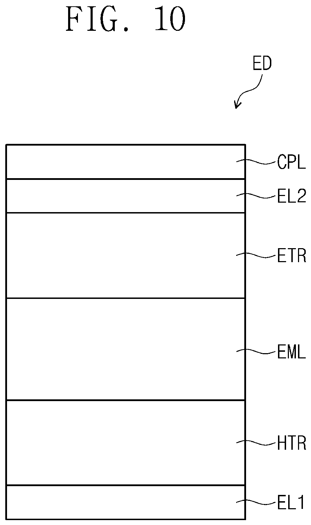

In comparison to FIG. 5, FIG. 6 is a schematic cross-sectional view of a light-emitting element ED according to an embodiment in which the hole transport region HTR includes a hole injection layer HIL and a hole transport layer HTL, and the electron transport region ETR includes an electron injection layer EIL and an electron transport layer ETL. In comparison to FIG. 5, FIG. 7 is a schematic cross-sectional view of a light-emitting element ED according to an embodiment in which the hole transport region HTR includes a hole injection layer HIL, a hole transport layer HTL, and an electron-blocking layer EBL, and the electron transport region ETR includes an electron injection layer EIL, an electron transport layer ETL, and a hole-blocking layer HBL. In comparison to FIG. 5, FIG. 8 is a schematic cross-sectional view of a light-emitting element ED according to an embodiment in which the hole transport region HTR includes a hole injection layer HIL, a hole transport layer HTL, and an auxiliary light-emitting layer EAL, and the electron transport region ETR includes an electron injection layer EIL, an electron transport layer ETL, and a hole-blocking layer HBL. In comparison to FIG. 5, FIG. 9 is a schematic cross-sectional view of a light-emitting element ED according to an embodiment in which the hole transport region HTR includes a hole transport layer HTL and an electron-blocking layer EBL, and the electron transport region ETR includes an electron transport layer ETL and a hole-blocking layer HBL. In FIG. 9, the hole transport layer HTL may include a first hole transport layer HTL1 and a second hole transport layer HTL2. In comparison to FIG. 5, FIG. 10 is a schematic cross-sectional view of a light-emitting element ED according to an embodiment that further includes a capping layer CPL disposed on the second electrode EL2.

The first electrode EL1 has conductivity. The first electrode EL1 may be formed of a metal material, a metal alloy, or a conductive compound. The first electrode EL1 may be an anode or a cathode. However, embodiments are not limited thereto. In an embodiment, the first electrode EL1 may be a pixel electrode. The first electrode EL1 may be a transmissive electrode, a transflective electrode, or a reflective electrode. The first electrode EL1 may include at least one of Ag, Mg, Cu, Al, Pt, Pd, Au, Ni, Nd, Ir, Cr, Li, Ca, LiF, Mo, Ti, W, In, Sn, Zn, an oxide thereof, a compound thereof, and a mixture thereof.

If the first electrode EL1 is a transmissive electrode, the first electrode EL1 may include a transparent metal oxide such as indium tin oxide (ITO), indium zinc oxide (IZO), zinc oxide (ZnO), or indium tin zinc oxide (ITZO). If the first electrode EL1 is a transflective electrode or a reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, a compound thereof, or a mixture thereof (e.g., a mixture of Ag and Mg). In another embodiment, the first electrode EL1 may have a multilayered structure including a reflective film or a transflective film formed of the above-described materials, and a transparent conductive film formed of ITO, IZO, ZnO, ITZO, etc. For example, the first electrode EL1 may have a three-layered structure of ITO/Ag/ITO, but embodiments are not limited thereto. In an embodiment, the first electrode EL1 may include the above-described metal materials, combinations of at least two of the above-described metal materials, oxides of the above-described metal materials, or the like. A thickness of the first electrode EL1 may be in a range of about 700 Å to about 10,000 Å. For example, the thickness of the first electrode EL1 may be in a range of about 1,000 Å to about 3,000 Å.

The hole transport region HTR may be provided on the first electrode EL1. The hole transport region HTR may include at least one of a hole injection layer HIL, a hole transport layer HTL, a buffer layer (not shown), an auxiliary light-emitting layer EAL, and an electron blocking layer EBL. A thickness of the hole transport region HTR may be, for example, in a range of about 50 Å to about 15,000 Å.

The hole transport region HTR may have a structure consisting of a layer consisting of a single material, a structure consisting of a layer including different materials, or a structure including multiple layers including different materials.

For example, the hole transport region HTR may have a single-layered structure of a hole injection layer HIL or a hole transport layer HTL, or may have a single-layered structure formed of a hole injection material and a hole transport material. In embodiments, the hole transport region HTR may have a single-layered structure formed of different materials, or may have a structure in which a hole injection layer HIL/hole transport layer HTL, a hole injection layer HIL/hole transport layer HTL/buffer layer (not shown), a hole injection layer HIL/buffer layer (not shown), a hole transport layer HTL/buffer layer (not shown), or a hole injection layer HIL/hole transport layer HTL/electron blocking layer EBL are stacked in its respectively stated order from the first electrode EL1, but embodiments are not limited thereto.

The hole injection layer HIL, the hole transport layer HTL, the electron-blocking layer EBL, and the auxiliary light-emitting layer EAL may each independently have a structure consisting of a layer consisting of a single material, a structure consisting of a layer including different materials, or a structure including multiple layers including different materials. For example, the hole transport layer HTL may have a single-layered structure consisting of a hole transport material or a structure including multiple hole transport materials. For example, the hole transport layer HTL may include a first hole transport layer HTL1 stacked on the first electrode EL1 and the second hole transport layer HTL2 stacked on the first hole transport layer HTL1. However, embodiments are not limited thereto, and the hole transport layer HTL may have a multilayered structure that includes at least three layers.

The hole transport region HTR may be formed using various methods such as a vacuum deposition method, a spin coating method, a cast method, a Langmuir-Blodgett (LB) method, an inkjet printing method, a laser printing method, and a laser induced thermal imaging (LITI) method.

In the light-emitting element ED according to an embodiment, the hole transport region HTR may include a compound represented by Formula H-1:

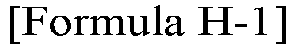

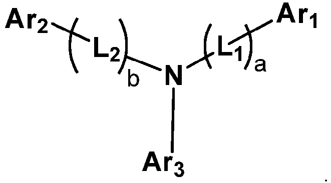

In Formula H-1, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms. In Formula H-1, a and b may each independently be an integer from 0 to 10. When a or b is 2 or greater, multiple L₁ groups or multiple L₂ groups may each independently be a substituted or unsubstituted arylene group having 6 to 30 ring-forming carbon atoms or a substituted or unsubstituted heteroarylene group having 2 to 30 ring-forming carbon atoms.

In Formula H-1, Ar₁ and Ar₂ may each independently be a substituted or unsubstituted aryl group having 6 to 30 ring-forming carbon atoms or a substituted or unsubstituted heteroaryl group having 2 to 30 ring-forming carbon atoms. In Formula H-1, Ar₃ may be a substituted or unsubstituted aryl group having 6 to 30 ring-forming carbon atoms or a substituted or unsubstituted heteroaryl group having 2 to 30 ring-forming carbon atoms.

In an embodiment, the compound represented by Formula H-1 may be a monoamine compound. In another embodiment, the compound represented by Formula H-1 may be a diamine compound in which at least one of Ar₁ to Ar₃ includes an amine group as a substituent. In an embodiment, the compound represented by Formula H-1 may be a carbazole-based compound in which at least one of Ar₁ and Ar₂ includes a substituted or unsubstituted carbazole group, or may be a fluorene-based compound in which at least one of Ar₁ and Ar₂ includes a substituted or unsubstituted fluorene group.

The compound represented by Formula H-1 may be any compound selected from Compound Group H. However, the compounds listed in Compound Group H are only examples, and a compound represented by Formula H-1 is not limited to Compound Group H:

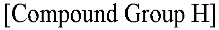

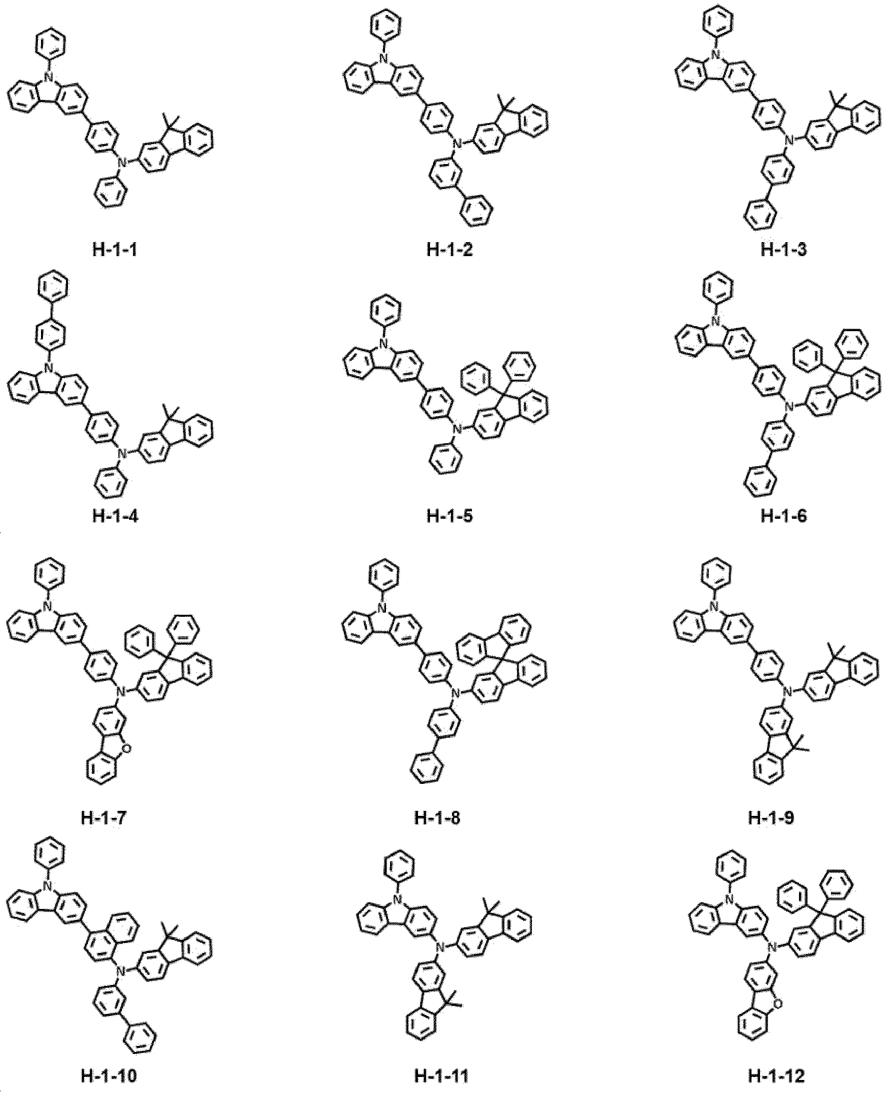

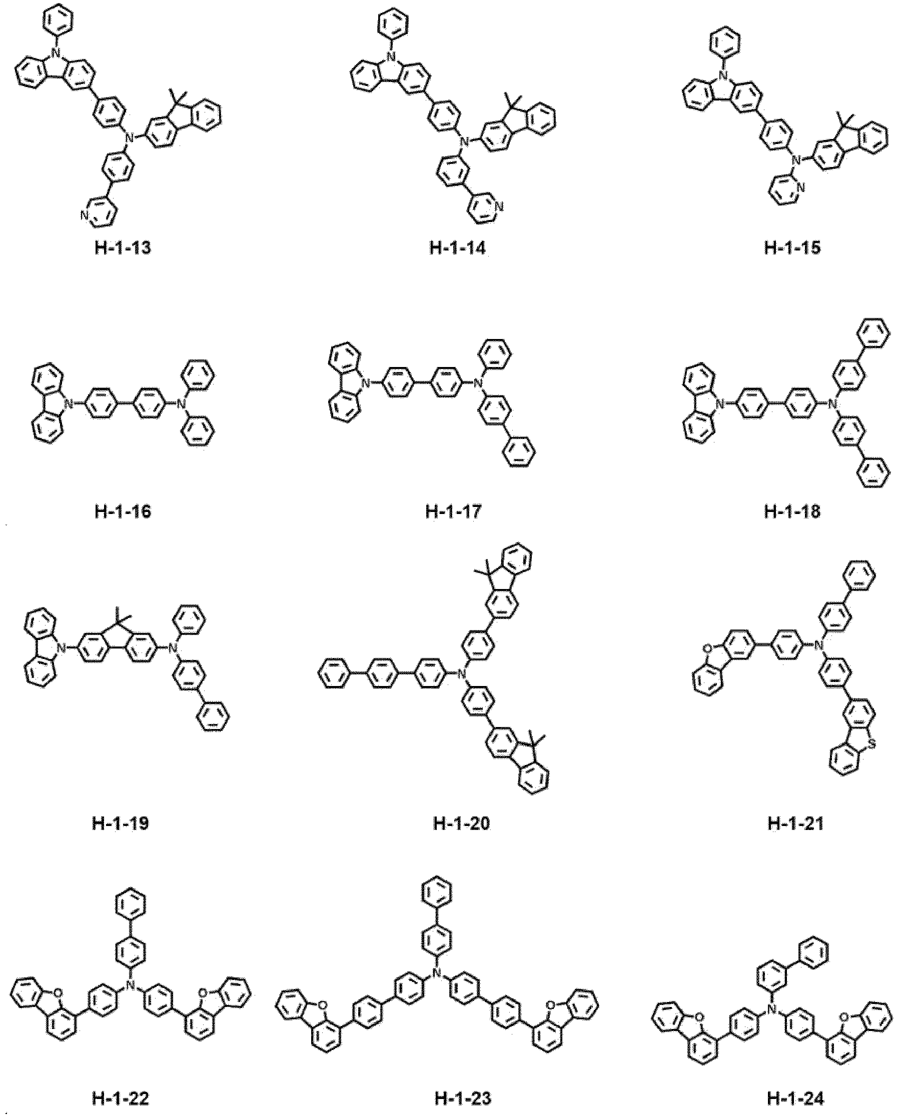

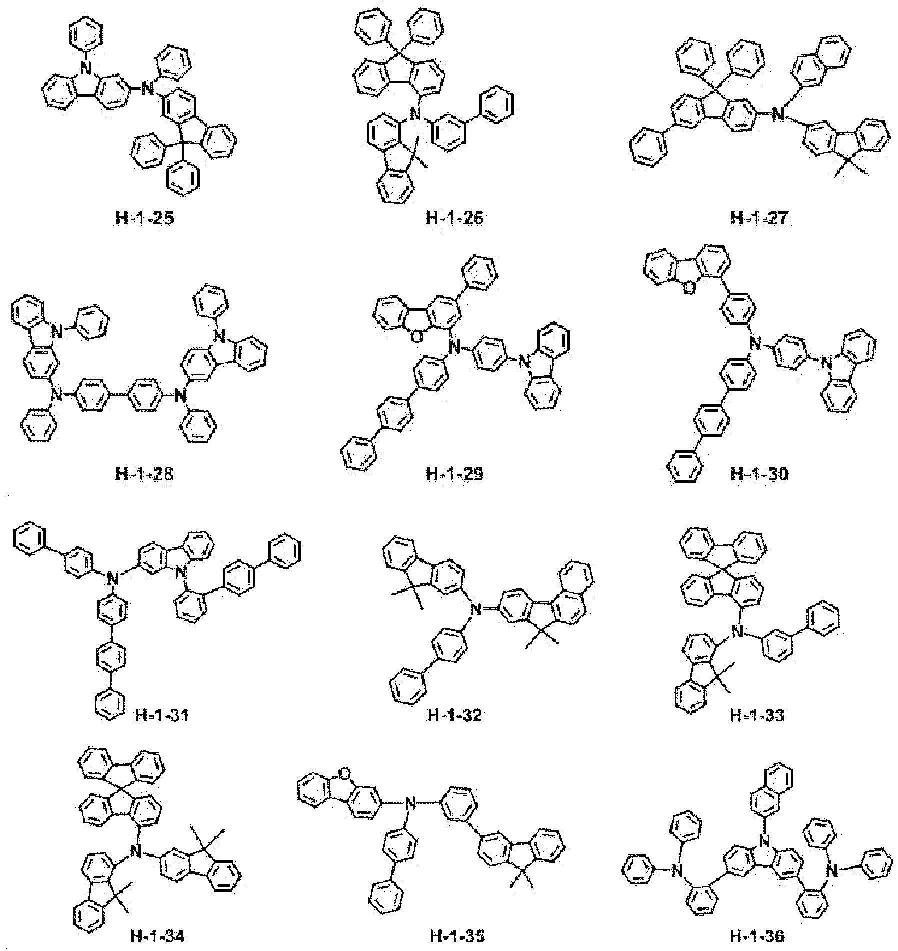

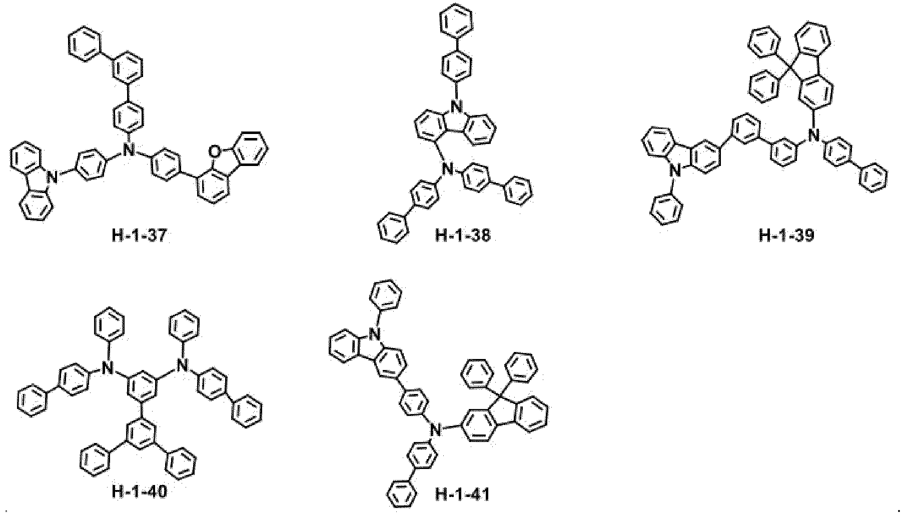

The hole transport region HTR may include a phthalocyanine compound such as copper phthalocyanine, N¹,N^{1'}-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4',4''-tris(N,N-diphenylamino)triphenylamine (TDATA), 4,4',4"-tris[N-(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalene-1-yl)-N,N'-diphenyl-benzidine (NPB), triphenylamine-containing polyetherketone (TPAPEK), 4-isopropyl-4'-methyldiphenyliodonium [tetrakis(pentafluorophenyl)borate], dipyrazino[2,3-f: 2',3'-h]quinoxaline-2,3,6,7,10,11-hexacarbonitrile (HAT-CN), etc.

The hole transport region HTR may include a carbazole-based derivative such as 1,3-bis(N-carbazolyl)benzene (mCP), N-phenyl carbazole or polyvinyl carbazole, a fluorene-based derivative, a triphenylamine-based derivative such as N,N'-bis(3-methylphenyl)-N,N'-diphenyl-[1,1-biphenyl]-4,4'-diamine (TPD) or 4,4',4''-tris(N-carbazolyl)triphenylamine (TCTA), N,N'-di(naphthalene-1-yl)-N,N'-diphenyl-benzidine (NPB), 4,4'-cyclohexylidene bis[N,N-bis(4-methylphenyl]benzenamine] (TAPC), 4,4'-bis[N,N'-(3-tolyl)amino]-3,3'-dimethylbiphenyl (HMTPD), etc.

In an embodiment, the hole transport region HTR may include 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), etc.

The hole transport region HTR may include the above-described compounds of the hole transport region in at least one of a hole injection layer HIL, a hole transport layer HTL, an auxiliary light-emitting layer EAL, and an electron blocking layer EBL.

In an embodiment, the hole transport region HTR may include a compound having a positive giant surface potential. The hole transport region HTR may include the compound having a positive giant surface potential in at least one of the hole injection layer HIL, the hole transport layer HTL, the auxiliary light-emitting layer EAL, and the electron-blocking layer EBL.

When the compound having a positive giant surface potential is included in the hole transport region HTR having a multi-layered structure, the compound having a positive giant surface potential may be included in a layer adjacent to the light-emitting layer EML. For example, the compound having a positive giant surface potential may be included in an electron-blocking layer EBL, but embodiments are not limited thereto.

The compound having a positive giant surface potential included in the hole transport region HTR may be represented by Formula 3, which will be described later. In an embodiment, the compound having a positive giant surface potential included in the hole transport region HTR may be a compound selected from Compound Group 3, which will be explained below. The compound having a positive giant surface potential included in the hole transport region HTR may be the same as or different from a hole-transporting host compound included in the light-emitting layer EML.

A thickness of the hole transport region HTR may be in a range of about 100 Å to about 10,000 Å. For example, the thickness of the hole transport region HTR may be in a range of about 100 Å to about 5,000 Å. When the hole transport region HTR includes a hole injection layer HIL, the hole injection layer HIL may have a thickness in a range of about 30 Å to about 1,000 Å. When the hole transport region HTR includes a hole transport layer HTL, the hole transport layer HTL may have a thickness in a range of about 250 Å to about 1,000 Å. When the hole transport region HTR includes an electron blocking layer EBL, the electron blocking layer EBL may have a thickness in a range of about 10 Å to about 1,000 Å. If the thicknesses of the hole transport region HTR, the hole injection layer HIL, the hole transport layer HTL, and the electron blocking layer EBL satisfy the above-described ranges, satisfactory hole transport properties may be achieved without a substantial increase in driving voltage.

The hole transport region HTR may further include a charge generating material to increase conductivity, in addition to the above-described materials. The charge generating material may be dispersed uniformly or non-uniformly in the hole transport region HTR. The charge generating material may be, for example, a p-dopant. The p-dopant may include at least one of a metal halide, a quinone derivative, a metal oxide, and a cyano group-containing compound, but embodiments are not limited thereto. For example, the p-dopant may include a metal halide compound such as CuI or RbI, a quinone derivative such as tetracyanoquinodimethane (TCNQ) or 2,3,5,6-tetrafluoro-7,7,8,8-tetracyanoquinodimethane (F4-TCNQ), a metal oxide such as tungsten oxide or molybdenum oxide, a cyano group-containing compound such as dipyrazino[2,3-f: 2',3'-h] quinoxaline-2,3,6,7,10,11-hexacarbonitrile (HAT-CN) or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), etc., but embodiments are not limited thereto.

As described above, the hole transport region HTR may further include at least one of an auxiliary light-emitting layer EAL and an electron blocking layer EBL, in addition to a hole injection layer HIL and a hole transport layer HTL. The auxiliary light-emitting layer EAL may increase light emission efficiency by compensating for a resonance distance according to a wavelength of light emitted by the light-emitting layer EML, by controlling hole charge balance. The auxiliary light-emitting layer EAL may also prevent electron injection to the hole transport region HTR. A material that may be included in the hole transport region HTR may be used as a material included in the auxiliary light-emitting layer EAL. The electron-blocking layer EBL may prevent the injection of electrons from an electron transport region ETR to the hole transport region HTR.

The light-emitting layer EML may be provided on the hole transport region HTR. The light-emitting layer EML may have a thickness in a range of about 100 Å to about 1,000 Å. For example, the light-emitting layer EML may have a thickness in a range of about 100 Å to about 300 Å. The light-emitting layer EML may have a structure consisting of a layer consisting of a single material, a structure consisting of a layer including different materials, or a structure including multiple layers including different materials.

In the light-emitting element ED according to an embodiment, the light-emitting layer EML may include a hole-transporting host compound, an electron-transporting host compound, a phosphorescent compound, and a fluorescent compound. Hereinafter, the hole-transporting host compound may be referred to as an "HT host", the electron-transporting host compound may be referred to as an "ET host", the phosphorescent compound may be referred to as a first compound, and the fluorescent compound may be referred to as a second compound.

In an embodiment, at least one of the HT host and the ET host may have a lower giant surface potential than the first compound. For example, a giant surface potential of the hole-transporting host compound and a giant surface potential of the electron-transporting host compound may each be smaller than a giant surface potential of the phosphorescent compound. In an embodiment, the giant surface potential of the hole-transporting host compound or the giant surface potential of the electron-transporting host compound may be smaller than the giant surface potential of the phosphorescent compound.

In the specification, a giant surface potential may be a surface potential derived from an organic layer due to an electric field that, when an organic material having a dipole aligns in a specific direction in forming an organic layer, such as the light-emitting layer EML, the dipole makes. Hereinafter, the giant surface potential may be referred to as a "GSP".

In the specification, a negative giant surface potential means a surface potential that derives a positive charge in a direction of the first electrode EL1, for example, an anode, and derives a negative charge in an opposite direction from the anode. In the specification, a positive giant surface potential means a surface potential that derives a negative charge in a direction of the first electrode EL1, for example, the anode, and derives a positive charge in an opposite direction from the anode.

A negative giant surface potential and a positive giant surface potential may be each a potential gradient of a surface potential obtained by measuring the surface potential according to a thickness of the organic layer through a Kelvin probe. The negative giant surface potential may be a giant surface potential having a negative slope, and the positive giant surface potential may be a giant surface potential having a positive slope. Hereinafter, a negative giant surface potential may be referred to as a "negative GSP", and the positive giant surface potential may be referred to as a "positive GSP".

In the light-emitting layer EML according to an embodiment, at least one of the HT host and the ET host may have a GSP that is opposite of a GSP of the first compound. The first compound may be a positive GSP-deriving compound. At least one of the HT host and the ET host may be a negative GSP-deriving compound.

The positive GSP-deriving compound may be a compound that exhibits a positive ("+") surface potential on a surface of the organic layer in forming the organic layer, such as the light-emitting layer EML. The first compound, which is a positive GSP-deriving compound, may have a positive GSP in the light-emitting layer EML.

The negative GSP-deriving compound may be a compound that exhibits a negative ("-") surface potential on a surface of the organic layer in forming the organic layer, such as the light-emitting layer EML. At least one of the HT host and the ET host may include a negative GSP-deriving compound. At least one of the HT host and the ET host may have a negative GSP in the light-emitting layer EML. The HT host having a negative GSP may be referred to as a first HT host, and the ET host having a negative GSP may be referred to as a first ET host. The HT host not having a negative GSP may be referred to as a second HT host, and the ET host not having a negative GSP may be referred to as a second ET host. The second HT host and the second ET host may each have a positive GSP. When the light-emitting layer EML includes the first HT host, the ET host may be the first ET host or the second ET host. When the light-emitting layer EML includes the second HT host, the ET host may be the first ET host. When the light-emitting layer EML includes the first ET host, the HT host may be the first HT host or the second HT host. When the light-emitting layer EML includes the second ET host, the HT host may be the first HT host.

The light-emitting layer EML according to an embodiment may include the first compound, the first HT host, and the first ET host. In an embodiment, the light-emitting layer EML may include the first compound, the first HT host, and the second ET host, but embodiments are not limited thereto. For example, the light-emitting layer EML may include the first compound, the second HT host, and the first ET host.

In an embodiment, the first HT host may be represented by Formula 1. The first HT host represented by Formula 1 may be a negative GSP-deriving compound, and may be included in the light-emitting layer EML to have a negative GSP.

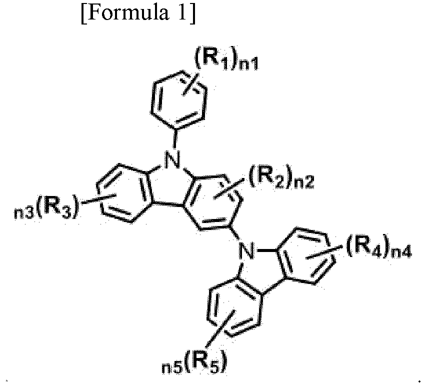

In Formula 1, R₁ to R₃ may each independently be a hydrogen atom, a deuterium atom, a substituted or unsubstituted aryl group having 6 to 30 ring-forming carbon atoms, or a substituted or unsubstituted heteroaryl group having 5 to 30 ring-forming carbon atoms. For example, R₁ to R₃ may each independently be a hydrogen atom, a substituted or unsubstituted phenyl group, or a substituted or unsubstituted dibenzofuran group, but embodiments are not limited thereto.

In Formula 1, R₄ and R₅ may each independently be a hydrogen atom, a deuterium atom, or a substituted or unsubstituted silyl group. For example, R₄ and R₅ may each independently be a hydrogen atom, or a substituted or unsubstituted triphenylsilyl group, but embodiments are not limited thereto.

In Formula 1, n1 may be an integer from 0 to 5, n2 may be an integer from 0 to 3, and n3 to n5 may each independently be an integer from 0 to 4. When n1 is at least 2, multiple R₁ groups may all be the same, or at least one thereof may be different from the remainder. A case in which n1 is 0 may be the same as a case in which n1 is 5, and five R₁ groups are all hydrogen atoms. When n2 is at least 2, multiple R₂ groups may all be the same, or at least one thereof may be different from the remainder. A case in which n2 is 0 may be the same as a case in which n2 is 3, and three R₂ groups are all hydrogen atoms. When n3 to n5 are each at least 2, multiple groups of each of R₃, R₄, and R₅ may all be the same, or at least one thereof may be different from the remainder. A case in which n3 to n5 are each 0 may be the same as a case in which n3 to n5 are each 4 and four groups of each of R₃, R₄, and R₅ are all hydrogen atoms.

In an embodiment, the first HT host represented by Formula 1 may be any compound selected from Compound Group 1. In an embodiment, in the light-emitting element ED, the first HT host may include at least one compound selected from Compound Group 1:

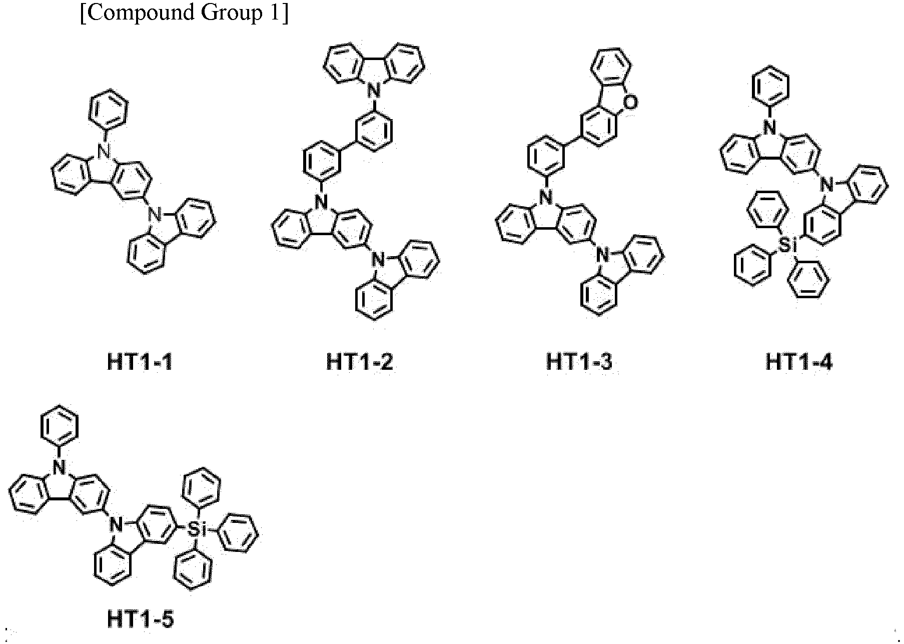

In Compound Group 1, Compound HT1-1 may have a GSP of about -28 mV/nm, Compound HT1-2 may have a GSP of about -41 mV/nm, Compound HT1-3 may have a GSP of about -20 mV/nm, Compound HT1-4 may have a GSP of about -1 mV/nm, and Compound HT1-5 may have a GSP of about -36 mV/nm.

In an embodiment, the first ET host may be represented by Formula 2. The first ET host represented by Formula 2 may be a negative GSP-deriving compound, and may be included in the light-emitting layer EML to have a negative GSP.

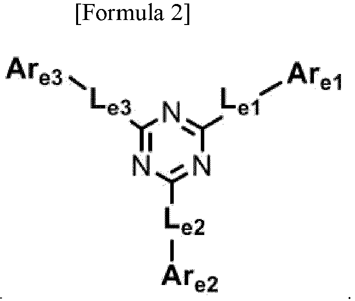

In Formula 2, Lₑ₁ to Lₑ₃ may each independently be a direct linkage or a substituted or unsubstituted arylene group having 6 to 30 ring-forming carbon atoms. For example, Lₑ₁ to Lₑ₃ may each independently be a direct linkage or a substituted or unsubstituted phenylene group.

In Formula 2, Arₑ₁ to Arₑ₃ may each independently be a substituted or unsubstituted aryl group having 6 to 30 ring-forming carbon atoms, or a substituted or unsubstituted heteroaryl group having 5 to 30 ring-forming carbon atoms. For example, Arₑ₁ to Arₑ₃ may each independently be a substituted phenyl group, a substituted biphenyl group, or an unsubstituted carbazole group, but embodiments are not limited thereto. In Formula 2, when Lₑ₁ to Lₑ₃ are each a direct linkage, a case in which Arₑ₁ to Arₑ₃ are each substituted with a triphenylsilyl group may be excluded. For example, in Formula 2, when Lₑ₁ to Lₑ₃ are each a direct linkage, none of Arₑ₁ to Arₑ₃ may be a phenyl group substituted with a triphenylsilyl group.

In an embodiment, the first ET host represented by Formula 2 may be any compound selected from Compound Group 2. In an embodiment, in the light-emitting element ED, the first ET host may include at least one compound selected from Compound Group 2:

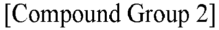

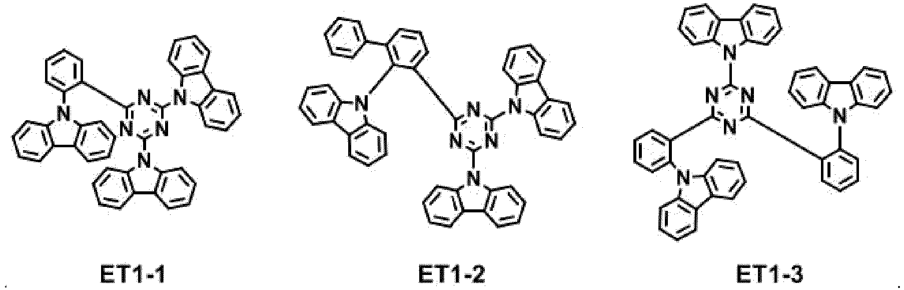

In Compound Group 2, Compound ET1-1 may have a GSP of about -19 mV/nm, Compound ET1-2 may have a GSP of about -5 mV/nm, and Compound ET1-3 may have a GSP of about -9 mV/nm.

In the light-emitting element ED according to an embodiment, at least one of the HT host and the ET host included in the light-emitting layer EML may have a negative GSP, and thus it may compensate for an increase in capacitance of the light-emitting element ED caused by the first compound having a relatively high positive GSP, so that an injection voltage may be suppressed.

In an embodiment, the light-emitting layer EML may include a second HT host represented by Formula HT-1 as the hole-transporting host compound. For example, the light-emitting layer EML may include the first ET host having a negative GSP, and the HT host included in the light-emitting layer EML may be the second HT host. The second HT host may be a positive GSP-deriving compound. For example, the second HT host may have a GSP greater than 0 and equal to or less than about 13 mV/nm, but embodiments are not limited thereto.

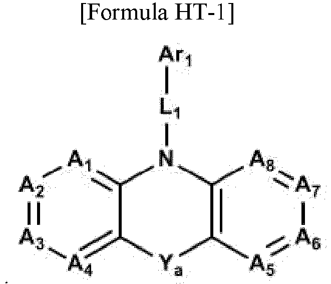

In Formula HT-1, A₁ to As may each independently be N or C(R₅₁). For example, A₁ to As may each independently be C(R₅₁). As another example, one of A₁ to As may be N, and the remainder of A₁ to As may each independently be C(R₅₁).

In Formula HT-1, L₁ may be a direct linkage, a substituted or unsubstituted arylene group having 6 to 30 ring-forming carbon atoms, or a substituted or unsubstituted heteroarylene group having 2 to 30 ring-forming carbon atoms. For example, L₁ may be a direct linkage, a substituted or unsubstituted phenylene group, a substituted or unsubstituted divalent biphenyl group, a substituted or unsubstituted divalent carbazole group, etc., but embodiments are not limited thereto.

In Formula HT-1, Yₐ may be a direct linkage, C(R₅₂)(R₅₃), or Si(R₅₄)(R₅₅). For example, the two rings that are linked to the nitrogen atom in Formula HT-1 may be linked to each other via a direct linkage, 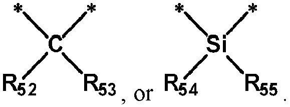 In Formula HT-1, when Yₐ is a direct linkage, the second HT host represented by Formula HT-1 may include a carbazole moiety.

In Formula HT-1, Ar₁ may be a substituted or unsubstituted aryl group having 6 to 30 ring-forming carbon atoms or a substituted or unsubstituted heteroaryl group having 2 to 30 ring-forming carbon atoms. For example, Ar₁ may be a substituted or unsubstituted carbazole group, a substituted or unsubstituted dibenzofuran group, a substituted or unsubstituted dibenzothiophene group, a substituted or unsubstituted biphenyl group, etc., but embodiments are not limited thereto.

In Formula HT-1, R₅₁ to R₅₅ may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, or bonded to an adjacent group to form a ring. For example, R₅₁ to R₅₅ may each independently be a hydrogen atom or a deuterium atom. As another example, R₅₁ to R₅₅ may each independently be an unsubstituted methyl group or an unsubstituted phenyl group.

In an embodiment, the second HT host represented by Formula HT-1 may be any compound selected from Compound Group 3. In an embodiment, in the light-emitting element ED, the second HT host may include at least one compound selected from Compound Group 3:

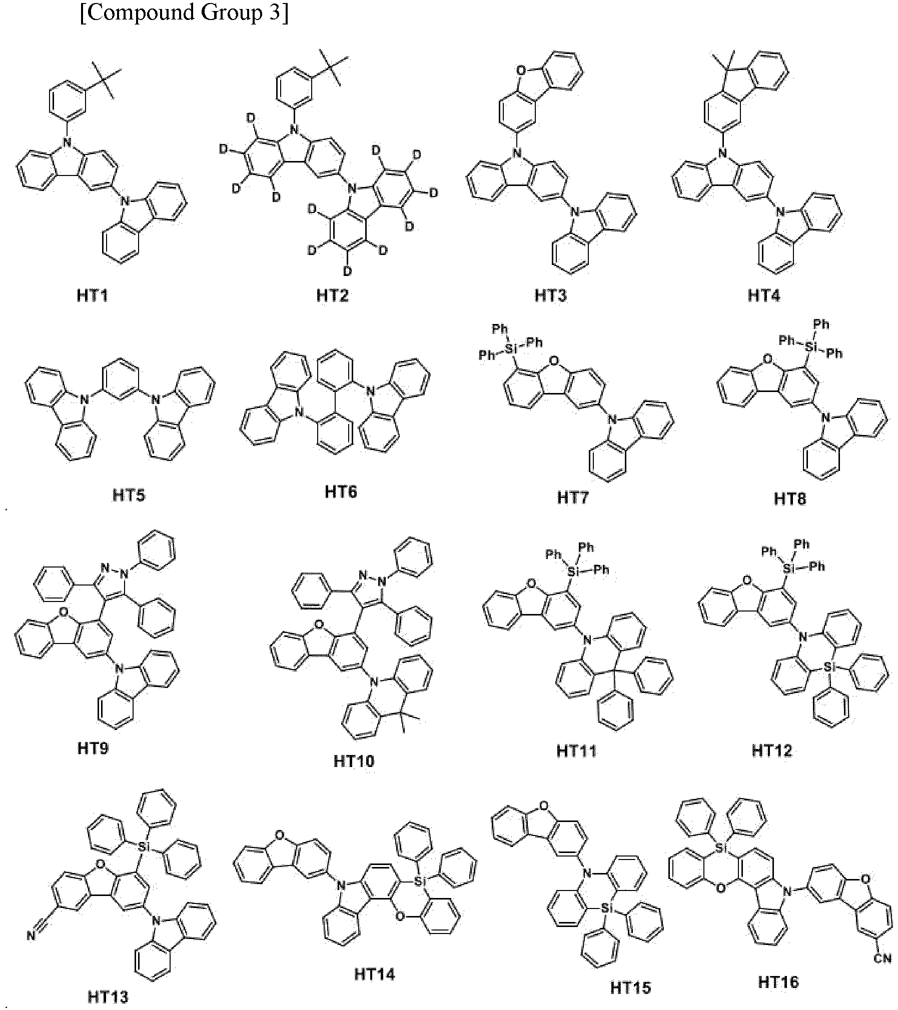

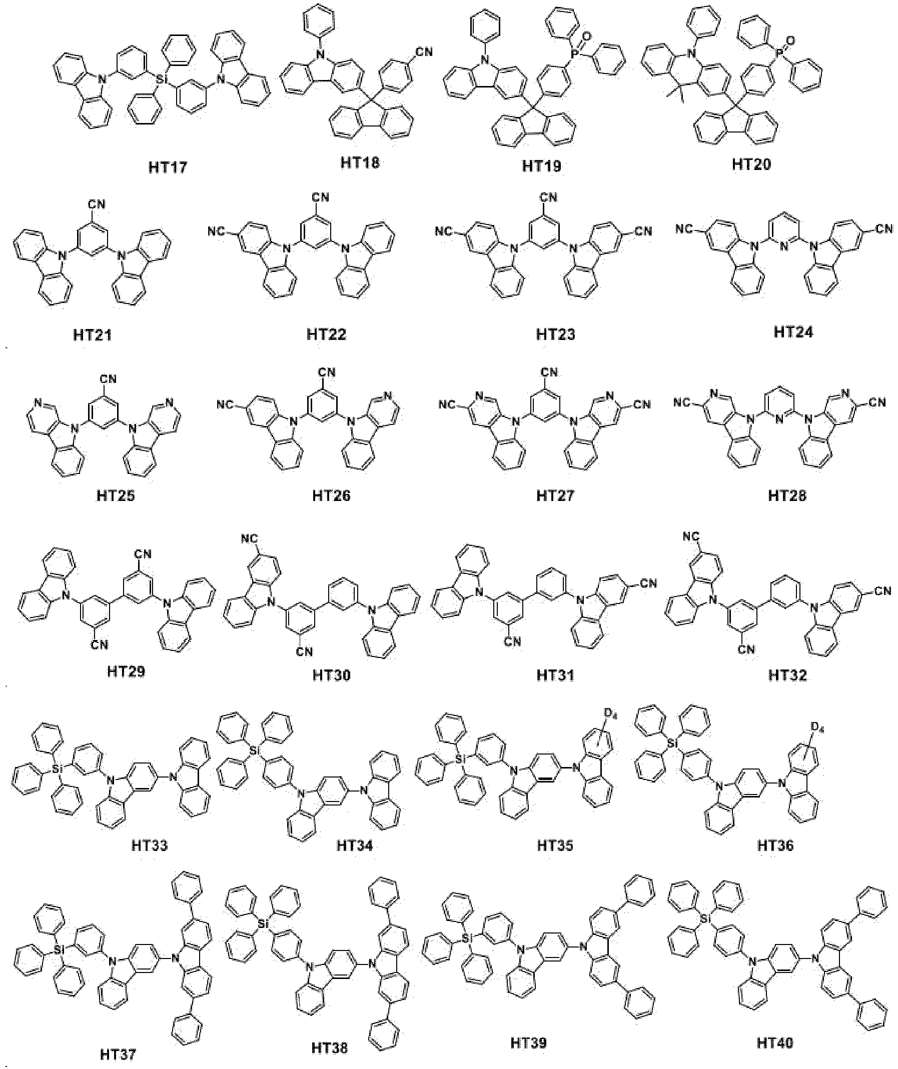

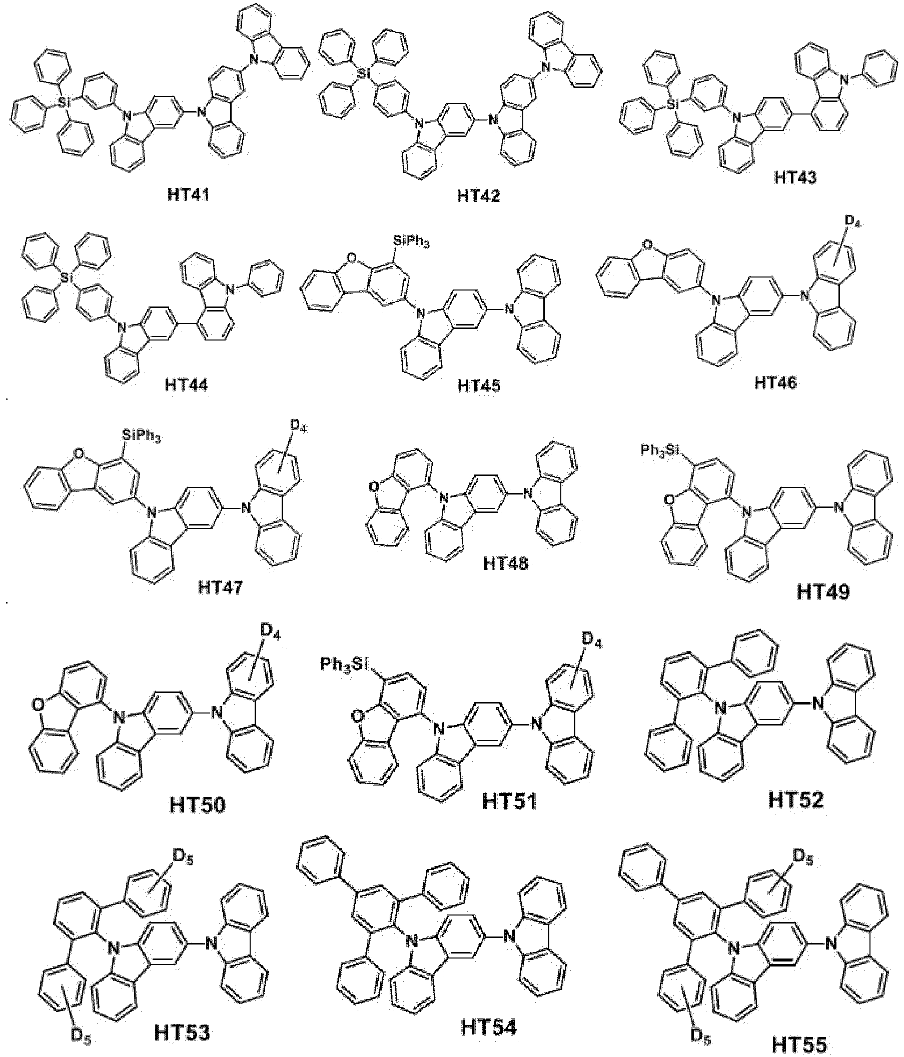

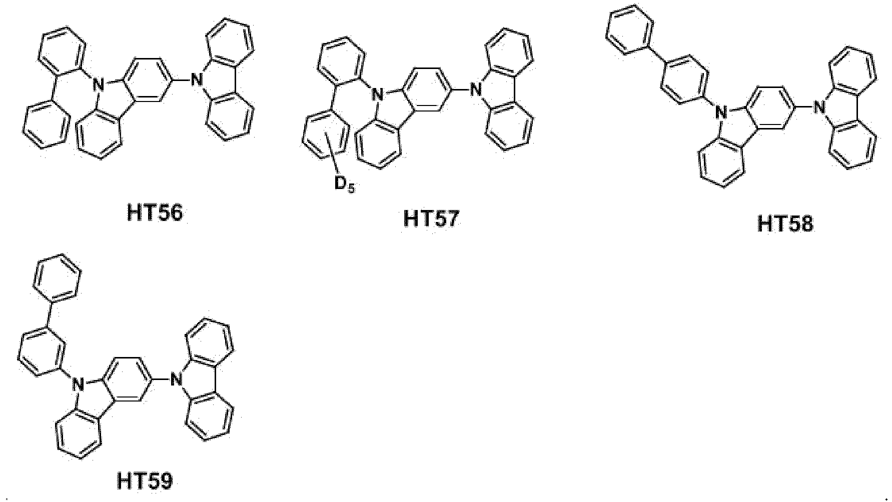

In Compound Group 3, D represents a deuterium atom, and Ph represents a substituted or unsubstituted phenyl group. For example, in Compound Group 3, Ph may represent an unsubstituted phenyl group.

At least one compound selected from Compound Group 3 may be included in the hole transport region HTR. For example, at least one compound selected from Compound Group 3 may be included in an electron-blocking layer EBL, but embodiments are not limited thereto.

In an embodiment, the light-emitting layer EML may include a second ET host represented by Formula ET-1 as the electron-transporting host compound. For example, the light-emitting layer EML may include the first HT host having a negative GSP, and the ET host included in the light-emitting layer EML may be the second ET host. The second ET host may be a positive GSP-deriving compound.

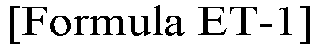

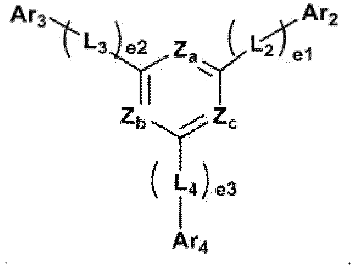

In Formula ET-1, at least one of Zₐ to Z_{c} may each be N; and the remainder of Zₐ to Z_{c} may each independently be C(R₅₆). For example, one of Zₐ to Z_{c} may be N, and the remainder of Zₐ to Z_{c} may each independently be C(R₅₆). Thus, the second ET host represented by Formula ET-1 may include a pyridine moiety. As another example, two of Zₐ to Z_{c} may each be N, and the remainder of Zₐ to Z_{c} may be C(R₅₆). Thus, the second ET host represented by Formula ET-1 may include a pyrimidine moiety. As yet another example, Zₐ to Z_{c} may each be N. Thus, the second ET host represented by Formula ET-1 may include a triazine moiety.

In Formula ET-1, R₅₆ may be a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula ET-1, e1 to e3 may each independently be an integer from 0 to 10.

In Formula ET-1, Ar₂ to Ar₄ may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, Ar₂ to Ar₄ may each independently be a substituted or unsubstituted phenyl group or a substituted or unsubstituted carbazole group.

In Formula ET-1, L₂ to L₄ may each independently be a direct linkage, a substituted or unsubstituted arylene group having 6 to 30 ring-forming carbon atoms, or a substituted or unsubstituted heteroarylene group having 2 to 30 ring-forming carbon atoms. When e1 to e3 are each 2 or greater, multiple groups of each of L₂ to L₄ may each independently be a substituted or unsubstituted arylene group having 6 to 30 ring-forming carbon atoms, or a substituted or unsubstituted heteroarylene group having 2 to 30 ring-forming carbon atoms.

In an embodiment, the second ET host represented by Formula ET-1 may be any compound selected from Compound Group 4. In an embodiment, in the light-emitting element ED, the second ET host may include at least one compound selected from Compound Group 4:

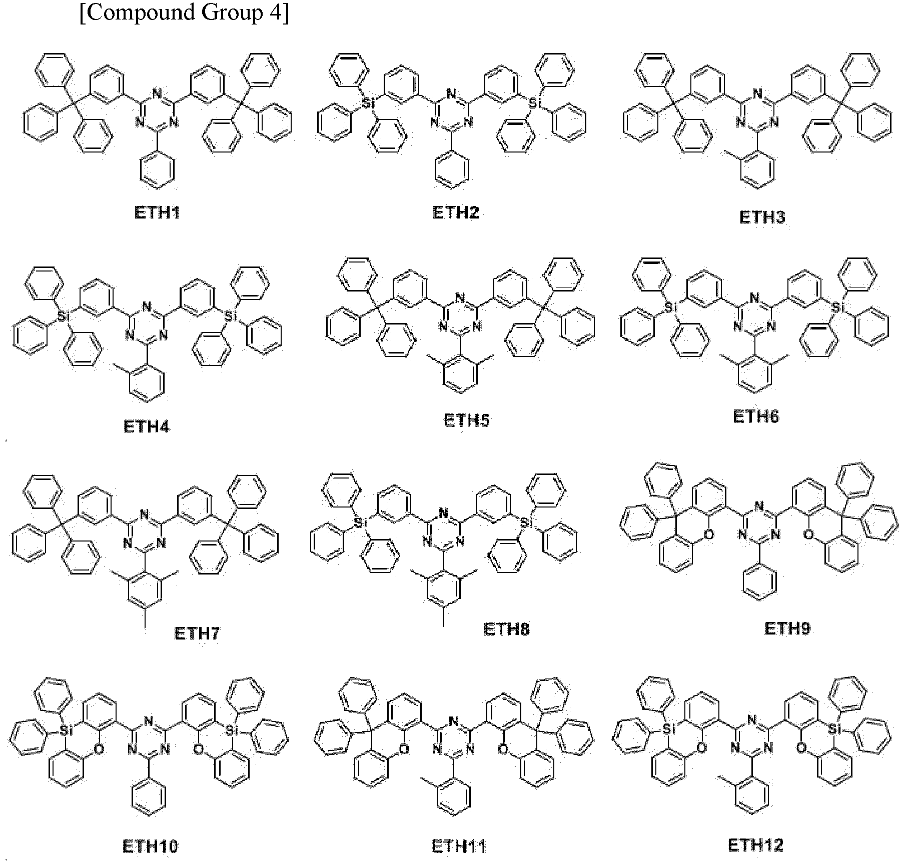

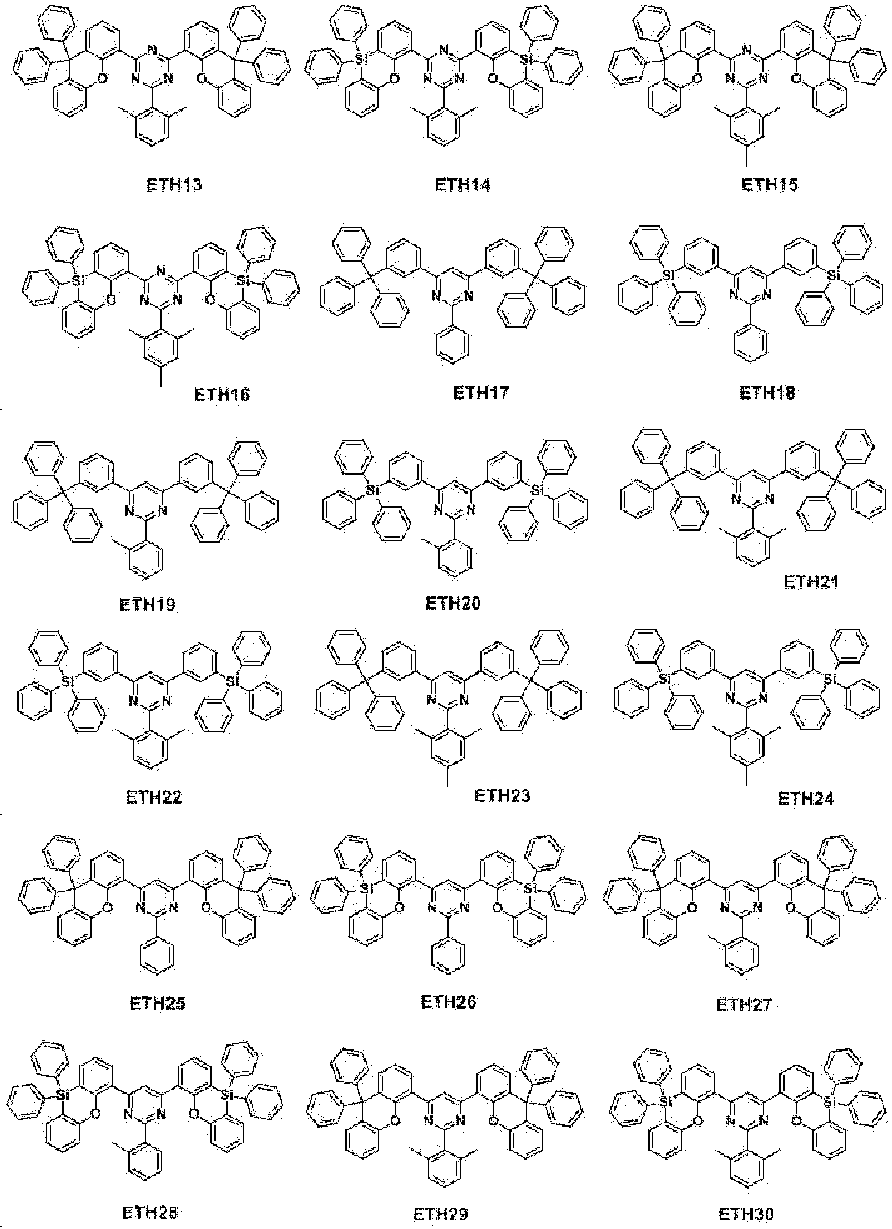

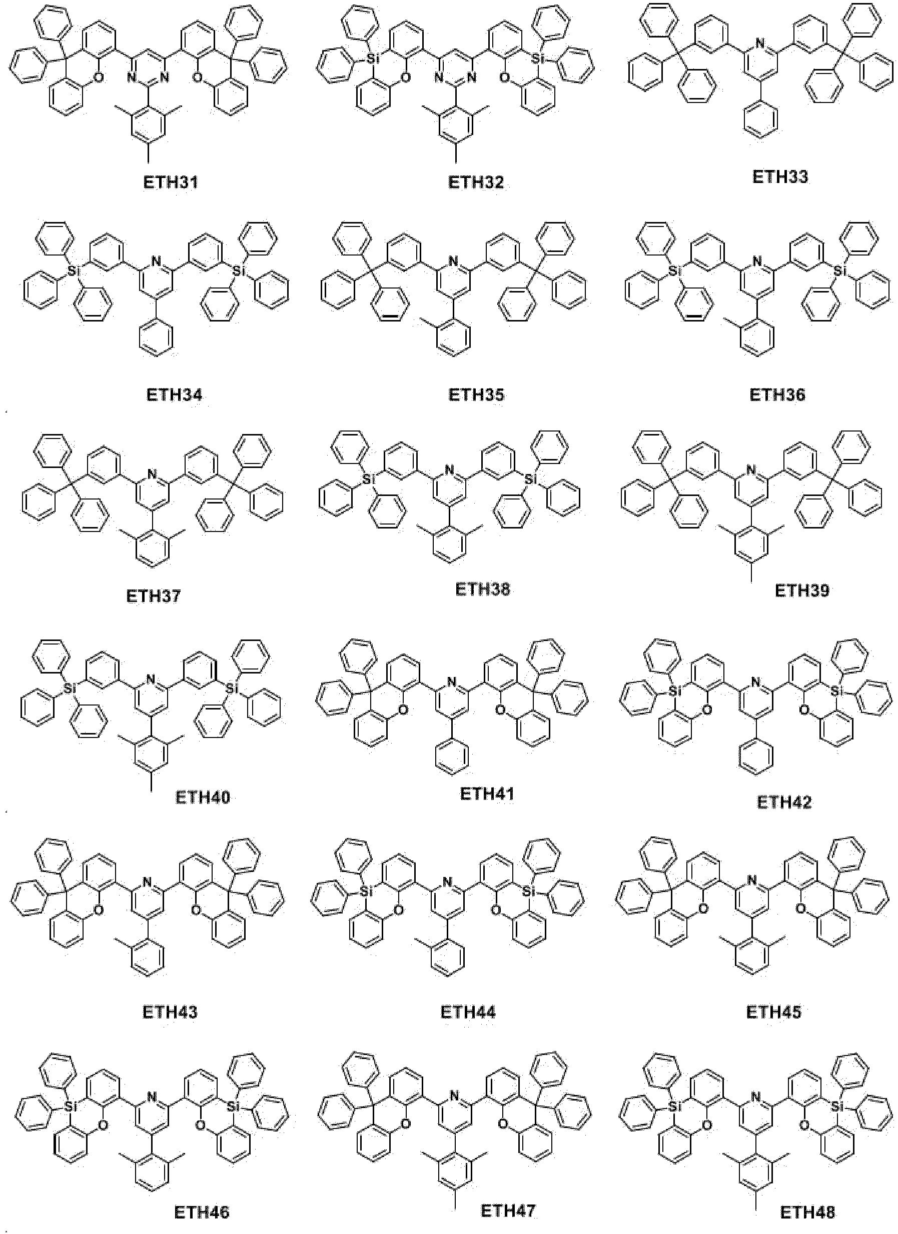

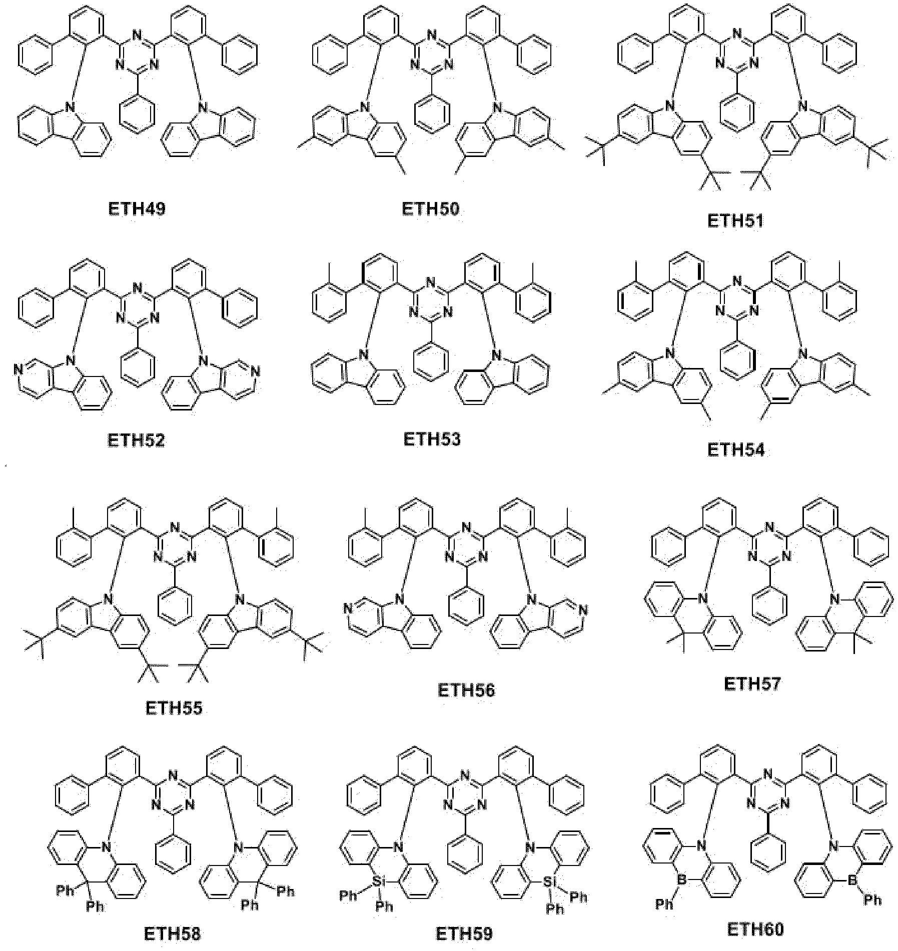

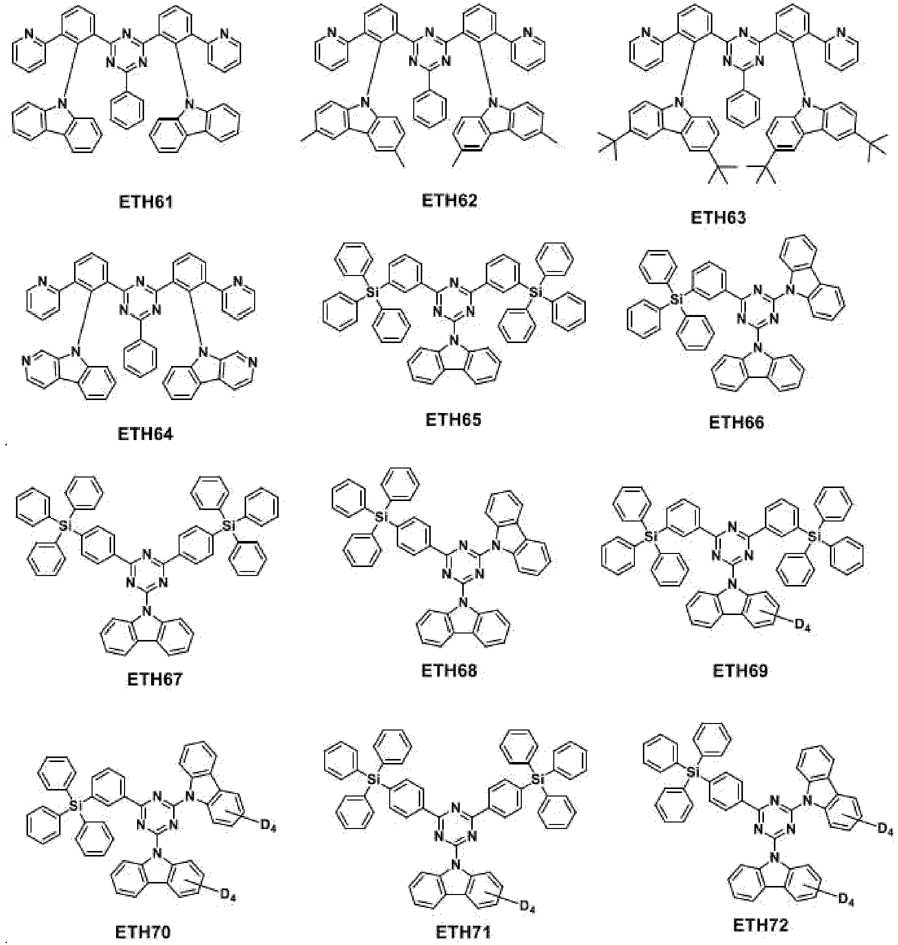

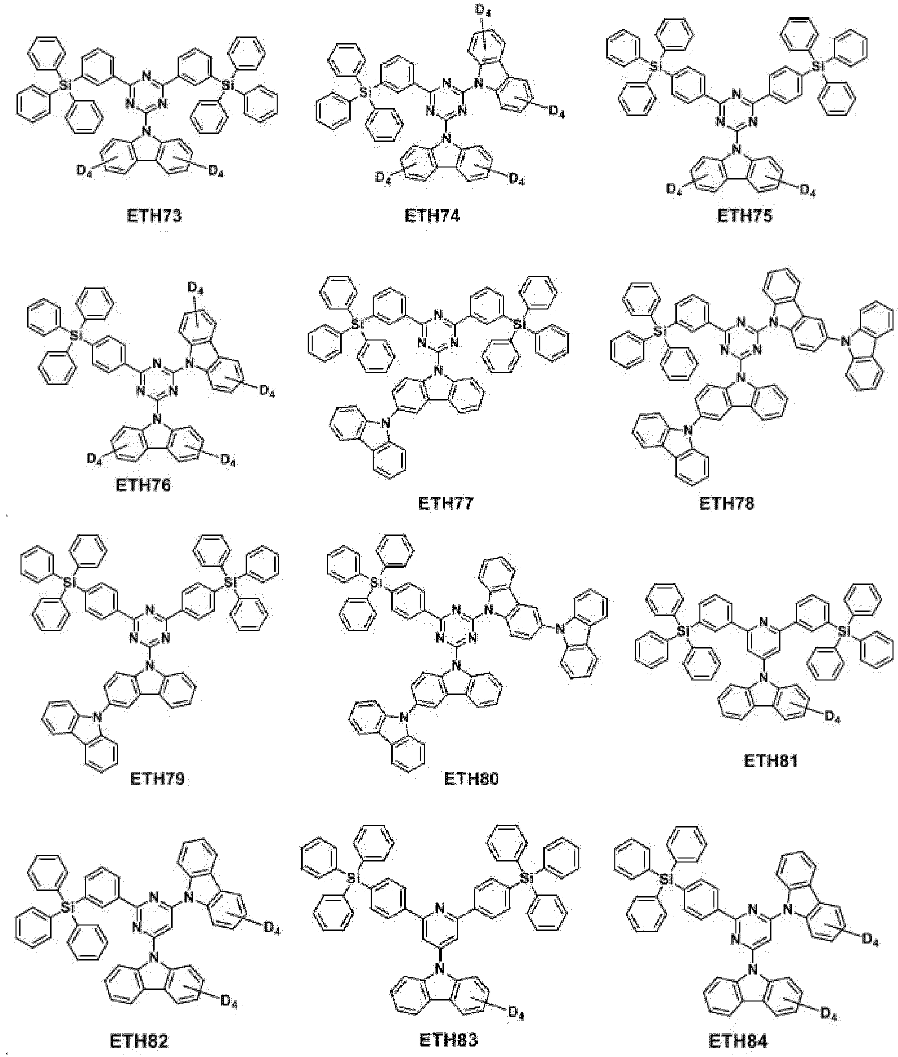

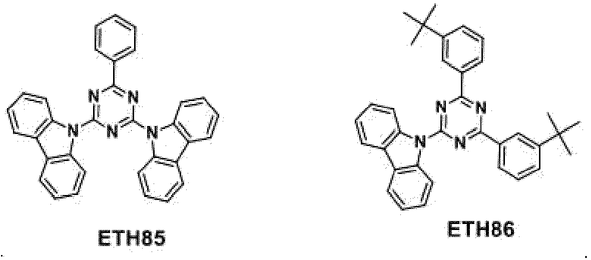

In Compound Group 4, D represents a deuterium atom, and Ph represents an unsubstituted phenyl group.

At least one compound selected from Compound Group 4 may be included in the electron transport region ETR. For example, at least one compound selected from Compound Group 4 may be included in a hole-blocking layer HBL, but embodiments are not limited thereto.

In an embodiment, the light-emitting layer EML may include a first compound. The first compound is the phosphorescent compound, and may have a positive GSP. For example, the light-emitting layer EML may include, as a first compound, an organometallic complex that includes platinum (Pt) as a central metal atom, and including ligands bonded to the central metal atom. In an embodiment, the light-emitting layer EML may include a first compound, which is the phosphorescent compound, represented by Formula 3:

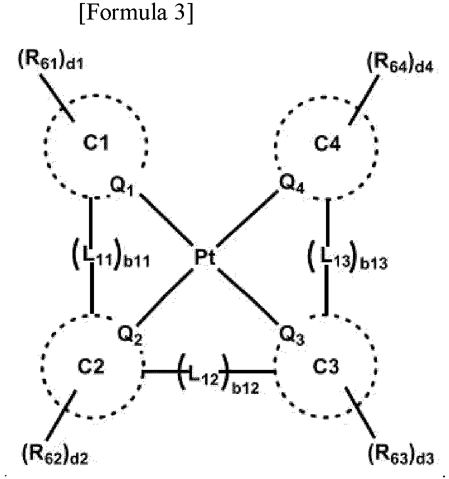

In Formula 3, Q₁ to Q₄ may each independently be C or N. In Formula 3, C1 to C4 may each independently be a substituted or unsubstituted hydrocarbon ring having 5 to 30 ring-forming carbon atoms or a substituted or unsubstituted heterocycle having 2 to 30 ring-forming carbon atoms.

In Formula 3, L₁₁ to L₁₃ may each independently be a direct linkage, ***-O-*, *-S-*,** 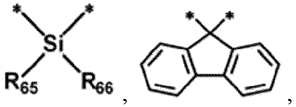 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms. In L₁₁ to L₁₃, **-*** represents a bond to one of C1 to C4.

In Formula 3, b11 to b13 may each independently be 0 or 1. If b11 is 0, C1 and C2 may not be directly linked to each other. If b12 is 0, C2 and C3 may not be directly linked to each other. If b13 is 0, C3 and C4 may not be directly linked to each other.

In Formula 3, R₆₁ to R₆₆ may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, or bonded to an adjacent group to form a ring. For example, R₆₁ to R₆₆ may each independently be a substituted or unsubstituted methyl group or a substituted or unsubstituted t-butyl group.

In Formula 3, d1 to d4 may each independently be an integer from 0 to 4. In Formula 3, if d1 to d4 are each 0, the first compound may not be substituted with R₆₁ to R₆₄, respectively. A case where d1 to d4 are each 4 and four groups of each of R₆₁ to R₆₄ are all hydrogen atoms may be the same as a case where d1 to d4 are each 0. When d1 to d4 are each 2 or more, multiple groups of each of R₆₁ to R₆₄ may all be the same or at least one thereof may be different from the remainder.

In an embodiment, in Formula 3, C1 to C4 may each independently be a substituted or unsubstituted hydrocarbon ring or a substituted or unsubstituted heterocycle that is represented by one of Formula C-1 to Formula C-4:

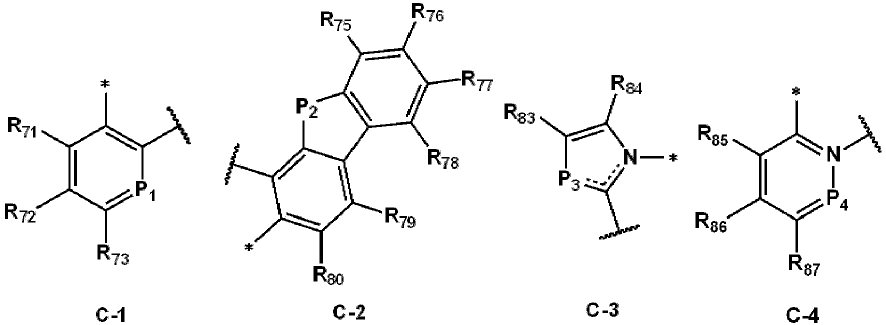

In Formula C-1 to Formula C-4, P₁ may be **C-*** or C(R₇₄); P₂ may be **N-*** or N(R₈₁); P₃ may be **N-*** or N(R₈₂); and P₄ may be **C**-* or C(R₈₈). In Formula C-1 to Formula C-4, R₇₁ to R₈₈ may each independently be a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or bonded to an adjacent group to form a ring.

In Formula C-1 to Formula C-4, 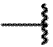 represents a bond to Pt, which is a central metal atom, and **-*** represents a bond to a neighboring cyclic group (C1 to C4) or to a linking moiety (L₁₁ to L₁₃).

In an embodiment, the first compound represented by Formula 3 may be any compound selected from Compound Group 5. In an embodiment, in the light-emitting element ED, the first compound, which is the phosphorescent compound, may include at least one compound selected from Compound Group 5:

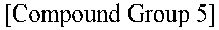

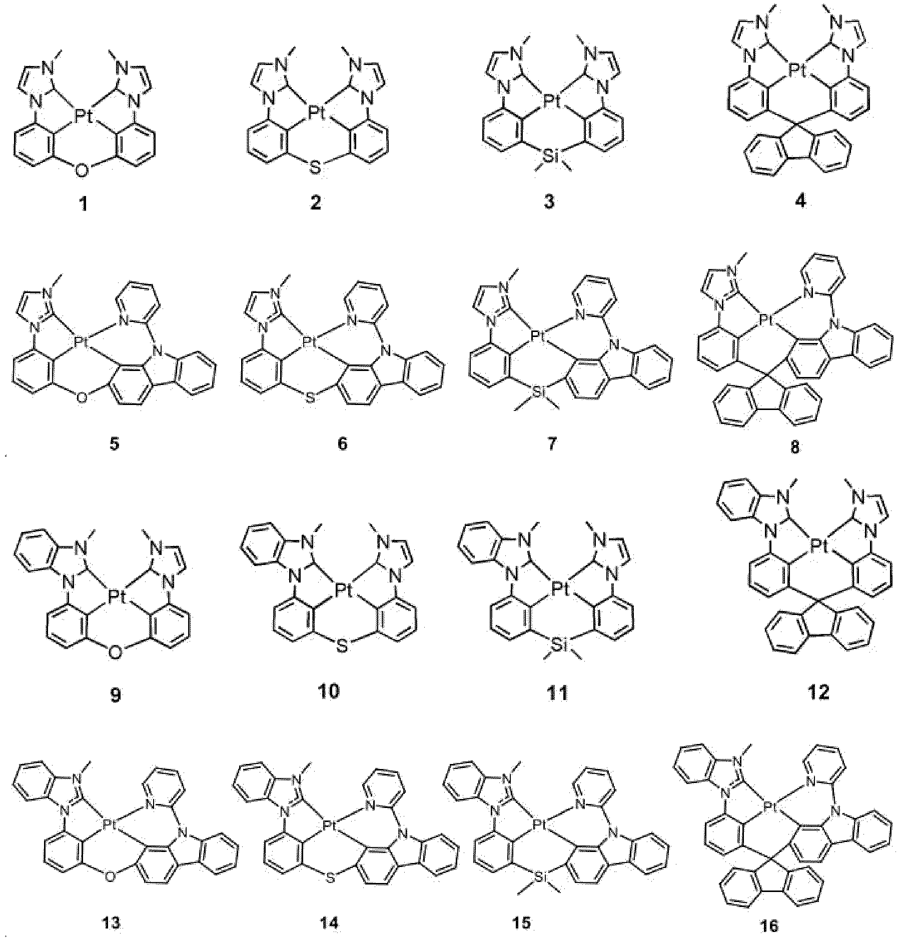

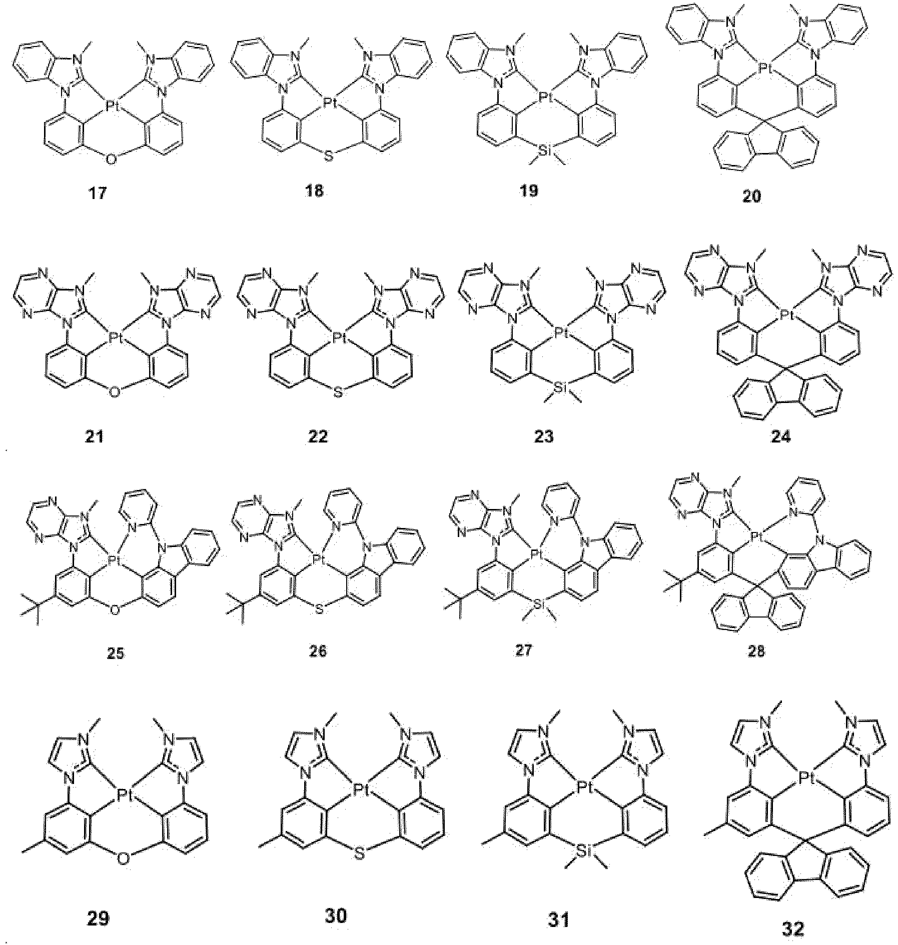

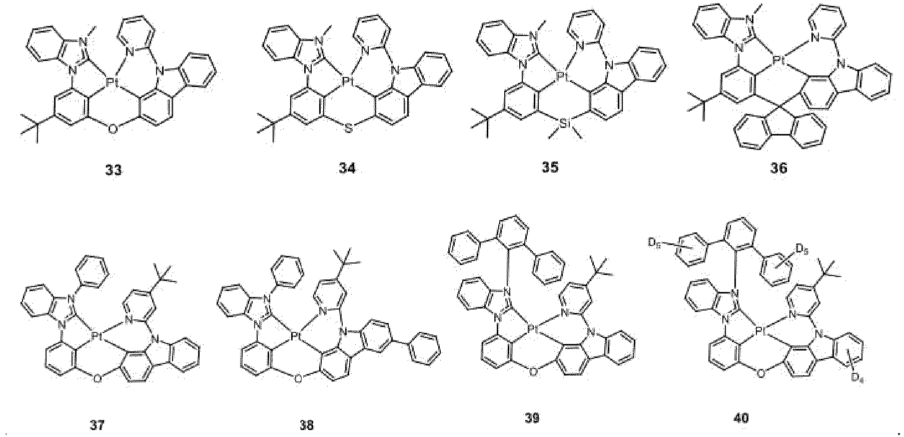

In an embodiment, the light-emitting layer EML may include a second compound. In an embodiment, the light-emitting layer EML may include a second compound, which is the fluorescent compound, represented by Formula TE:

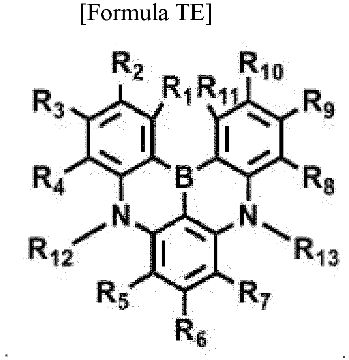

In Formula TE, R₁ to R₁₁ may each independently be a hydrogen atom, a deuterium atom, a substituted or unsubstituted thio group, a substituted or unsubstituted oxy group, a substituted or unsubstituted alkyl group having 1 to 30 carbon atoms, a substituted or unsubstituted aryl group having 6 to 30 ring-forming carbon atoms, or a substituted or unsubstituted heteroaryl group having 2 to 30 ring-forming carbon atoms, or bonded to an adjacent group to form a ring.

In Formula TE, R₁₂ and R₁₃ may each independently be a substituted or unsubstituted aryl group having 6 to 30 ring-forming carbon atoms. For example, R₁₂ and R₁₃ may each independently be a substituted or unsubstituted phenyl group, but embodiments are not limited thereto.

In an embodiment, the second compound represented by Formula TE may be any compound selected from Compound Group 6. In an embodiment, in the light-emitting element ED, the second compound, which is the fluorescent compound, may include at least one compound selected from Compound Group 6:

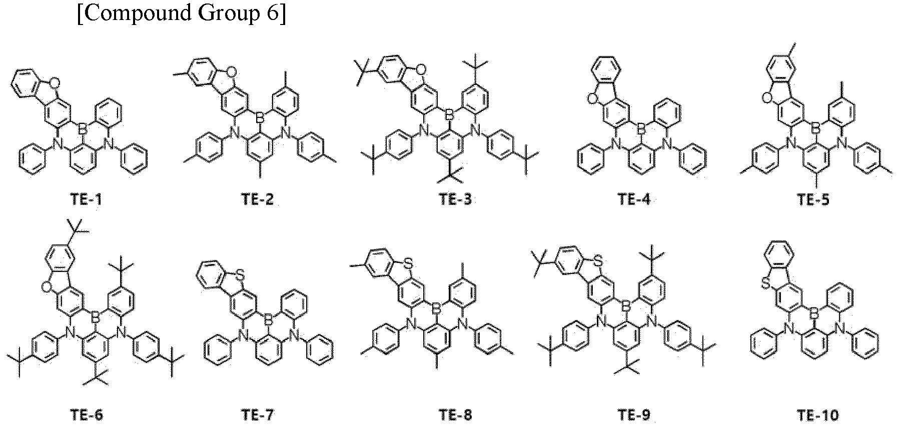

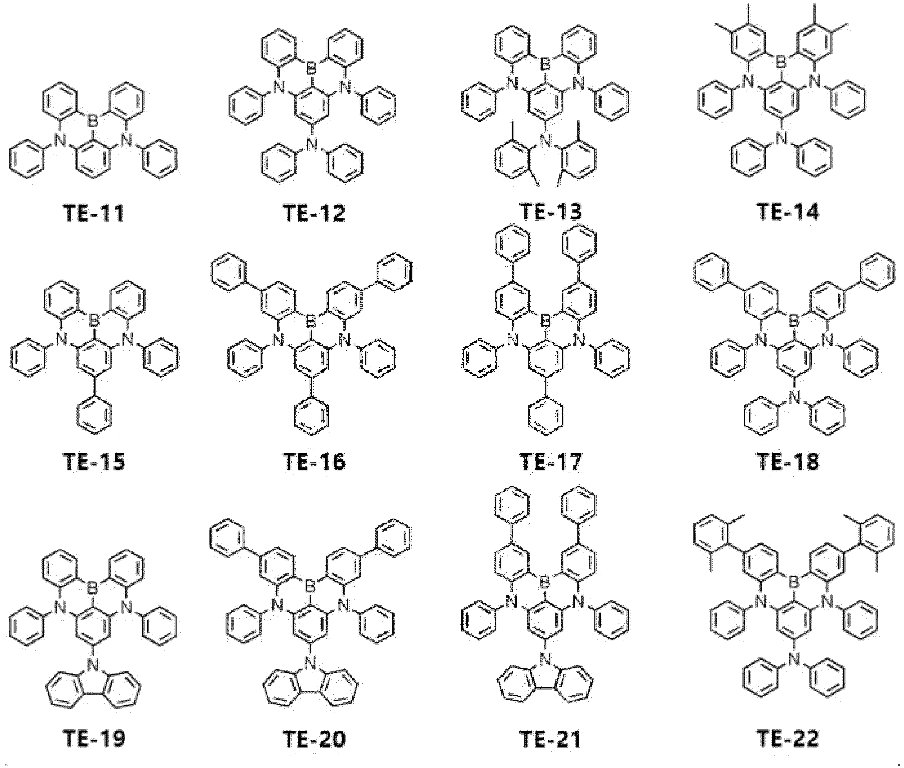

In an embodiment, the light-emitting layer EML in the light-emitting element ED may emit blue color light. For example, the light-emitting layer EML of the light-emitting element ED may emit blue color light having a wavelength region equal to or less than about 490 nm. However, embodiments are not limited thereto, and the light-emitting layer EML may emit green color light or red color light.

The light-emitting element ED according to an embodiment may include multiple light-emitting layers. The light-emitting layers may be stacked between the first electrode and the second electrode so that, for example, the light-emitting element ED including the multiple light-emitting layers may emit white color light. The light-emitting element including multiple light-emitting layers may be a light-emitting element having a tandem structure. When the light-emitting element ED includes multiple light-emitting layers, at least one light-emitting layer EML may include the HT host, the ET host, the first compound, and the second compound.

In the light-emitting element ED, the light-emitting layer EML may include an anthracene derivative, a pyrene derivative, a fluoranthene derivative, a chrysene derivative, a dihydrobenzanthracene derivative, or a triphenylene derivative. For example, the light-emitting layer EML may include an anthracene derivative or a pyrene derivative.

In the light-emitting element ED according to embodiments illustrated in FIGS. 5 to 10, the light-emitting layer EML may further include a host and a dopant, in addition to the HT host, the ET host, the first compound, and the second compound as described above.

In an embodiment, the light-emitting layer EML may include a compound represented by Formula E-1. The compound represented by Formula E-1 may be used as a fluorescent host material.

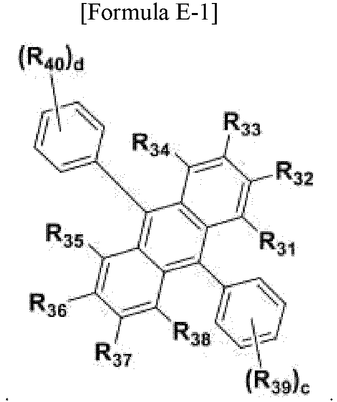

In Formula E-1, R₃₁ to R₄₀ may each independently be a hydrogen atom, a deuterium atom, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, or bonded to an adjacent group to form a ring. For example, R₃₁ to R₄₀ may be bonded to an adjacent group to form a saturated hydrocarbon ring, an unsaturated hydrocarbon ring, a saturated heterocycle, or an unsaturated heterocycle.

In Formula E-1, c and d may each independently be an integer from 0 to 5.

In an embodiment, the compound represented by Formula E-1 may be any compound selected from Compound E1 to Compound E19:

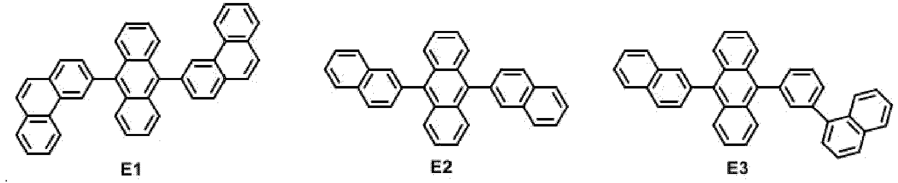

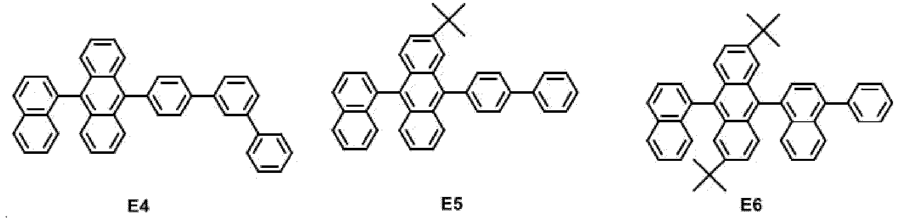

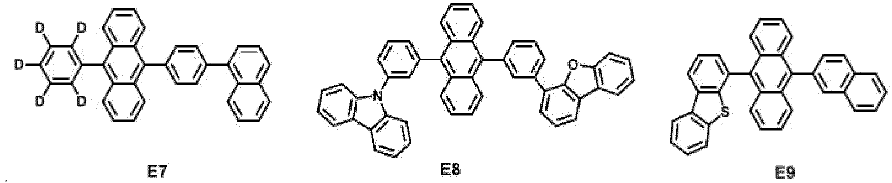

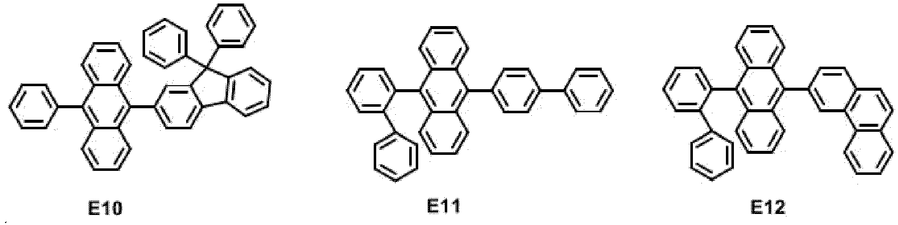

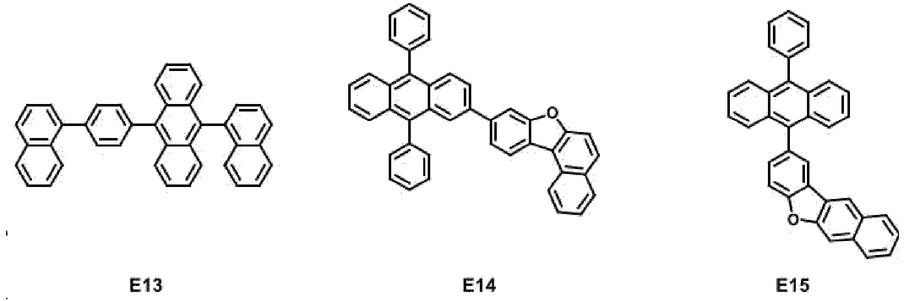

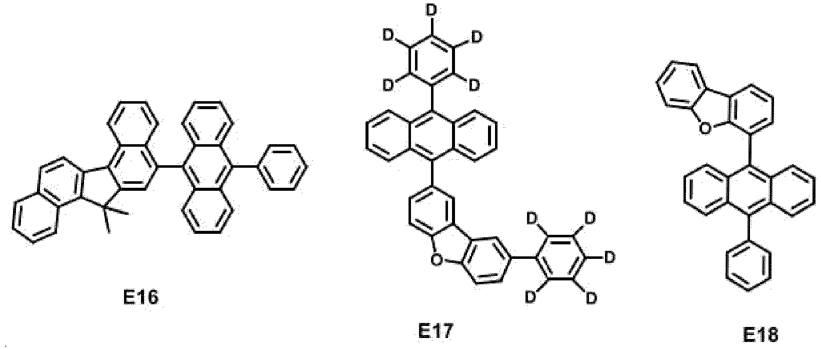

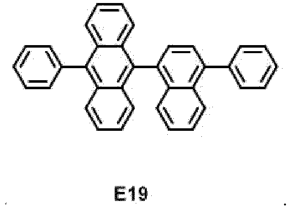

In an embodiment, the light-emitting layer EML may include a compound represented by Formula E-2a or Formula E-2b. The compound represented by Formula E-2a or Formula E-2b may be used as a host material for phosphorescent light-emitting element.

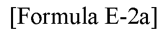

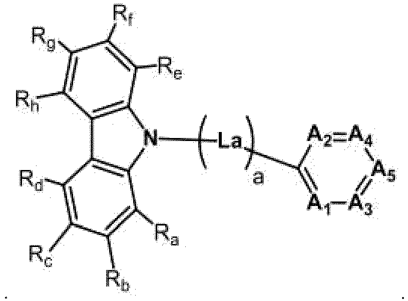

In Formula E-2a, a may be an integer from 0 to 10; and La may be a direct linkage, a substituted or unsubstituted arylene group having 6 to 30 ring-forming carbon atoms, or a substituted or unsubstituted heteroarylene group having 2 to 30 ring-forming carbon atoms. When a is 2 or greater, multiple La groups may be each independently a substituted or unsubstituted arylene group having 6 to 30 ring-forming carbon atoms or a substituted or unsubstituted heteroarylene group having 2 to 30 ring-forming carbon atoms.

In Formula E-2a, A₁ to A₅ may each independently be N or C(Rᵢ). In Formula E-2a, Rₐ to Rᵢ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or bonded to an adjacent group to form a ring. For example, Rₐ to Rᵢ may be bonded to an adjacent group to form a hydrocarbon ring or a heterocycle containing N, O, S, etc., as a ring-forming atom.

In Formula E-2a, two or three of A₁ to A₅ may each be N, and the remainder of A₁ to A₅ may each independently be C(Rᵢ).

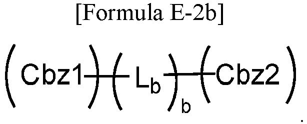

In Formula E-2b, Cbz1 and Cbz2 may each independently be an unsubstituted carbazole group, or a carbazole group substituted with an aryl group having 6 to 30 ring-forming carbon atoms. In Formula E-2b, L_{b} may be a direct linkage, a substituted or unsubstituted arylene group having 6 to 30 ring-forming carbon atoms, or a substituted or unsubstituted heteroarylene group having 2 to 30 ring-forming carbon atoms. In Formula E-2b, b may be an integer from 0 to 10. When b is 2 or more, multiple L_{b} groups may each independently be a substituted or unsubstituted arylene group having 6 to 30 ring-forming carbon atoms or a substituted or unsubstituted heteroarylene group having 2 to 30 ring-forming carbon atoms.

In an embodiment, the compound represented by Formula E-2a or Formula E-2b may be any compound selected from Compound Group E-2. However, the compounds listed in Compound Group E-2 are only examples, and the compound represented by Formula E-2a or Formula E-2b is not limited to Compound Group E-2:

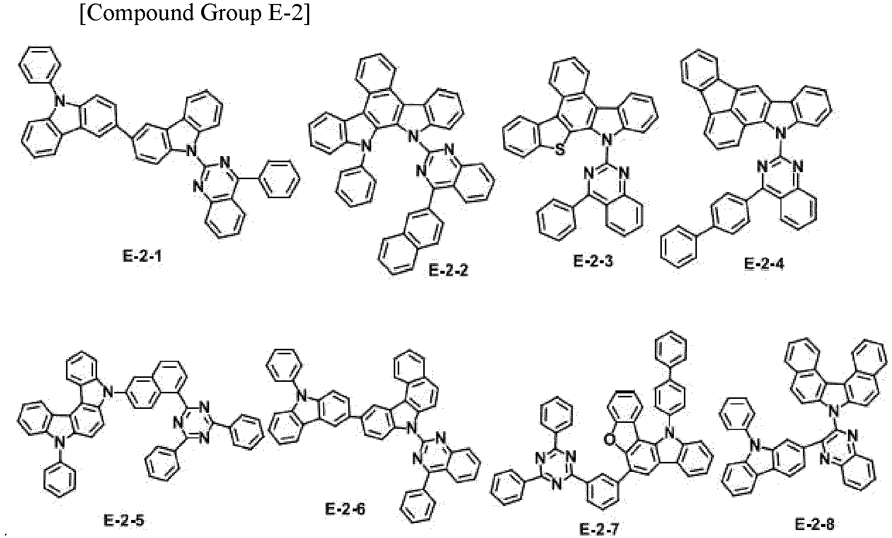

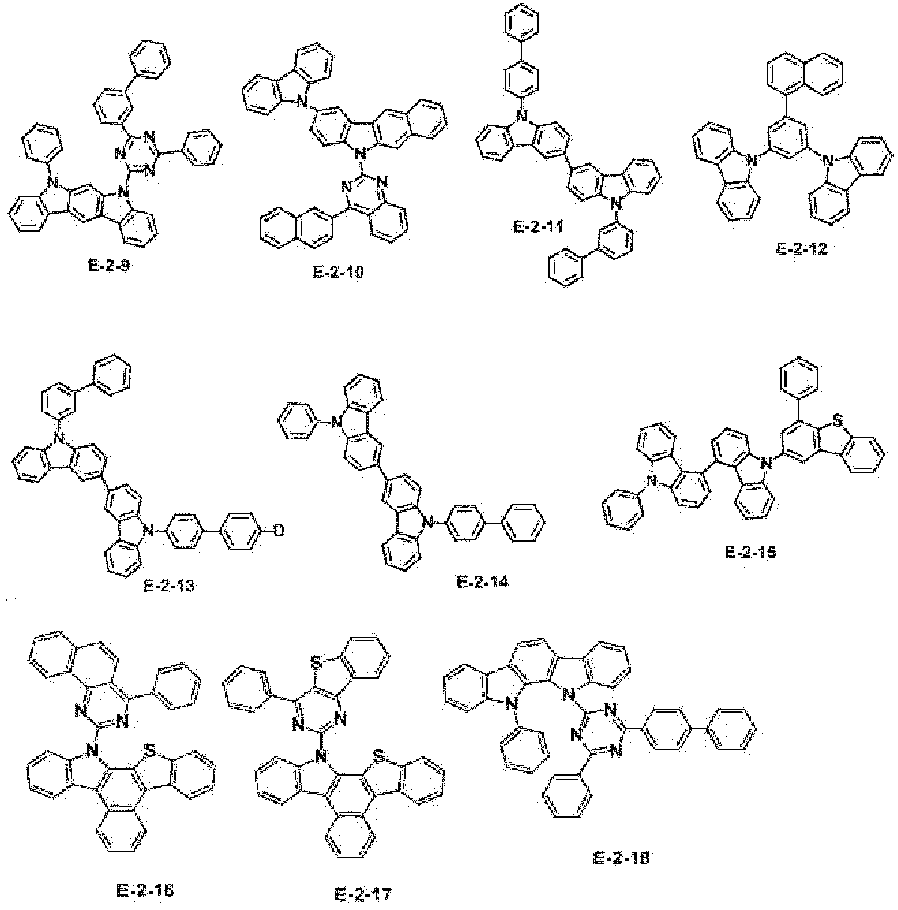

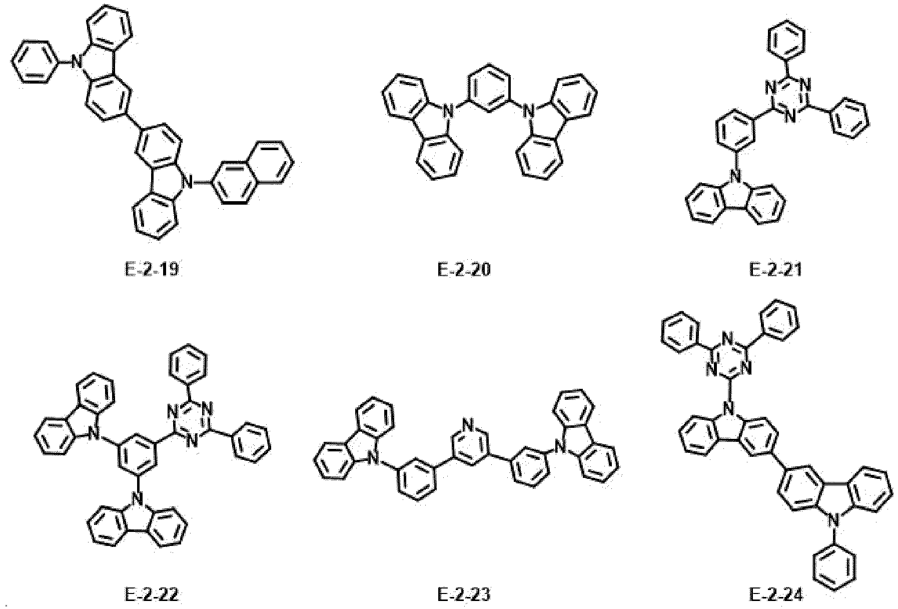

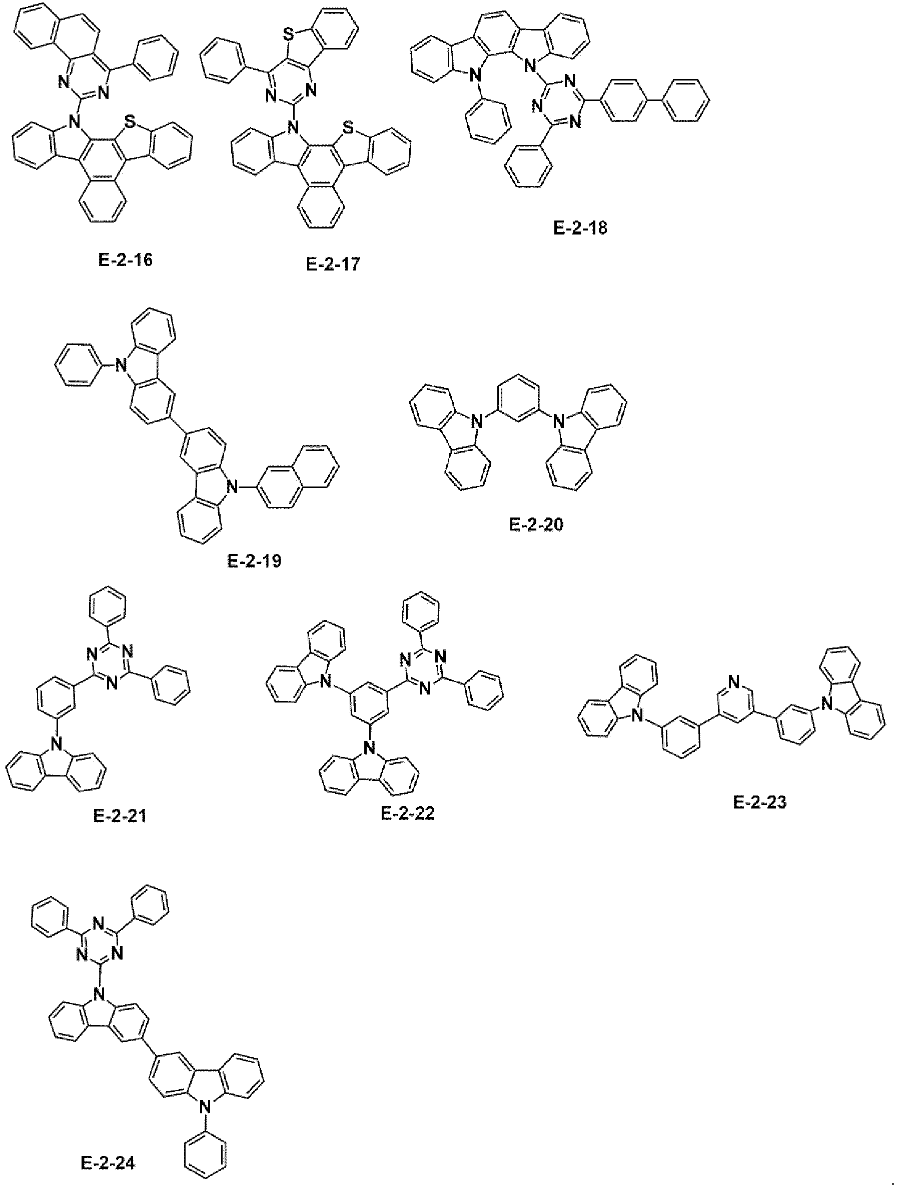

In an embodiment, the light-emitting layer EML may further include a material of the related art as a host material. For example, the light-emitting layer EML may include, as a host material, at least one of bis(4-(9H-carbazol-9-yl)phenyl)diphenylsilane (BCPDS), (4-(1-(4-(diphenylamino)phenyl)cyclohexyl)phenyl)diphenyl-phosphine oxide (POPCPA), bis[2-(diphenylphosphino)phenyl]ether oxide (DPEPO), 4,4'-bis(N-carbazolyl)-1,1'-biphenyl (CBP), 1,3-bis(carbazol-9-yl)benzene (mCP), 2,8-bis(diphenylphosphoryl)dibenzo[b,d]furan (PPF), 4,4',4"-tris(carbazol-9-yl)-triphenylamine (TCTA), and 1,3,5-tris(1-phenyl-1H-benzo[d]imidazole-2-yl)benzene (TPBi). However, embodiments are not limited thereto. For example, tris(8-hydroxyquinolino)aluminum (Alq₃), 9,10-di(naphthalene-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiO₃), octaphenylcyclotetrasiloxane (DPSiO₄), etc. may be used as a host material.

In an embodiment, the light-emitting layer EML may include a compound represented by Formula M-a. The compound represented by Formula M-a may be used as a phosphorescent dopant material.

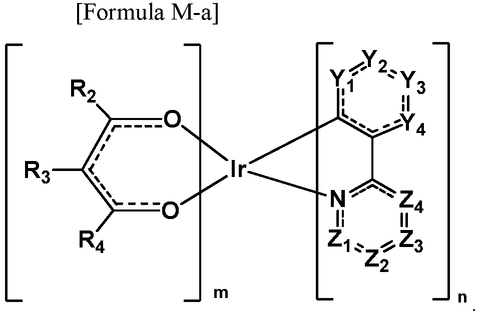

In Formula M-a, Y₁ to Y₄ and Z₁ to Z₄ may each independently be C(R₁) or N; and R₁ to R₄ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or bonded to an adjacent group to form a ring. In Formula M-a, m may be 0 or 1, and n may be 2 or 3. In Formula M-a, when m is 0, n may be 3, and when m is 1, n may be 2.

In an embodiment, the compound represented by Formula M-a may be any compound selected from Compound M-a1 to Compound M-a25. However, Compounds M-a1 to M-a25 are only examples, and the compound represented by Formula M-a is not limited to Compounds M-a1 to M-a25:

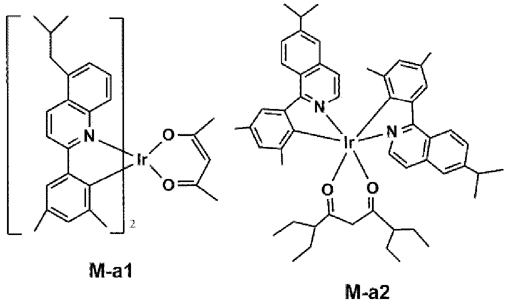

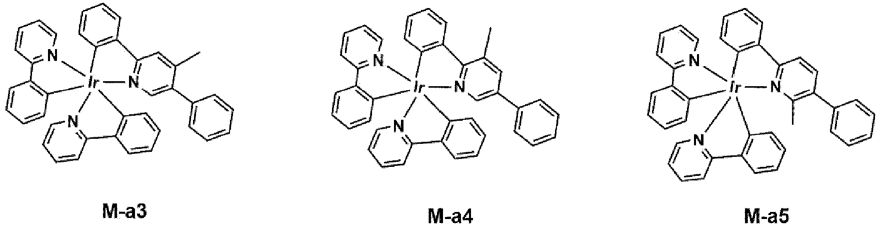

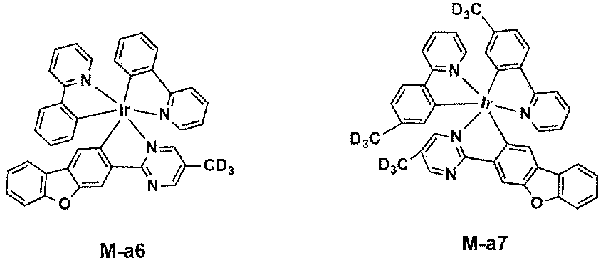

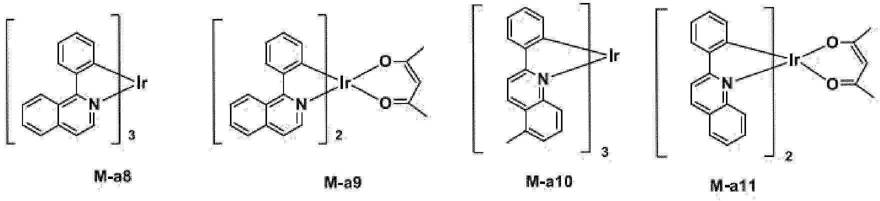

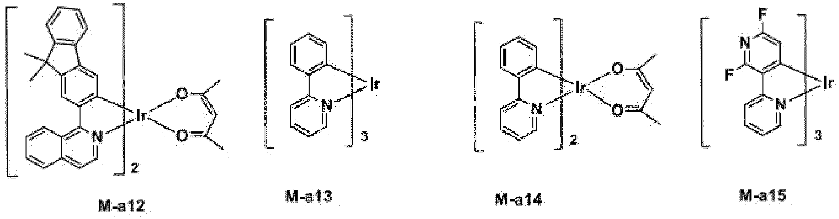

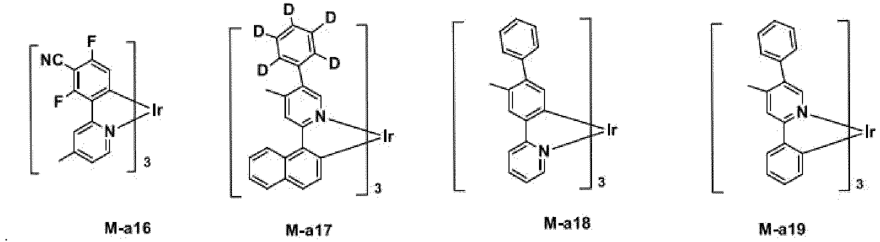

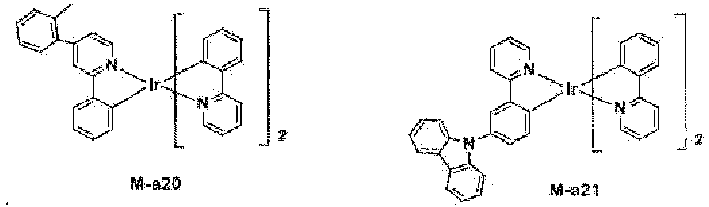

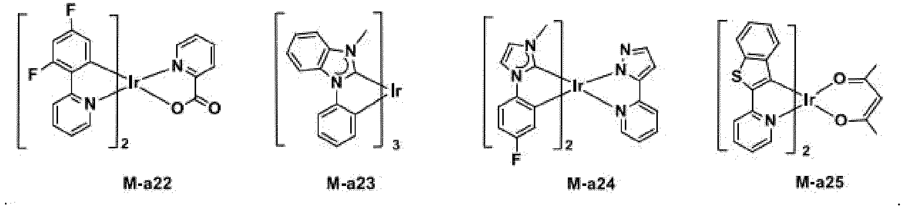

In an embodiment, the light-emitting layer EML may include a compound represented by one of Formula F-a to Formula F-c. The compound represented by one of Formula F-a to Formula F-c may be used as a fluorescence dopant material.

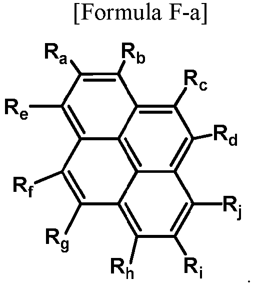

In Formula F-a, two of Rₐ to Rⱼ may each independently be substituted with a group represented by *-NAr₁Ar₂. The remainder of Rₐ to Rⱼ that are not substituted with the group represented by *-NAr₁Ar₂ may each independently be a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In the group represented by *-NAr₁Ar₂, Ar₁ and Ar₂ may each independently be a substituted or unsubstituted aryl group having 6 to 30 ring-forming carbon atoms or a substituted or unsubstituted heteroaryl group having 2 to 30 ring-forming carbon atoms. For example, at least one of Ar₁ and Ar₂ may each independently be a heteroaryl group containing O or S as a ring-forming atom.

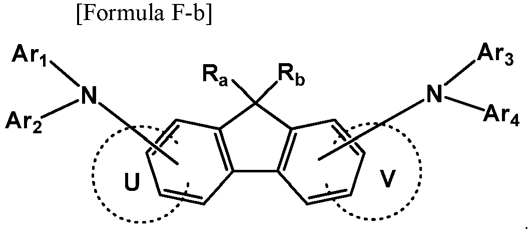

In Formula F-b, Rₐ and R_{b} may each independently be a hydrogen atom, a deuterium atom, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or bonded to an adjacent group to form a ring. In Formula F-b, Ar₁ to Ar₄ may each independently be a substituted or unsubstituted aryl group having 6 to 30 ring-forming carbon atoms or a substituted or unsubstituted heteroaryl group having 2 to 30 ring-forming carbon atoms. For example, at least one of Ar₁ to Ar₄ may each independently be a heteroaryl group containing O or S as a ring-forming atom.

In Formula F-b, U and V may each independently be a substituted or unsubstituted hydrocarbon ring having 5 to 30 ring-forming carbon atoms or a substituted or unsubstituted heterocycle having 2 to 30 ring-forming carbon atoms.

In Formula F-b, the number of rings represented by U and V may each independently be 0 or 1. When the number of U or V is 1, a fused ring may be present at a portion respectively indicated by U or V, and when the number of U or V is 0, a fused ring may not be present at the portion respectively indicated by U or V. When the number of U is 0 and the number of V is 1, or when the number of U is 1 and the number of V is 0, a fused ring having a fluorene core of Formula F-b may be a cyclic compound having four rings. When the number of U and V is each 0, a fused ring having a fluorene core of Formula F-b may be a cyclic compound having three rings. When the number of U and V is each 1, a fused ring having a fluorene core of Formula F-b may be a cyclic compound having five rings.

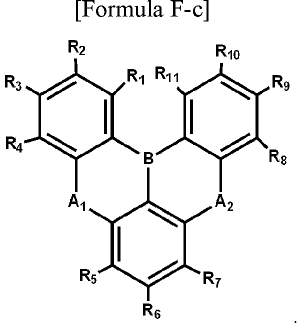

In Formula F-c, A₁ and A₂ may each independently be O, S, Se, or N(Rₘ); and Rₘ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. In Formula F-c, R₁ to R₁₁ may each independently be a hydrogen atom, a deuterium atom, a halogen atom, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or bonded to an adjacent group to form a ring.

In Formula F-c, A₁ and A₂ may each independently be bonded to a substituent of an adjacent ring to form a fused ring. For example, when A₁ and A₂ are each independently N(Rₘ), A₁ may be bonded to R₄ or R₅ to form a ring, and/or A₂ may be bonded to R₇ or R₈ to form a ring.

In an embodiment, the light-emitting layer EML may further include, as a dopant material of the related art, a styryl derivative (e.g., 1,4-bis[2-(3-N-ethylcarbazolyl)vinyl]benzene (BCzVB), 4-(di-p-tolylamino)-4'-[(di-p-tolylamino)styryl]stilbene (DPAVB), and N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi), perylene or a derivative thereof (e.g., 2,5,8,11-tetra-t-butylperylene (TBP)), pyrene or a derivative thereof (e.g., 1,1'-dipyrene, 1,4-dipyrenylbenzene, 1,4-bis(N,N-diphenylamino)pyrene), etc.

The light-emitting layer EML may further include a phosphorescence dopant material of the related art. For example, a metal complex containing iridium (Ir), platinum (Pt), osmium (Os), gold (Au), titanium (Ti), zirconium (Zr), hafnium (Hf), europium (Eu), terbium (Tb), or thulium (Tm) may be used as a phosphorescent dopant. For example, iridium(III) bis(4,6-difluorophenylpyridinato-N,C2) (FIrpic), bis(2,4-difluorophenylpyridinato)-tetrakis(1-pyrazolyl)borate iridium(III) (FIr6), or platinum octaethyl porphyrin (PtOEP) may be used as a phosphorescent dopant. However, embodiments are not limited thereto.

In an embodiment, the light-emitting layer EML may include quantum dots. In the specification, a quantum dot may be a crystal of a semiconductor compound. In an embodiment, a quantum dot may emit light having various wavelengths according to a size thereof. In an embodiment, a quantum dot may emit light having various wavelengths by adjusting an elemental ratio in a quantum dot compound.

A diameter of the quantum dot may be, for example, in a range of about 1 nm to about 10 nm. The quantum dot may be synthesized by a wet chemical process, a metal organic chemical vapor deposition process, a molecular beam epitaxy process, a process similar thereto, or the like.

The wet chemical process is a method in which an organic solvent and a precursor material are mixed, and a quantum dot particle crystal is grown. While growing the crystal, the organic solvent may naturally serve as a dispersant coordinated to a surface of the quantum dot crystal, and may control growth of the crystal. Accordingly, the wet chemical process may be more readily performed than a vapor deposition method such as a metal organic chemical vapor deposition (MOCVD) or a molecular beam epitaxy (MBE), and may control the growth of a quantum dot particle through a low-cost process.

The quantum dot may include a Group II-VI compound, a Group III-V compound, a Group III-VI compound, a Group I-III-VI compound, a Group IV-VI compound, a Group IV element, a Group IV compound, or a combination thereof.

Examples of a Group II-VI compound may include: a binary compound such as CdSe, CdTe, CdS, ZnS, ZnSe, ZnTe, ZnO, HgS, HgSe, HgTe, MgSe, MgS, and a mixture thereof; a ternary compound such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; a quaternary compound such as HgZnTeS, CdZnSeS, CdZnSeTe, CdZnSTe, CdHgSeS, CdHgSeTe, CdHgSTe, HgZnSeS, HgZnSeTe, and a mixture thereof; and any combination thereof.

Examples of a Group III-VI compound may include: a binary compound such as In₂S₃ or In₂Se₃; a ternary compound such as InGaS₃ or InGaSe₃; and any combination thereof.

Examples of a Group I-III-VI compound may include: a ternary compound such as AgInS, AgInS₂, CuInS, CuInS₂, AgGaS₂, CuGaS₂ CuGaO₂, AgGaO₂, AgAlO₂, and a mixture thereof; a quaternary compound such as AgInGaS₂ or CuInGaS₂; and any combination thereof.

Examples of a Group III-V compound may include: a binary compound such as GaN, GaP, GaAs, GaSb, AlN, AlP, AlAs, AlSb, InN, InP, InAs, InSb, and a mixture thereof; a ternary compound such as GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a mixture thereof; a quaternary compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof; and any combination thereof. In an embodiment, a Group III-V compound may further include a Group II metal. Examples of a Group III-II-V compound may include InZnP, etc.

Examples of a Group IV-VI compound may include: a binary compound such as SnS, SnSe, SnTe, PbS, PbSe, PbTe, and a mixture thereof; a ternary compound such as SnSeS, SnSeTe, SnSTe, PbSeS, PbSeTe, PbSTe, SnPbS, SnPbSe, SnPbTe, and a mixture thereof; a quaternary compound such as SnPbSSe, SnPbSeTe, SnPbSTe, and a mixture thereof; and any combination thereof. Examples of a Group IV element may include Si, Ge, and a mixture thereof. Examples of a Group IV compound may include a binary compound such as SiC, SiGe, and a mixture thereof.

Each element included in a compound, such as a binary compound, a ternary compound, or a quaternary compound, may be present in a particle at a uniform concentration distribution or at a non-uniform concentration distribution. For example, a formula may indicate the elements that are included in a compound, but an elemental ratio of the compound may vary. For example, AgInGaS₂ may indicate AgInₓGa₁₋ₓS₂ (wherein x is a real number between 0 and 1).

In an embodiment, a quantum dot may have a core/shell structure in which a quantum dot surrounds another quantum dot. A quantum dot having a core/shell structure, may have a concentration gradient in which the concentration of an element that is present in the shell decreases towards the center.

In embodiments, a quantum dot may have the above-described core/shell structure that includes a core containing nanocrystals and a shell surrounding the core. The shell of a quantum dot may serve as a protection layer that prevents chemical deformation of the core to maintain semiconductor properties, and/or may serve as a charging layer that imparts electrophoretic properties to the quantum dot. The shell may be single-layered or multilayered. Examples of a shell of a quantum dot may include a metal oxide, a non-metal oxide, a semiconductor compound, and a combination thereof.

Examples of a metal oxide or a non-metal oxide may include a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO, or a ternary compound such as MgAl₂O₄, CoFe₂O₄, NiFe₂O₄, or CoMn₂O₄, but embodiments are not limited thereto.

Examples of a semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, etc., but embodiments are not limited thereto.

A quantum dot may have a full width at half maximum (FWHM) of an emission wavelength spectrum equal to or less than about 45 nm. For example, the quantum dot may have an FWHM of an emission wavelength spectrum equal to or less than about 40 nm. For example, the quantum dot may have an FWHM of an emission wavelength spectrum equal to or less than about 30 nm. Color purity or color reproducibility may be improved in any of the above ranges. Light emitted through a quantum dot may be emitted in all directions, so that a wide viewing angle may be improved.

The form of a quantum dot is not particularly limited, and may be any form used in the related art. For example, a quantum dot may have a spherical shape, a pyramidal shape, a multi-arm shape, or a cubic shape, or a quantum dot may be in the form of a nanoparticle, a nanotube, a nanowire, a nanofiber, a nanoplate particles, etc.

As a size of a quantum dot is adjusted or an elemental ratio of a quantum dot compound is adjusted, an energy band gap may be controlled accordingly, so that light in various wavelength ranges may be obtained from a quantum dot light-emitting layer. Therefore, by utilizing a quantum dot as described above (using different sizes of quantum dots or having different elemental ratios in a quantum dot compound), a light-emitting element that emits light in various wavelengths may be implemented. For example, a size of a quantum dot may be adjusted or an elemental ratio of a quantum dot compound may be adjusted to emit red light, green light, and/or blue light. In an embodiment, quantum dots may be configured to emit white light by combining various colors of light.

In the light-emitting elements ED according to embodiments as shown in each FIGS. 5 to 10, the electron transport region ETR may be provided on the light-emitting layer EML. The electron transport region ETR may include at least one of a hole blocking layer HBL, an electron transport layer ETL, and an electron injection layer EIL, but embodiments are not limited thereto.

The electron transport region ETR may have a structure consisting of a layer consisting of a single material, a structure consisting of a layer including different materials, or a structure including multiple layers including different materials.

For example, the electron transport region ETR may have a single-layered structure of an electron injection layer EIL or an electron transport layer ETL, or may have a single-layered structure formed of an electron injection material and an electron transport material. In embodiment, the electron transport region ETR may have a single-layered structure formed of different materials, or may have a structure in which an electron transport layer ETL/electron injection layer EIL, a hole blocking layer HBL/electron transport layer ETL/electron injection layer EIL are stacked in its respectively stated order from a light-emitting layer EML, but embodiments are not limited thereto. The electron transport region ETR may have a thickness, for example, in a range of about 1,000 Å to about 1,500 Å.

The electron transport region ETR may be formed using various methods such as a vacuum deposition method, a spin coating method, a cast method, a Langmuir-Blodgett (LB) method, an inkjet printing method, a laser printing method, and a laser induced thermal imaging (LITI) method.

In the light-emitting element ED according to an embodiment, the electron transport region ETR may include a compound represented by Formula ET-2:

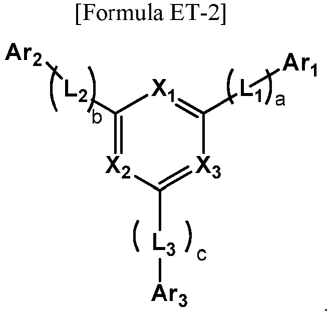

In Formula ET-2, at least one of X₁ to X₃ may each be N; and the remainder of X₁ to X₃ may each independently be C(Rₐ). In Formula ET-2, Rₐ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. In Formula ET-2, Ar₁ to Ar₃ may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-2, a to c may each independently be an integer from 0 to 10. In Formula ET-2, L₁ to L₃ may each independently be a direct linkage, a substituted or unsubstituted arylene group having 6 to 30 ring-forming carbon atoms, or a substituted or unsubstituted heteroarylene group having 2 to 30 ring-forming carbon atoms. When a to c are each 2 or more, multiple groups of each of L₁ to L₃ may each independently be a substituted or unsubstituted arylene group having 6 to 30 ring-forming carbon atoms or a substituted or unsubstituted heteroarylene group having 2 to 30 ring-forming carbon atoms.

The electron transport region ETR may include an anthracene-based compound. However, embodiments are not limited thereto, and the electron transport region ETR may include, for example, tris(8-hydroxyquinolinato)aluminum (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminum (BAlq), beryllium bis(benzoquinolin-10-olate) (Bebq₂), 9,10-di(naphthalene-2-yl)anthracene (ADN), 1,3-bis[3,5-di(pyridin-3-yl)phenyl]benzene (BmPyPhB), or a mixture thereof.

In an embodiment, the electron transport region ETR may include at least one compound selected from Compound ET1 to Compound ET36:

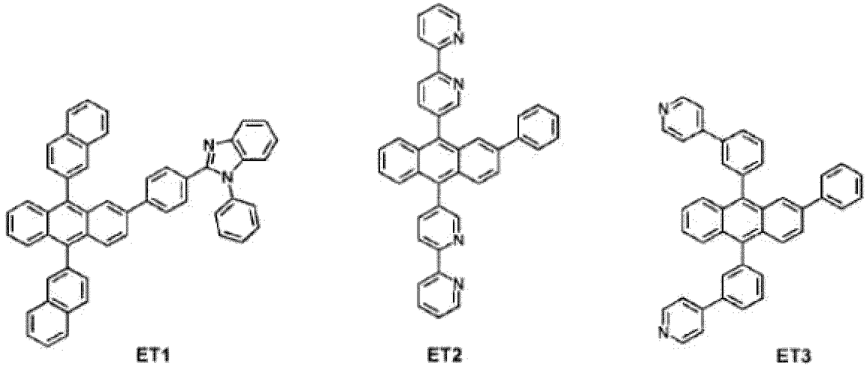

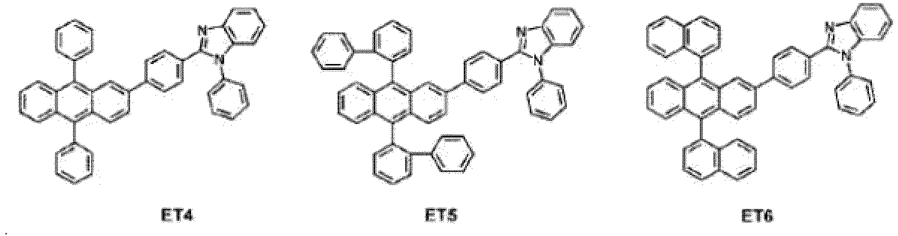

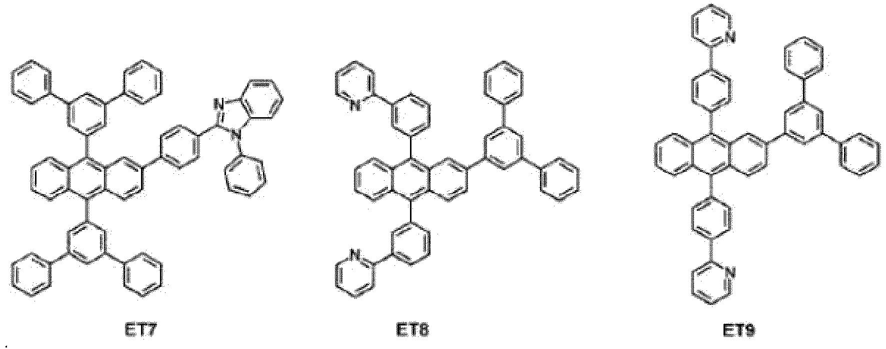

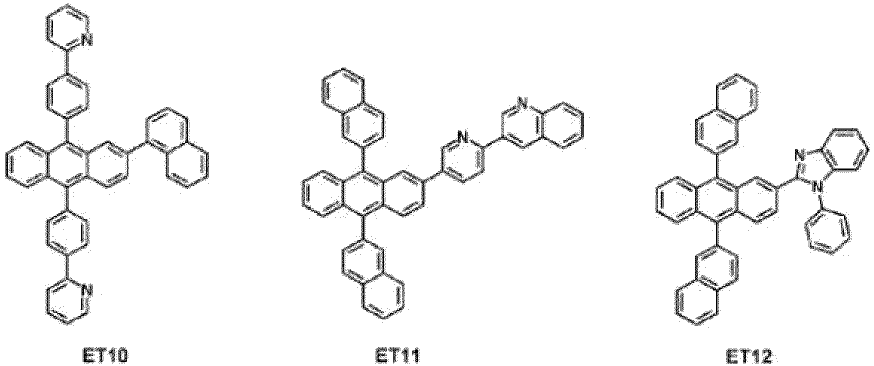

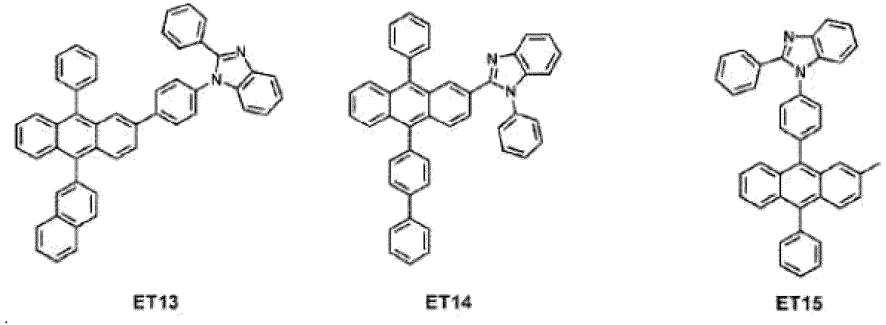

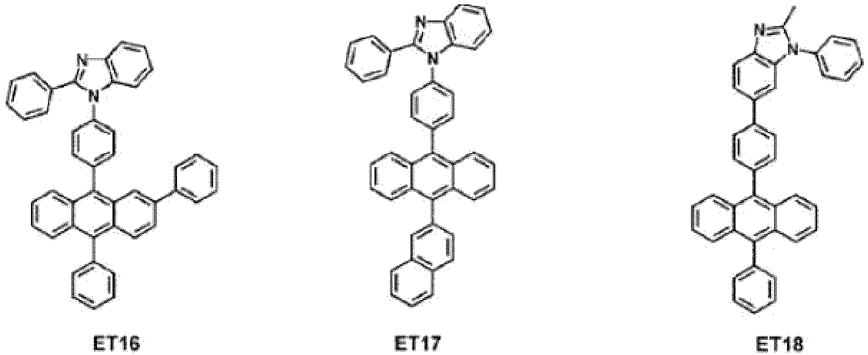

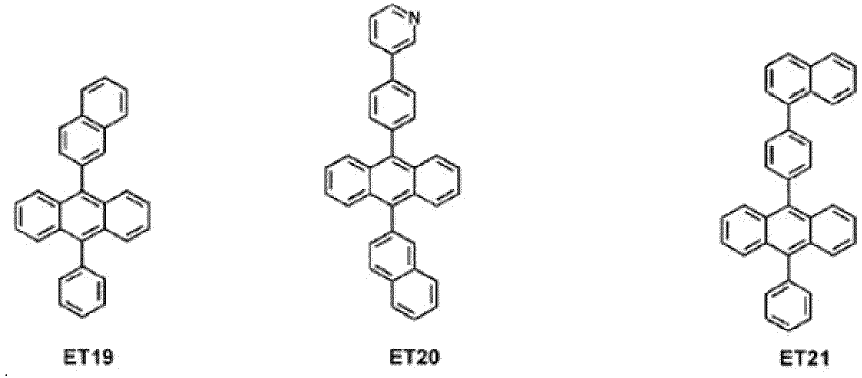

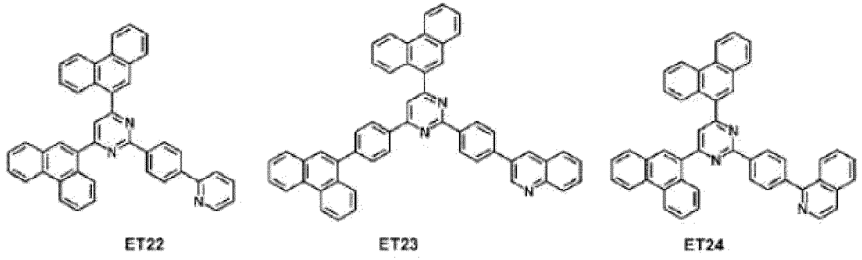

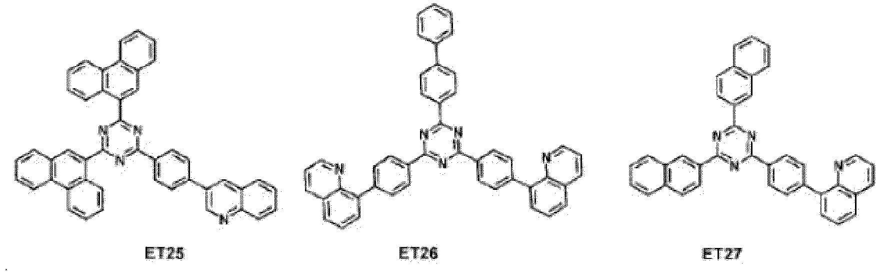

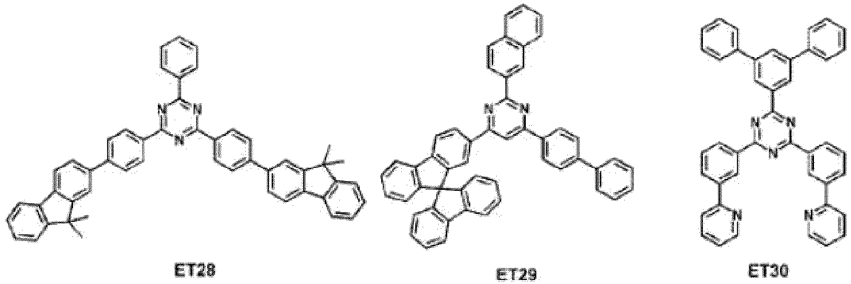

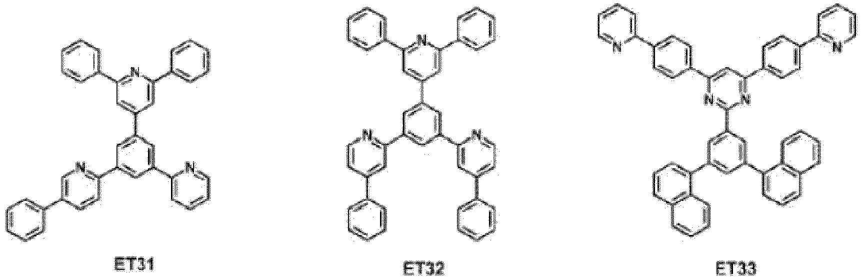

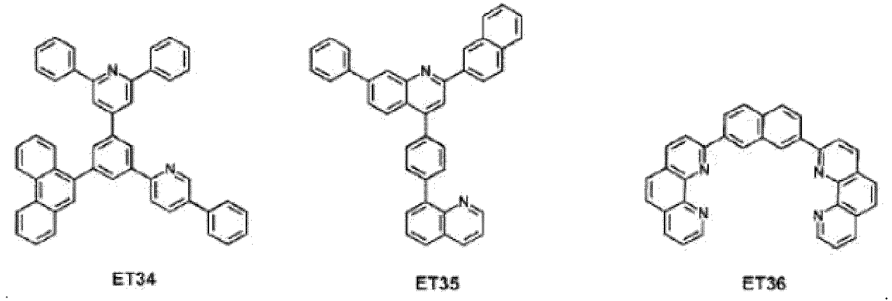

In an embodiment, the electron transport region ETR may include a metal halide such as LiF, NaCl, CsF, RbCl, RbI, CuI, and KI; a lanthanide metal such as Yb; or a co-deposited material of a metal halide and a lanthanide metal. For example, the electron transport region ETR may include KI:Yb, RbI:Yb, LiF:Yb, etc., as a co-deposited material. The electron transport region ETR may include a metal oxide such as Li₂O or BaO, or 8-hydroxyl-lithium quinolate (Liq), etc., but embodiments are not limited thereto. In an embodiment, the electron transport region ETR may include a mixture material of an electron transport material and an insulating organometallic salt. The organometallic salt may be a material having an energy band gap equal to or greater than about 4 eV. For example, the organometallic salt may include a metal acetate, a metal benzoate, a metal acetoacetate, a metal acetylacetonate, or a metal stearate.

The electron transport region ETR may further include at least one of 2,9-dimethyl-4,7-diphenyl-1,10-phenanthroline (BCP), diphenyl(4-(triphenylsilyl)phenyl)phosphine oxide (TSPO1), and 4,7-diphenyl-1,10-phenanthroline (Bphen), in addition to the above-described materials, but embodiments are not limited thereto.

The electron transport region ETR may include the above-described compounds of the electron transport region in at least one of an electron injection layer EIL, an electron transport layer ETL, and a hole blocking layer HBL.

In an embodiment, the electron transport region ETR may include a compound having a positive giant surface potential. The electron transport region ETR may include a compound having a positive giant surface potential in at least one of an electron injection layer EIL, an electron transport layer ETL, and a hole-blocking layer HBL.

When a compound having a positive giant surface potential is included in an electron transport region ETR having a multi-layered structure, the compound having the positive giant surface potential may be included in a layer that is adjacent to the light-emitting layer EML. For example, the compound having the positive giant surface potential may be included in the hole-blocking layer HBL, but embodiments are not limited thereto.

The compound having the positive giant surface potential included in the electron transport region ETR may be represented by Formula 4 as described above, and may be any compound selected from Compound Group 4. The compound having the positive giant surface potential included in the electron transport region ETR may be the same as or different from the electron-transporting host compound included in the light-emitting layer EML.

When the electron transport region ETR includes an electron transport layer ETL, the electron transport layer ETL may have a thickness in a range of about 100 Å to about 1,000 Å. For example, the electron transport layer ETL may have a thickness in a range of about 150 Å to about 500 Å. If the thickness of the electron transport layer ETL satisfies any of the aforementioned ranges, satisfactory electron transport characteristics may be obtained without a substantial increase in driving voltage. When the electron transport region ETR includes an electron injection layer EIL, the electron injection layer EIL may have a thickness in a range of about 1 Å to about 100 Å. For example, the electron injection layer EIL may have a thickness in a range of about 3 Å to about 90 Å. If the thickness of the electron injection layer EIL satisfies any of the above-described ranges, satisfactory electron injection characteristics may be obtained without a substantial increase in driving voltage.

The second electrode EL2 may be provided on the electron transport region ETR. The second electrode EL2 may be a common electrode. The second electrode EL2 may be a cathode or an anode, but embodiments are not limited thereto. For example, when the first electrode EL1 is an anode, the second electrode EL2 may be a cathode, and when the first electrode EL1 is a cathode, the second electrode EL2 may be an anode.

The second electrode EL2 may be a transmissive electrode, a transflective electrode, or a reflective electrode. When the second electrode EL2 is a transmissive electrode, the second electrode EL2 may include a transparent metal oxide, for example, indium tin oxide (ITO), indium zinc oxide (IZO), zinc oxide (ZnO), indium tin zinc oxide (ITZO), etc.

When the second electrode EL2 is a transflective electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, a compound thereof, or a mixture thereof (e. g., AgMg, AgYb, or MgYb). In an embodiment, the second electrode EL2 may have a multilayered structure including a reflective film or a transflective film formed of the above-described materials, and a transparent conductive film formed of ITO, IZO, ZnO, ITZO, etc. For example, the second electrode EL2 may include the above-described metal materials, combinations of at least two of the above-described metal materials, oxides of the above-described metal materials, or the like.

Although not shown in the drawings, in an embodiment, the second electrode EL2 may be electrically connected to an auxiliary electrode. If the second electrode EL2 is electrically connected to an auxiliary electrode, resistance of the second electrode EL2 may decrease.

In an embodiment, the light-emitting element ED may further include a capping layer CPL disposed on the second electrode EL2. The capping layer CPL may have a multilayered structure or a single-layered structure.

In an embodiment, the capping layer CPL may include an organic layer or an inorganic layer. For example, when the capping layer CPL contains an inorganic material, the inorganic material may include an alkaline metal compound (e.g., LiF), an alkaline earth metal compound (e.g., MgF₂), SiON, SiNₓ, SiO_{y}, etc.

For example, when the capping layer CPL includes an organic material, the organic material may include α-NPD, NPB, TPD, m-MTDATA, Alq3, CuPc, N4,N4,N4',N4'-tetra(biphenyl-4-yl)biphenyl-4,4'-diamine (TPD15), 4,4',4"-tris(carbazol-9-yl)triphenylamine (TCTA), etc., or may include an epoxy resin, or an acrylate resin such as methacrylate. However, embodiments are not limited thereto, and the capping layer CPL may include at least one of Compounds P1 to P5:

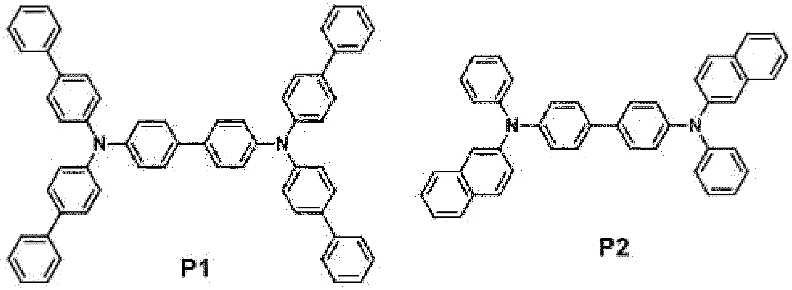

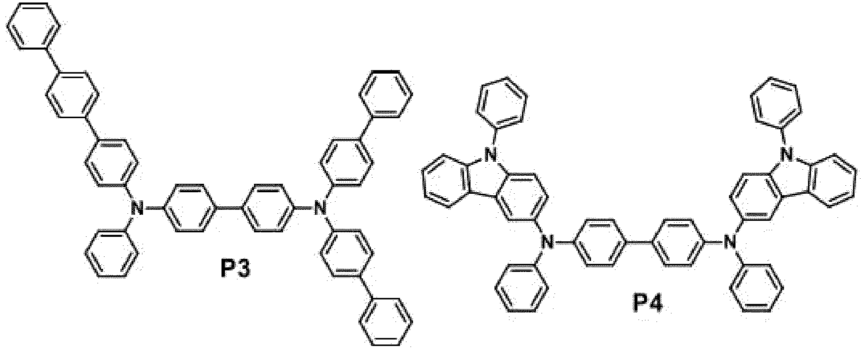

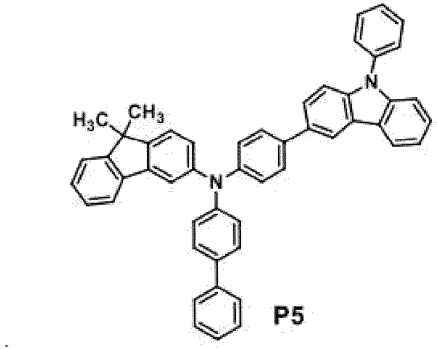

A refractive index of the capping layer CPL may be equal to or greater than about 1.6. For example, the refractive index of the capping layer CPL may be equal to or greater than about 1.6, with respect to light in a wavelength range of about 550 nm to about 660 nm.

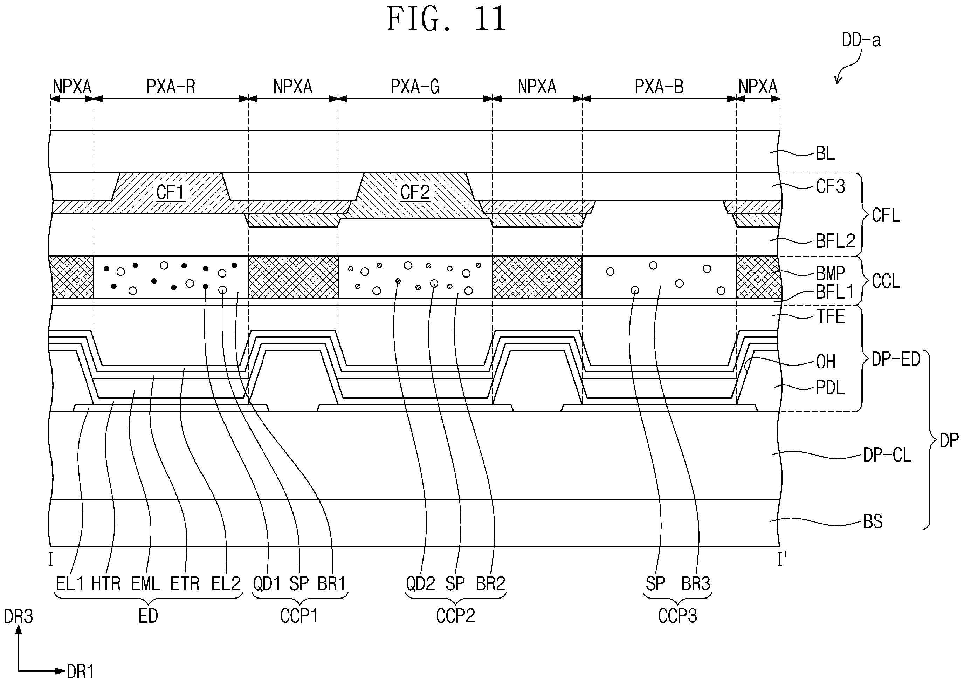

FIGS. 11 to 14 are each a schematic cross-sectional view of a display device according to an embodiment. Hereinafter, in describing the display devices according to embodiments as shown in FIGS. 11 to 14, the features which have been described above with respect to FIGS. 3 to 10 will not be explained again, and the differing features will be described.

Referring to FIG. 11, the display device DD-a according to an embodiment may include a display panel DP including a display device layer DP-ED, a light control layer CCL disposed on the display panel DP, and a color filter layer CFL. In an embodiment illustrated in FIG. 11, the display panel DP may include a base layer BS, a circuit layer DP-CL provided on the base layer BS, and the display device layer DP-ED, and the display device layer DP-ED may include a light-emitting element ED.

The light-emitting element ED may include a first electrode EL1, a hole transport region HTR disposed on the first electrode EL1, a light-emitting layer EML disposed on the hole transport region HTR, an electron transport region ETR disposed on the light-emitting layer EML, and a second electrode EL2 disposed on the electron transport region ETR. In embodiments, a structure of the light-emitting element ED shown in FIG. 11 may be the same as a structure of a light-emitting element according to one of FIGS. 5 to 10 as described above.

Referring to FIG. 11, the light-emitting layer EML may be disposed in an opening OH defined in a pixel defining film PDL. For example, the light-emitting layer EML, which is separated by the pixel defining film PDL and provided to correspond to each of the light emitting regions PXA-R, PXA-G, and PXA-B, may emit light in a same wavelength range. In the display device DD-a, the light-emitting layer EML may emit blue light. Although not shown in the drawings, in an embodiment, the light-emitting layer EML may be provided as a common layer for all of the light emitting regions PXA-R, PXA-G, and PXA-B.

The light control layer CCL may be disposed on the display panel DP. The light control layer CCL may include a light conversion body. The light conversion body may be a quantum dot, a phosphor, or the like. The light conversion body may convert the wavelength of a provided light and emit the resulting light. For example, the light control layer CCL may be a layer that includes a quantum dot or a layer that includes a phosphor.

The light control layer CCL may include light control parts CCP1, CCP2, and CCP3. The light control parts CCP1, CCP2, and CCP3 may be spaced apart from each other.

Referring to FIG. 11, divided patterns BMP may be disposed between the light control parts CCP1, CCP2, and CCP3, which are spaced apart from each other, but embodiments are not limited thereto. In FIG. 11, it is shown that the divided patterns BMP do not overlap the light control parts CCP1, CCP2, and CCP3, but the edges of the light control parts CCP1, CCP2, and CCP3 may overlap at least a portion of the divided patterns BMP.

The light control layer CCL may include a first light control part CCP1 containing a first quantum dot QD1 that converts first color light provided from the light-emitting element ED into second color light, a second light control part CCP2 containing a second quantum dot QD2 that converts the first color light into third color light, and a third light control part CCP3 that transmits the first color light.

In an embodiment, the first light control part CCP1 may provide red light, which is the second color light, and the second light control part CCP2 may provide green light, which is the third color light. The third light control part CCP3 may provide blue light by transmitting the blue light that is the first color light provided from the light-emitting element ED. For example, the first quantum dot QD1 may be a red quantum dot, and the second quantum dot QD2 may be a green quantum dot. The quantum dots QD1 and QD2 may each be a quantum dot as described above.

The light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include any quantum dot but may include the scatterer SP.

The scatterer SP may be inorganic particles. For example, the scatterer SP may include at least one of TiO₂, ZnO, Al₂O₃, SiO₂, and hollow silica. The scatterer SP may include one of TiO₂, ZnO, Al₂O₃, SiO₂, and hollow silica, or may be a mixture of at least two materials selected from TiO₂, ZnO, Al₂O₃, SiO₂, and hollow silica.

The first light control part CCP1, the second light control part CCP2, and the third light control part CCP3 may include base resins BR1, BR2, and BR3 in which the quantum dots QD1 and QD2 and the scatterer SP are dispersed. In an embodiment, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3.

The base resins BR1, BR2, and BR3 are media in which the quantum dots QD1 and QD2 and the scatterer SP are dispersed, and may include various resin compositions, which may be referred to as a binder. For example, the base resins BR1, BR2, and BR3 may be acrylic-based resins, urethane-based resins, silicone-based resins, epoxy-based resins, etc. The base resins BR1, BR2, and BR3 may each be a transparent resin. In an embodiment, the first base resin BR1, the second base resin BR2, and the third base resin BR3 may be the same as or different from each other.

The light control layer CCL may include a barrier layer BFL1. The barrier layer BFL1 may prevent the penetration of moisture and/or oxygen (hereinafter, referred to as 'moisture/oxygen'). The barrier layer BFL1 may block the light control parts CCP1, CCP2, and CCP3 from exposure to moisture/oxygen. The barrier layer BFL1 may cover the light control parts CCP1, CCP2, and CCP3. In an embodiment, the barrier layer BFL2 may be provided between the light control parts CCP1, CCP2, and CCP3, and the color filter layer CFL.

The barrier layers BFL1 and BFL2 may each independently include at least one inorganic layer. For example, the barrier layers BFL1 and BFL2 may each independently include an inorganic material. For example, the barrier layers BFL1 and BFL2 may each independently include a silicon nitride, an aluminum nitride, a zirconium nitride, a titanium nitride, a hafnium nitride, a tantalum nitride, a silicon oxide, an aluminum oxide, a titanium oxide, a tin oxide, a cerium oxide, a silicon oxynitride, a metal thin film which secures a transmittance, etc. The barrier layers BFL1 and BFL2 may further include an organic film. The barrier layers BFL1 and BFL2 may be formed of a single layer or of multiple layers.

In the display device DD-a, the color filter layer CFL may be disposed on the light control layer CCL. In an embodiment, the color filter layer CFL may be directly disposed on the light control layer CCL. For example, the barrier layer BFL2 may be omitted.

The color filter layer CFL may include color filters CF1, CF2, and CF3. The color filter layer CFL may include a first filter CF1 that transmits the second color light, a second filter CF2 that transmits the third color light, and a third filter CF3 that transmits the first color light. For example, the first filter CF1 may be a red filter, the second filter CF2 may be a green filter, and the third filter CF3 may be a blue filter. The filters CF1, CF2, and CF3 may each include a polymeric photosensitive resin and a pigment or dye. The first filter CF1 may include a red pigment or dye, the second filter CF2 may include a green pigment or dye, and the third filter CF3 may include a blue pigment or dye.

However, embodiments are not limited thereto, and the third filter CF3 may not include a pigment or dye. The third filter CF3 may include a polymeric photosensitive resin and may not include a pigment or dye. The third filter CF3 may be transparent. The third filter CF3 may be formed of a transparent photosensitive resin.

In an embodiment, the first filter CF1 and the second filter CF2 may each be a yellow filter. The first filter CF1 and the second filter CF2 may not be provided as separate filters and may be provided as a unitary filter.

Although not shown in the drawings, in an embodiment, the color filter layer CFL may further include a light shielding part (not shown). The light shielding part (not shown) may be a black matrix. The light shielding part (not shown) may include an organic light shielding material or an inorganic light shielding material, each containing a black pigment or a black dye. The light shielding part (not shown) may prevent light leakage, and may separate the boundaries between adjacent filters CF1, CF2, and CF3.

The first to third filters CF1, CF2, and CF3 may be disposed so that they respectively correspond to the red light emitting region PXA-R, the green light emitting region PXA-G, and the blue light emitting region PXA-B.

A base substrate BL may be disposed on the color filter layer CFL. The base substrate BL may provide a base surface on which the color filter layer CFL, the light control layer CCL, and the like are disposed. The base substrate BL may be a glass substrate, a metal substrate, a plastic substrate, etc. However, embodiments are not limited thereto, and the base substrate BL may include an inorganic layer, an organic layer, or a composite material layer. Although not shown in the drawings, in an embodiment, the base substrate BL may be omitted.

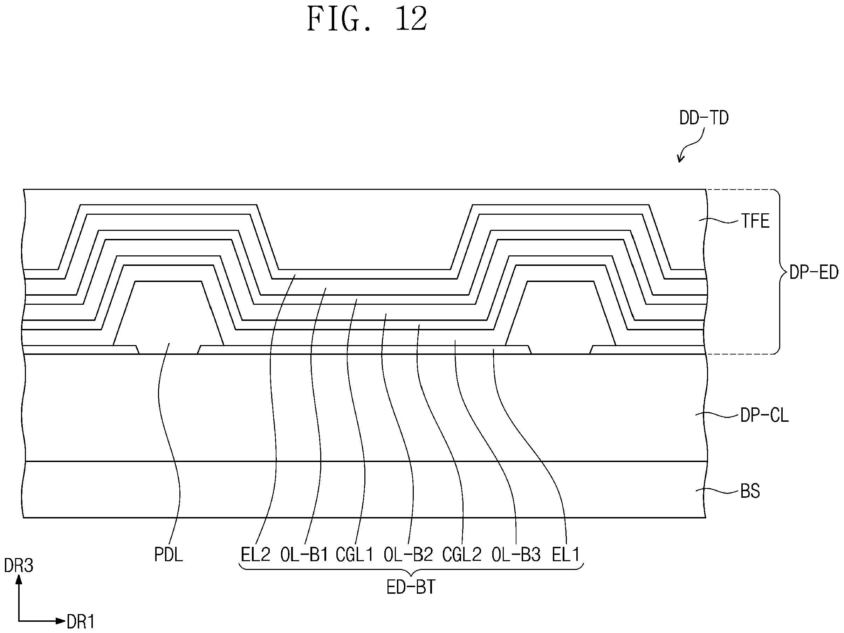

FIG. 12 is a schematic cross-sectional view of a portion of a display device according to an embodiment. In the display device DD-TD according to an embodiment, the light-emitting element ED-BT may include light emitting structures OL-B1, OL-B2, and OL-B3. The light-emitting element ED-BT may include a first electrode EL1 and a second electrode EL2 that face each other, and light emitting structures OL-B1, OL-B2, and OL-B3 stacked in a thickness direction between the first electrode EL1 and the second electrode EL2. The light emitting structures OL-B1, OL-B2, and OL-B3 may each include a hole transport region HTR (FIG. 11), a light-emitting layer EML (FIG. 11), and an electron transport region ETR (FIG. 11), which may be disposed in that order between the first electrode EL1 and the second electrode EL2.

For example, the light-emitting element ED-BT included in the display device DD-TD may be a light-emitting element having a tandem structure and including multiple light-emitting layers.

In an embodiment illustrated in FIG. 12, light emitted from the light emitting structures OL-B1, OL-B2, and OL-B3 may each be blue light. However, embodiments are not limited thereto, and the light emitted from the light emitting structures OL-B1, OL-B2, and OL-B3 may have wavelength ranges that are different from each other. For example, the light-emitting element ED-BT that includes the light emitting structures OL-B1, OL-B2, and OL-B3, which emit light having wavelength ranges that are different from each other, may emit white light.

Charge generation layers CGL1 and CGL2 may each be disposed between two adjacent light emitting structures among the light emitting structures OL-B1, OL-B2, and OL-B3. The charge generation layers CGL1 and CGL2 may each independently include a p-type charge generation layer and/or an n-type charge generation layer.

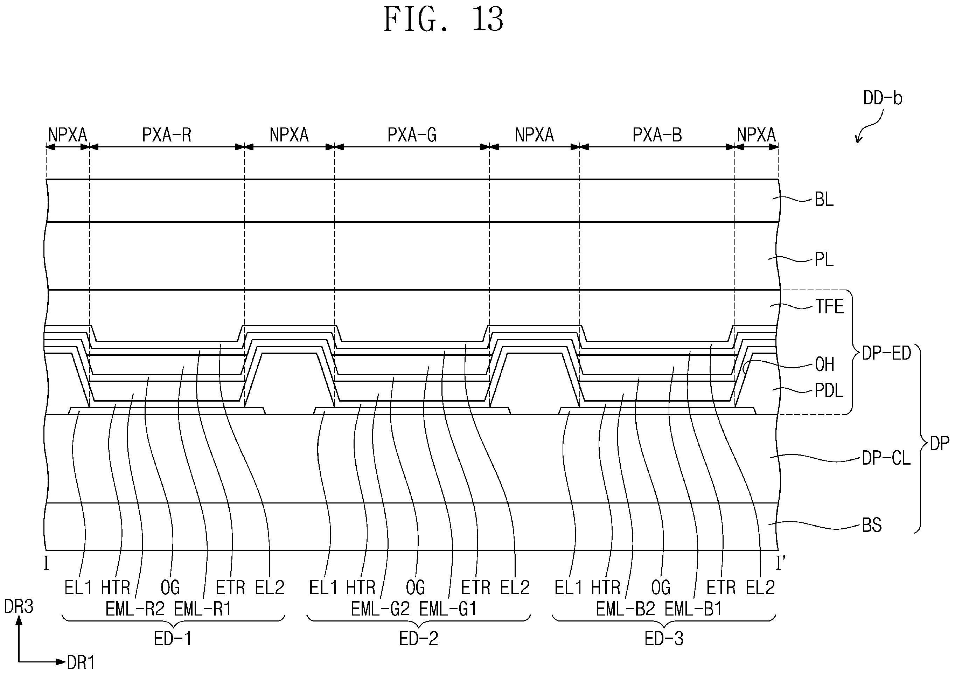

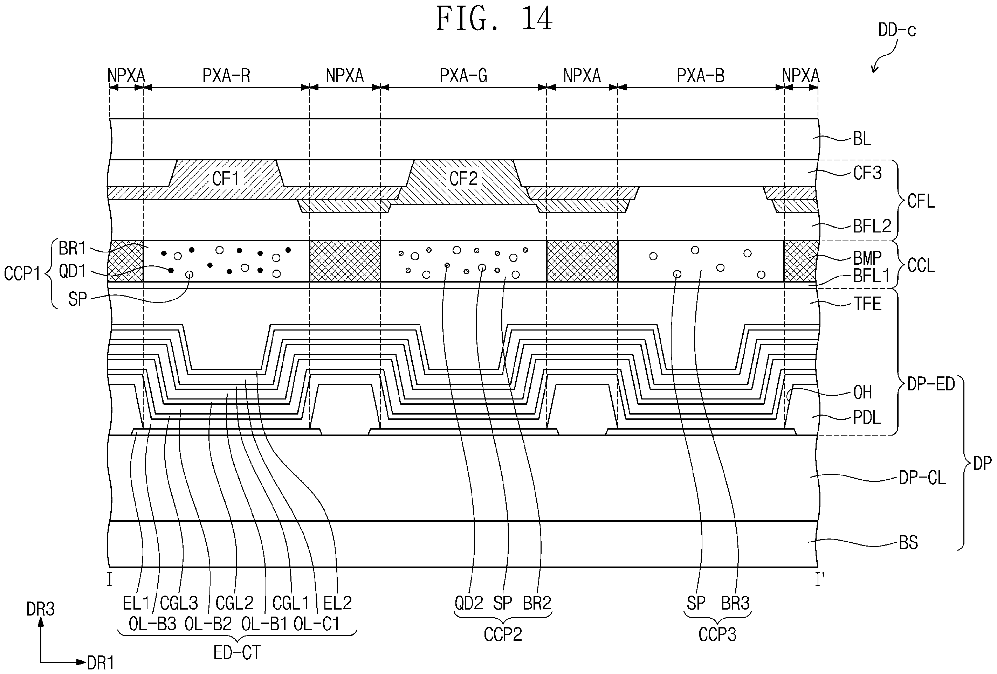

FIG. 13 is a schematic cross-sectional view of a display device DD-b according to an embodiment. FIG. 14 is a schematic cross-sectional view of a display device DD-c according to an embodiment.

Referring to FIG. 13, the display device DD-b according to an embodiment may include light-emitting elements ED-1, ED-2, and ED-3, in which two light-emitting layers are stacked. In comparison to the display device DD illustrated in FIG. 4, the embodiment illustrated in FIG. 13 is different at least in that the first to third light-emitting elements ED-1, ED-2, and ED-3 each include two light-emitting layers that are stacked in a thickness direction. In the first to third light-emitting elements ED-1, ED-2, and ED-3, the two light-emitting layers may emit light in a same wavelength region.

The first light-emitting element ED-1 may include a first red light-emitting layer EML-R1 and a second red light-emitting layer EML-R2. The second light-emitting element ED-2 may include a first green light-emitting layer EML-G1 and a second green light-emitting layer EML-G2. The third light-emitting element ED-3 may include a first blue light-emitting layer EML-B1 and a second blue light-emitting layer EML-B2. An emission auxiliary part OG may be disposed between the first red light-emitting layer EML-R1 and the second red light-emitting layer EML-R2, between the first green light-emitting layer EML-G1 and the second green light-emitting layer EML-G2, and between the first blue light-emitting layer EML-B1 and the second blue light-emitting layer EML-B2.

The emission auxiliary part OG may have a single-layered structure or a multilayered structure. The emission auxiliary part OG may include a charge generation layer. For example, the emission auxiliary part OG may include an electron transport region, a charge generation layer, and a hole transport region, which may be stacked in that order. The emission auxiliary part OG may be provided as a common layer for the first to third light-emitting elements ED-1, ED-2, and ED-3. However, embodiments are not limited thereto, and the emission auxiliary part OG may be provided by being patterned within the openings OH defined in the pixel defining film PDL.

The first red light-emitting layer EML-R1, the first green light-emitting layer EML-G1, and the first blue light-emitting layer EML-B1 may each be disposed between the emission auxiliary part OG and the electron transport region ETR. The second red light-emitting layer EML-R2, the second green light-emitting layer EML-G2, and the second blue light-emitting layer EML-B2 may each be disposed between the hole transport region HTR and the emission auxiliary part OG.

The first light-emitting element ED-1 may include the first electrode EL1, the hole transport region HTR, the second red light-emitting layer EML-R2, the emission auxiliary part OG, the first red light-emitting layer EML-R1, the electron transport region ETR, and the second electrode EL2, which are stacked in that order. The second light-emitting element ED-2 may include the first electrode EL1, the hole transport region HTR, the second green light-emitting layer EML-G2, the emission auxiliary part OG, the first green light-emitting layer EML-G1, the electron transport region ETR, and the second electrode EL2, which are stacked in that order. The third light-emitting element ED-3 may include the first electrode EL1, the hole transport region HTR, the second blue light-emitting layer EML-B2, the emission auxiliary part OG, the first blue light-emitting layer EML-B1, the electron transport region ETR, and the second electrode EL2, which are stacked in that order.

An optical auxiliary layer PL may be disposed on the display device layer DP-ED. The optical auxiliary layer PL may include a polarizing layer. The optical auxiliary layer PL may be disposed on the display panel DP and may control light that is reflected at the display panel DP from an external light. Although not shown in the drawings, in an embodiment, the optical auxiliary layer PL may be omitted from the display device DD-b.

In contrast to FIGS. 12 and 13, FIG. 14 shows a display device DD-c that is different at least in that it includes four light emitting structures OL-B1, OL-B2, OL-B3, and OL-C1. A light-emitting element ED-CT may include a first electrode EL1 and a second electrode EL2 which face each other, and first to fourth light emitting structures OL-B1, OL-B2, OL-B3, and OL-C1 that are stacked in a thickness direction between the first electrode EL1 and the second electrode EL2. Charge generation layers CGL1, CGL2, and CGL3 may each be disposed between two adjacent light emitting structures among the first to fourth light emitting structures OL-B1, OL-B2, OL-B3, and OL-C1. The charge generating layers CGL1, CGL2, and CGL3 may each independently include a p-type charge generating layer and/or an n-type charge generating layer.

Among the four light emitting structures, the first to third light emitting structures OL-B1, OL-B2, and OL-B3 may each emit blue light, and the fourth light emitting structure OL-C1 may emit green light. However, embodiments are not limited thereto, and the first to fourth light emitting structures OL-B1, OL-B2, OL-B3, and OL-C1 may emit light in different wavelength regions.

In an embodiment, an electronic device may include a display device that includes display comprising multiple light-emitting elements, and a control part that controls the display device. The electronic device may be a device that is activated according to an electrical signal. The electronic device may include display devices according to various embodiments. Examples of an electronic device may include large, medium-sized, and small electronic devices, such as a television set, a monitor, a billboard, a personal computer, a laptop computer, a personal digital terminal, a display device for a vehicle, a game console, a portable electronic device, smart watch, and a camera.

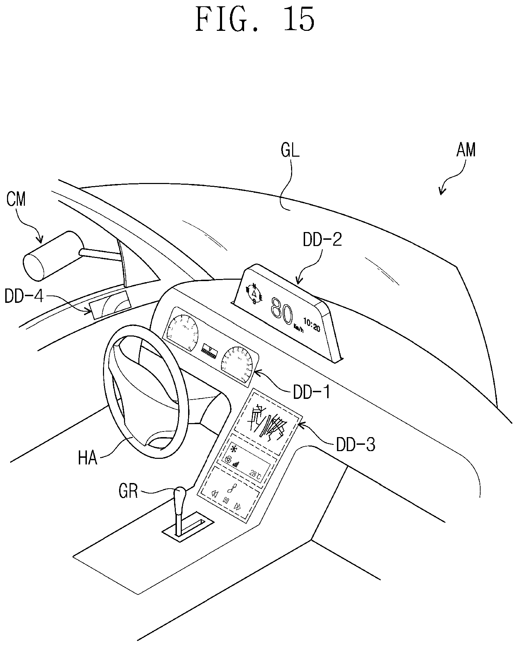

FIG. 15 is a schematic diagram of a vehicle AM in which first to fourth display devices DD-1, DD-2, DD-3, and DD-4 are disposed. At least one of the first to fourth display devices DD-1, DD-2, DD-3, and DD-4 may have a structure according to one of the display devices DD, DD-TD, DD-a, DD-b, and DD-c as described above with reference to FIGS. 3, 4, and 11 to 14.

FIG. 15 illustrates a vehicle AM, but this is only an example, and the first to fourth display devices DD-1, DD-2, DD-3, and DD-4 may be disposed in various transportation means such as a bicycle, a motorcycle, a train, a ship, and an airplane. In an embodiment, at least one of the first to fourth display devices DD-1, DD-2, DD-3, and DD-4 having a structure according to one of the display devices DD, DD-TD, DD-a, DD-b, and DD-c may be included in a personal computer, a laptop computer, a personal digital terminal, a game console, a portable electronic device, a television, a monitor, a billboard, or the like. However, these are merely provided as examples, and the display device may be included in other electronic devices.

At least one of the first to fourth display devices DD-1, DD-2, DD-3, and DD-4 may each independently include a light-emitting element ED according to an embodiment as described with reference to any of FIGS. 5 to 10.

Referring to FIG. 15, the vehicle AM may include a steering wheel HA and a gearshift GR for operating the vehicle AM. The vehicle AM may include a front window GL that is disposed so as to face the driver.

The first display device DD-1 may be disposed in a first region that overlaps the steering wheel HA. For example, the first display device DD-1 may be a digital cluster that displays first information of the vehicle AM. The first information may include a first scale that indicates a driving speed of the vehicle AM, a second scale that indicates an engine speed (for example, as revolutions per minute (RPM)), an image that represent a fuel gauge, etc. The first scale and the second scale may each be represented by a digital image.

The second display device DD-2 may be disposed in a second region facing the driver's seat and that overlaps the front window GL. The driver's seat may be a seat where the steering wheel HA is disposed. For example, the second display device DD-2 may be a head up display (HUD) that displays second information of the vehicle AM. The second display device DD-2 may be optically transparent. The second information may include digital numbers that indicate a driving speed, and may further include information such as the current time. Although not shown in the drawings, in an embodiment, the second information of the second display device DD-2 may be displayed by being projected onto the front window GL.

The third display device DD-3 may be disposed in a third region that is adjacent to the gearshift GR. For example, the third display device DD-3 may be disposed between the driver's seat and the passenger seat and may be a center information display (CID) for a vehicle that displays third information. The passenger seat may be a seat that is spaced apart from the driver's seat, and the gearshift GR may be disposed between the driver's seat and the passenger seat. The third information may include information about traffic conditions (e.g., navigation information), about music or radio that is playing, about a video (or an image) this is displayed, about temperatures inside the vehicle AM, etc.

The fourth display device DD-4 may be spaced apart from the steering wheel HA and the gearshift GR, and may be disposed in a fourth region that is adjacent to a side of the vehicle AM. For example, the fourth display device DD-4 may be a digital side-view mirror that displays fourth information. The fourth display device DD-4 may display an image that is external to the vehicle AM taken by a camera module CM disposed on the exterior of the vehicle AM. The fourth information may include an exterior image of the vehicle AM.

The first to fourth information as described above are only provided as examples, and the first to fourth display devices DD-1, DD-2, DD-3, and DD-4 may further display information about the interior and exterior of the vehicle AM. The first to fourth information may include information that is different from each other. However, embodiments are not limited thereto, and a part of the first to fourth information may include a same information as one another.

Hereinafter, a light-emitting element according to an embodiment will be described in detail with reference to the Examples and the Comparative Examples. The Examples shown below are only provided to facilitate in understanding the disclosure, and the scope thereof is not limited thereto.

### [Examples]

### 1. Manufacturing of Light-emitting Element

A glass substrate (a Corning product), on which an electrode having a stacked structure of ITO (about 70 Å)/Ag (about 1,000 Å)/ITO (about 70 Å) had been formed as an anode, was cut at a size of about 50 mm × about 50 mm × about 0.7 mm, and each cut glass substrate was ultrasonically cleaned using isopropyl alcohol and pure water for about 5 minutes, was cleaned by irradiating with ultraviolet light for about 30 minutes and being exposed to ozone, and was installed in a vacuum deposition apparatus.

A hole injection layer having a thickness of about 100 Å was formed by depositing, on the anode, Compound H-1-3 and a p-dopant (F4-TCNQ) at a ratio of 99:1, a hole transport layer having a thickness of about 1,000 Å was formed by depositing Compound H-1-3 on the hole injection layer, and an electron-blocking layer having a thickness of about 50 Å was formed by depositing Compound HT33 on the hole transport layer.

A light-emitting layer having a thickness of about 400 Å was formed by co-depositing, on the electron-blocking layer, a host mixture in which a HT host and an ET host were mixed at a ratio of 5:5, the first compound, and the second compound at a weight ratio of about 89: 10: 1. The materials listed in Table 2 below were used as the HT host, the ET host, the first compound, and the second compound.

A hole-blocking layer having a thickness of about 50 Å was formed by depositing Compound ETH66 on the light-emitting layer, an electron transport layer having a thickness of about 300 Å was formed by depositing Compound ET1 and Liq at a ratio of 5:5 on the hole-blocking layer, and an electron injection layer having a thickness of about 10 Å was formed by depositing Yb on the electron transport layer. A second electrode of AgMg having a thickness of about 100 Å was formed on the electron injection layer, and a capping layer having a thickness of about 1000 Å was formed on the second electrode.

Compounds used in manufacturing the light-emitting elements according to the Examples and the Comparative Examples were obtained by sublimation purification of commercial products and were used so as to manufacture the elements.

### [Compounds used in manufacturing light-emitting elements]

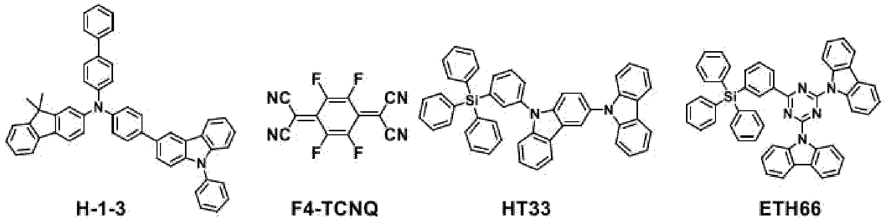

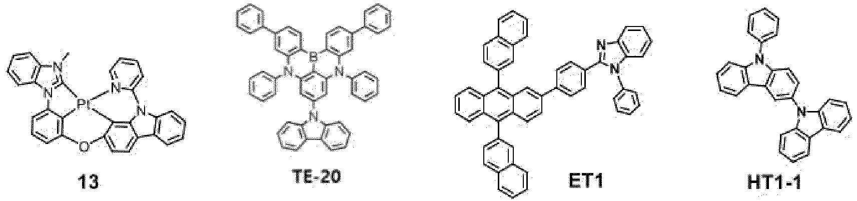

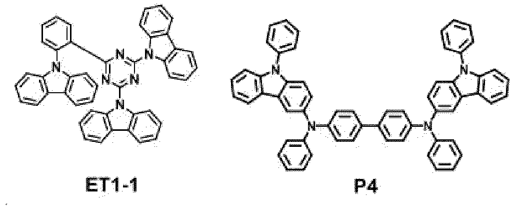

### 2. Evaluation of Properties of Light-emitting Material and Characteristics of Light-emitting Element

### 1) Evaluation of Properties of Light-emitting Material

Properties of the HT host, the ET host, and the first compound used as light-emitting materials in light-emitting elements according to the Examples and the Comparative Examples were evaluated through simulation and were shown in Table 1. Table 1 shows a property result of Compound HT33, Compound HT1-1, Compound ETH66, Compound ET1-1, and Compound 13. In Table 1, HOMO is a highest occupied molecular orbital (HOMO) energy level, and LUMO is a lowest unoccupied molecular orbital (LUMO) energy level. GSP was calculated by simulating a structure of a deposited film through molecular dynamics (MD) simulation and analyzing molecular dipole orientation in the organic film.

**[Table 1]**

| Compound | HOMO (eV) | LUMO (eV) | Dipole (Debye) | GSP (mV/nm) |
|---|---|---|---|---|
| HT33 | 5.4 | 1.2 | 4.5 | 19 |
| HT1-1 | 5.4 | 1.3 | 4.3 | -28 |
| ETH66 | 6.0 | 2.0 | 1.4 | 13 |
| ET1-1 | 5.7 | 2.7 | 1.5 | -19 |
| Compound 13 | 5.2 | 2.1 | 8.5 | 125 |

Referring to Table 1, it may be seen that Compound HT1-1 and Compound ET1-1 respectively used as the HT host and the ET host show negative a GSP value, and thus have lower giant surface potentials than the first compound having a positive GSP value. It may be seen that Compound HT33 and Compound ETH66 each have a positive GSP value.

### 2) Characteristics of Light-emitting Elements

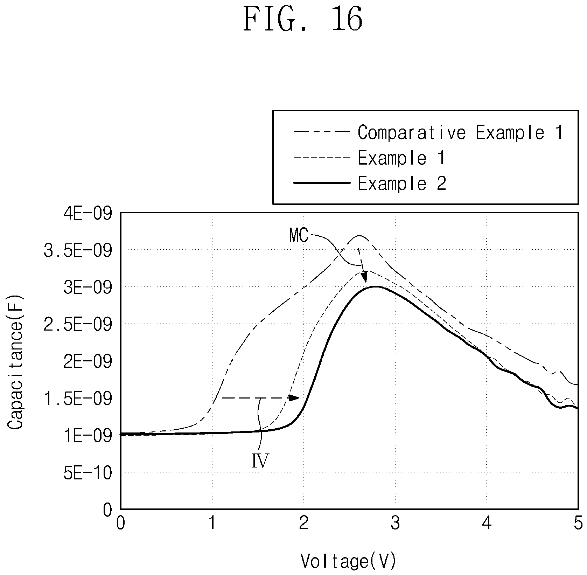

Table 2 shows evaluation results of light-emitting elements according to Example 1, Example 2, and Comparative Example 1. FIG. 16 is a graph showing an evaluation result of characteristics of light-emitting elements according to the Examples and the Comparative Examples. Table 2 shows relative luminous efficiency, relative element lifespan, and maximum capacitances (Cₘₐₓ) of the light-emitting elements according to Example 1, Example 2, and Comparative Example 1. In order to evaluate characteristics of the light-emitting elements according to Example 1, Example 2, and Comparative Example 1, the luminous efficiency and the lifespan at about 1000 nit were measured using Keithley MU 236 and luminance meter PR650, and when the luminous efficiency and the lifespan of Comparative example 1 were set to 100%, the luminous efficiency and the lifespan of Examples were shown as relative ratios. Impedances were measured from 0 V to 5 V in a capacitance-voltage mode and shown in FIG. 16, and the greatest capacitance values were calculated and shown in Table 2 as the greatest capacitances (Cₘₐₓ).

**[Table 2]**

| | Host mixture (HT host: ET host=5:5) | First compound | Second compound | Relative luminous efficiency | Relative lifespan (%) | Cₘₐₓ (nF) |
|---|---|---|---|---|---|---|
| Example 1 | HT1-1:ETH66 | Compound 13 | TE-20 | 115 | 112 | 3.1 |
| Example 2 | HT1-1:ET1-1 | Compound 13 | TE-20 | 112 | 151 | 3.0 |
| Comparative Example 1 | HT33:ETH66 | Compound 13 | TE-20 | 100 | 100 | 3.7 |

Referring to results of Table 2, it may be seen that the light-emitting elements according to the Examples have lower Cₘₐₓ values and higher luminous efficiency and lifespan than that according to Comparative Example 1.

Referring to Table 2, the light-emitting element according to Comparative Example 1 includes the first compound having a high positive GSP value in the light-emitting layer, and includes the HT host and the ET host having a positive GSP value, and thus shows lower luminous efficiency and lower lifespan than those according to the Examples. Referring to Table 2 and FIG. 16, it may be seen that the light-emitting element according to Comparative Example 1 shows higher Cₘₐₓ characteristics than the light-emitting elements according to Examples, and an injection voltage (IV) of the light-emitting element according to Comparative Example 1 is shifted to a low voltage region.

Compared to these, in the light-emitting elements according to Examples 1 and 2, at least one of the HT host or the ET host included in the light-emitting layer has a negative GSP value so that the light-emitting according to Examples 1 and 2 show higher luminous efficiency and greater lifespan than that according to Comparative Example 1. Referring to Table 2 and FIG. 16 together, it may be seen that the light-emitting elements according to Examples 1 and 2 show lower Cₘₐₓ characteristics than that according to Comparative Example 1, and the injection voltage thereof is shifted to a high voltage region.

A light-emitting element according to embodiments may have a lower capacitance, and may show improved luminous characteristics. Accordingly, the light-emitting element according to embodiments may have improved luminous efficiency and lifespan.

A display device according to an embodiment may include the light-emitting element described above to supply improved image quality.

Embodiments have been disclosed herein, and although terms are employed, they are used and are to be interpreted in a generic and descriptive sense only and not for the purposes of limitation. In some instances, as would be apparent to one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the spirit and scope of the disclosure as set forth in the claims.

## Claims

1. A light-emitting element comprising:
a first electrode;
a second electrode disposed on the first electrode; and
a light-emitting layer disposed between the first electrode and the second electrode, wherein
the light-emitting layer includes:
a hole-transporting host compound;
an electron-transporting host compound;
a phosphorescent compound; and
a fluorescent compound, and
at least one of the hole-transporting host compound and the electron-transporting host compound has a lower giant surface potential than the phosphorescent compound.

2. The light-emitting element of claim 1, wherein the phosphorescent compound has a positive giant surface potential.

3. The light-emitting element of claim 2, wherein at least one of the hole-transporting host compound and the electron-transporting host compound has a negative giant surface potential.

4. The light-emitting element of claim 1, wherein
the electron-transporting host compound and the phosphorescent compound each have a positive giant surface potential, and
the hole-transporting host compound has a negative giant surface potential.

5. The light-emitting element of claim 1, wherein
the phosphorescent compound has a positive giant surface potential, and
the hole-transporting host compound and the electron-transporting host compound each have a negative giant surface potential.

6. The light-emitting element of claim 1, wherein the hole-transporting host compound is represented by Formula 1: 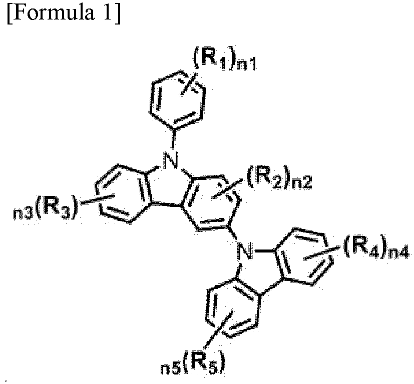
wherein in Formula 1,
R₁ to R₃ are each independently a hydrogen atom, a deuterium atom, a substituted or unsubstituted aryl group having 6 to 30 ring-forming carbon atoms, or a substituted or unsubstituted heteroaryl group having 5 to 30 ring-forming carbon atoms,
R₄ and R₅ are each independently a hydrogen atom, a deuterium atom, or a substituted or unsubstituted silyl group,
n1 is an integer from 0 to 5,
n2 is an integer from 0 to 3, and
n3 to n5 are each independently an integer from 0 to 4.

7. The light-emitting element of claim 6, wherein the hole-transporting host compound is selected from Compound Group 1:

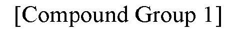

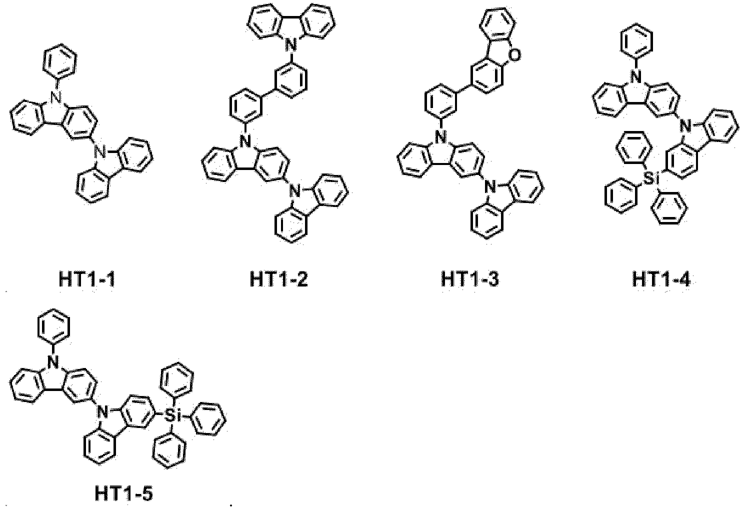

8. The light-emitting element of claim 1, wherein the electron-transporting host compound is represented by Formula 2: 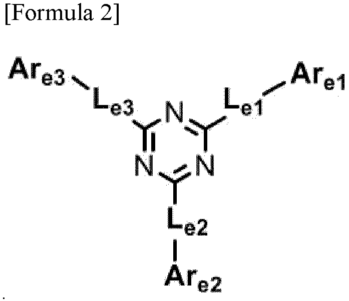
wherein in Formula 2,
Lₑ₁ to Lₑ₃ are each independently a direct linkage or a substituted or unsubstituted arylene group having 6 to 30 ring-forming carbon atoms,
Arₑ₁ to Arₑ₃ are each independently a substituted or unsubstituted aryl group having 6 to 30 ring-forming carbon atoms, or a substituted or unsubstituted heteroaryl group having 5 to 30 ring-forming carbon atoms, and
when Lₑ₁ to Lₑ₃ are each a direct linkage, a case in which Arₑ₁ to Arₑ₃ are each substituted with a triphenylsilyl group is excluded.

9. The light-emitting element of claim 8, wherein the electron-transporting host compound is selected from Compound Group 2:

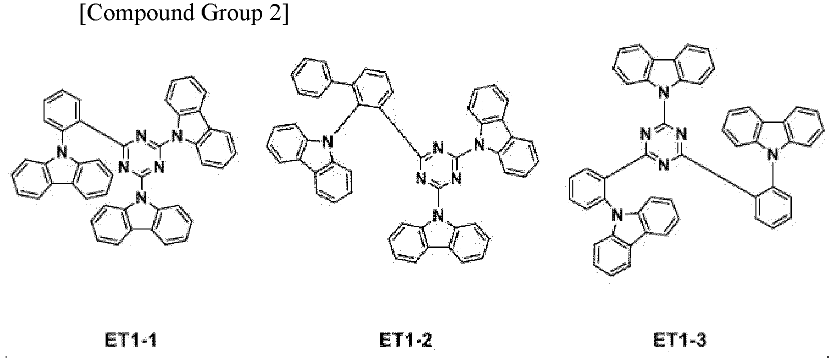

10. The light-emitting element of claim 1, wherein the phosphorescent compound is represented by Formula 3: 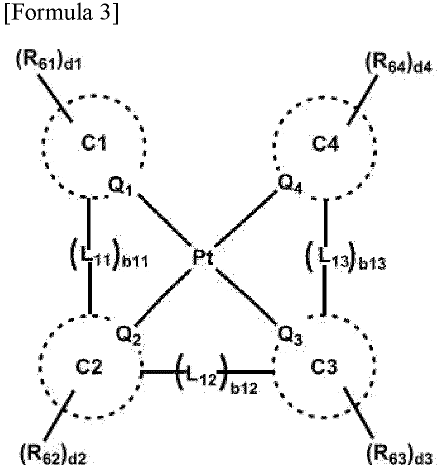
wherein in Formula 3,
Q₁ to Q₄ are each independently C or N,
C1 to C4 are each independently a substituted or unsubstituted hydrocarbon ring having 5 to 30 ring-forming carbon atoms, or a substituted or unsubstituted heterocycle having 2 to 30 ring-forming carbon atoms,
L₁₁ to L₁₃ are each independently a direct linkage, *-O-* , *-S-* , 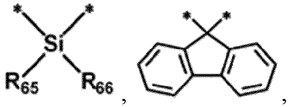
a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms,
b11 to b13 are each independently 0 or 1,
R₆₁ to R₆₆ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, and
d1 to d4 are each independently an integer from 0 to 4.

11. The light-emitting element of claim 1, wherein the fluorescent compound emits delayed fluorescence.

12. The light-emitting element of claim 1, further comprising:
a hole transport region disposed between the first electrode and the light-emitting layer, wherein
the hole transport region includes at least one of a hole injection layer, a hole transport layer, and an auxiliary light-emitting layer.

13. The light-emitting element of claim 12, wherein the hole transport region comprises a compound having a positive giant surface potential.

14. The light-emitting element of claim 13, wherein
the hole transport region comprises:
a hole injection layer disposed on the first electrode;
a hole transport layer disposed on the hole injection layer; and
an electron-blocking layer disposed on the hole transport layer, and
the electron-blocking layer comprises the compound having the positive giant surface potential.

15. The light-emitting element of claim 1, further comprising:
an electron transport region disposed between the light-emitting layer and the second electrode, wherein
the electron transport region includes at least one of a hole-blocking layer, an electron transport layer, and an electron injection layer.

16. The light-emitting element of claim 15, wherein the electron transport region comprises a compound having a positive giant surface potential.

17. The light-emitting element of claim 16, wherein
the electron transport region comprises:
a hole-blocking layer disposed on the light-emitting layer;
an electron transport layer disposed on the hole-blocking layer; and
an electron injection layer disposed on the electron transport layer, and
the hole-blocking layer comprises the compound having the positive giant surface potential.

18. A display device comprising:
a circuit layer disposed on a base layer;
a pixel-defining film disposed on the circuit layer; and
a plurality of light-emitting elements disposed on the circuit layer, wherein
a plurality of pixel openings are defined in the pixel-defining film,
each of the plurality of light-emitting elements includes a light-emitting layer,
each light-emitting layer includes:
a hole-transporting host compound;
an electron-transporting host compound;
a phosphorescent compound; and
a fluorescent compound, and
at least one of the hole-transporting host compound and the electron-transporting host compound has a lower giant surface potential than the phosphorescent compound.

19. The display device of claim 18, further comprising:
a light control layer including quantum dots; and
a color filter layer disposed on the light control layer, wherein
the color filter layer includes:
a first filter transmitting red color light;
a second filter transmitting green color light; and
a third filter transmitting blue color light.

20. The display device of claim 18, wherein at least one of the hole-transporting host compound and the electron-transporting host compound has a negative giant surface potential.

21. An electronic device comprising:
a display panel comprises multiple light-emitting elements,
wherein at least one of the multiple light-emitting elements comprise a first electrode;
a second electrode disposed on the first electrode; and a light-emitting layer disposed between the first electrode and the second electrode, wherein
the light-emitting layer includes:
a hole-transporting host compound;
an electron-transporting host compound;
a phosphorescent compound; and
a fluorescent compound, and
at least one of the hole-transporting host compound and the electron-transporting host compound has a lower giant surface potential than the phosphorescent compound.

22. The electronic device of claim 21, wherein
the electronic device is a television set, a monitor, a billboard, a personal computer, a laptop computer, a personal digital terminal, a display device for a vehicle, a game console, a portable electronic device, smart watch, or a camera.
